# EUROPEAN PATENT APPLICATION

(11) **EP 3 270 433 A1**
(43) Date of publication of application: **17.01.2018**
(21) Application number: 16764707.2
(22) Date of filing: 03.03.2016
(51) Int. Cl.: H01L 51/50, C09K 11/06

(54) **COMPOSITION FOR FORMING CHARGE-TRANSPORTING THIN FILM FOR ORGANIC ELECTROLUMINESCENT ELEMENTS, CHARGE-TRANSPORTING THIN FILM FOR ORGANIC ELECTROLUMINESCENT ELEMENTS, AND ORGANIC ELECTROLUMINESCENT ELEMENT**

(30) Priority: 13.03.2015 JP 2015051161
(71) Applicant: Nissan Chemical Industries, Ltd., Tokyo 101-0054 (JP)
(72) Inventor: NAKAIE Naoki, Funabashi-shi Chiba 274-0052 (JP); ADACHI Isao, Funabashi-shi Chiba 274-0052 (JP)
(74) Representative: Bailey, Sam Rogerson
(86) International application number: PCT/JP2016/056539
(87) International publication number: WO 2016/147877

(57) **Abstract**

Provided is a composition for forming a charge-transporting thin film for organic electroluminescent elements, which contains a dopant material that is composed of a nitrogen-containing heteroaromatic compound substituted by a cyano group and represented by one of formulae (D1)-(D5), a charge-transporting material and an organic solvent, and which is characterized in that the dopant material and the charge-transporting material are dissolved in the organic solvent.

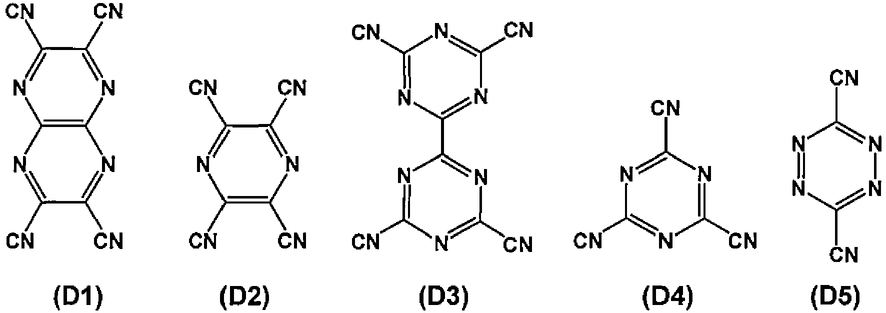

## Description

### TECHNICAL FIELD

The present invention relates to a charge transporting thin film-forming composition for organic electroluminesent devices, a charge-transporting thin film for organic electroluminescent devices, and an organic electroluminescent device.

### BACKGROUND ART

Charge-transporting films composed of organic compounds are used as light-emitting layers and charge-injecting layers in organic electroluminescent (EL) devices. In particular, a hole-injecting layer is responsible for transferring charge between an anode and a hole-transporting layer or a light-emitting layer, and thus serves an important function in achieving low-voltage driving and high brightness in organic EL devices.

Processes for forming the hole-injecting layer are broadly divided into dry processes such as vapor deposition and wet processes such as spin coating. Comparing these different processes, wet processes are better able to efficiently produce thin films having a high flatness over a large area. Hence, with the advances being made today toward larger-area organic EL displays, there exists a desire for a hole-injecting layer that can be formed by a wet process.

In view of these circumstances, the inventors have developed charge-transporting materials which can be employed in various wet processes and which moreover give thin films that, when used as hole-injecting layers for organic EL devices, are capable of achieving excellent EL device characteristics. The inventors have also developed compounds which have a good solubility in the organic solvents used in such charge-transporting materials (see, for example, Patent Documents 1 to 4).

However, with progress in the organic EL field, there exists a constant desire for new coating-type organic EL materials that are capable of achieving excellent EL characteristics.

### PRIOR ART DOCUMENTS

### PATENT DOCUMENTS

Patent Document 1: WO 2008/032616
Patent Document 2: WO 2008/129947
Patent Document 3: WO 2006/025342
Patent Document 4: WO 2010/058777
Patent Document 5: JP-A 2009-079131
Patent Document 6: JP-A 2001-341239
Patent Document 7: JP-A 2004-189674
Patent Document 8: JP-A H11-222263

### SUMMARY OF THE INVENTION

### PROBLEMS TO BE SOLVED BY THE INVENTION

It is therefore an object of this invention to provide compositions for forming charge-transporting thin films that, when employed in organic EL devices, are capable of achieving excellent brightness characteristics.

### MEANS FOR SOLVING THE PROBLEMS

The inventors have conducted extensive investigations, as a result of which they have discovered that charge-transporting thin films which, when used as a functional layer such as a hole-injecting layer in an organic electroluminescent device, are capable of achieving excellent brightness characteristics can be obtained from compositions containing a dopant substance consisting of a specific cyano group-substituted nitrogen-containing heteroaromatic compound, a charge-transporting substance, and an organic solvent.

Patent Documents 5 to 8 disclose materials that include 2,4,6,7-tetracyano-1,4,5,8-tetraazanaphthalene as a dopant (electron acceptor), but these documents contain no language that teaches or suggests organic EL device materials such as the compositions according to the present invention.

Accordingly, the invention provides:
1. A charge-transporting thin film-forming composition for an organic electroluminescent device, comprising a dopant substance consisting of a cyano group-substituted nitrogen-containing heteroaromatic compound of any of formulas (D1) to (D5) below, a charge-transporting substance and an organic solvent, wherein the dopant substance and the charge-transporting substance are dissolved in the organic solvent 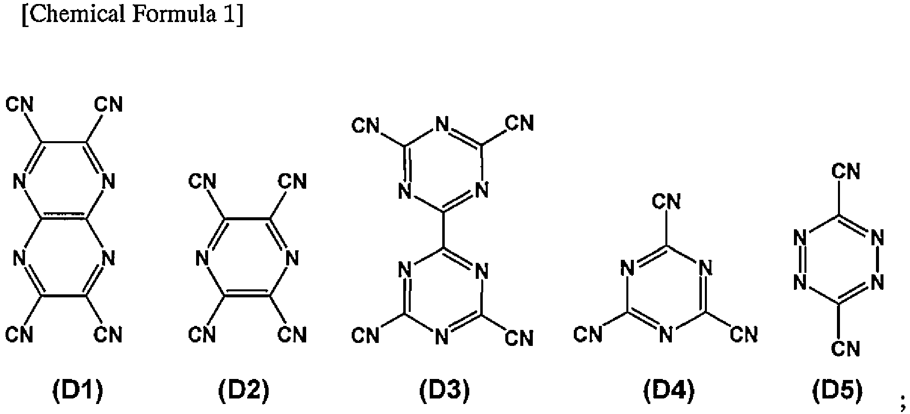
2. The charge-transporting thin film-forming composition for an organic electroluminescent device of 1 above, wherein the charge-transporting substance is a charge-transporting compound having a molecular weight of from 200 to 9,500;
3. The charge-transporting thin film-forming composition for an organic electroluminescent device of 2 above, wherein the charge-transporting compound is an aniline derivative or a thiophene derivative;
4. The charge-transporting thin film-forming composition for an organic electroluminescent device of 3 above, wherein the charge-transporting compound is an aniline derivative;
5. The charge-transporting thin film-forming composition for an organic electroluminescent device of any of 1 to 4 above, further comprising an organosilane compound;
6. The charge-transporting thin film-forming composition for an organic electroluminescent device of any of 1 to 5 above, further comprising a heteropolyacid;
7. The charge-transporting thin film-forming composition for an organic electroluminescent device of any of 1 to 6 above which is a composition for forming a hole-injecting layer, a hole-transporting layer or a hole-injecting-and-transporting layer of an organic electroluminescent device;
8. A charge-transporting thin film for an organic electroluminescence device that is produced using the charge-transporting thin film-forming composition for an organic electroluminescent device of any of 1 to 7 above; and
9. An organic electroluminescent device comprising the charge-transporting thin film for an organic electroluminescence device of 8 above.

### ADVANTAGEOUS EFFECTS OF THE INVENTION

By using the composition according to this invention, a charge-transporting thin film can be obtained which has both an excellent flatness and excellent charge transportability, and which moreover is capable of achieving excellent brightness characteristics when used as a hole-injecting layer or other functional layer in an organic electroluminescent device.

The reason why is not entirely clear, but is presumed to be as follows. Compounds having a structure in which cyano groups are bonded to a nitrogen-containing heteroaromatic ring, such as 2,4,6,7-tetracyano-1,4,5,8-tetraazanaphthalene, owing not only to the influence of the electron deficiency in the nitrogen-containing heteroaromatic ring but also to the effects of electron withdrawal by the cyano groups bonded thereto, are likely to exhibit excellent functionality as dopants. Therefore, use of the composition of this invention, which includes such a compound as a dopant substance together with a charge-transporting substance, especially an aniline derivative, makes it possible to obtain a charge-transporting thin film that has not only an excellent flatness and charge transportability, but also an excellent ability to accept holes from the anode and an excellent ability to inject holes into the hole-transporting layer or the light-emitting layer to be obtained. As a result, organic EL devices of excellent brightness characteristics can be obtained.

Moreover, compositions according to the invention can reproducibly form thin films of excellent charge transportability, even using various wet processes capable of film formation over a large area, such as spin coating and slit coating, and therefore are capable of fully accommodating recent advances in the field of organic EL devices.

### EMBODIMENT FOR CARRYING OUT THE INVENTION

The invention is described more fully below.

The charge-transporting thin film-forming composition for organic electroluminescent devices of the invention (also referred to below as simply the "inventive composition") includes a dopant substance consisting of a cyano group-substituted nitrogen-containing heteroaromatic compound of any of formulas (D1) to (D5).

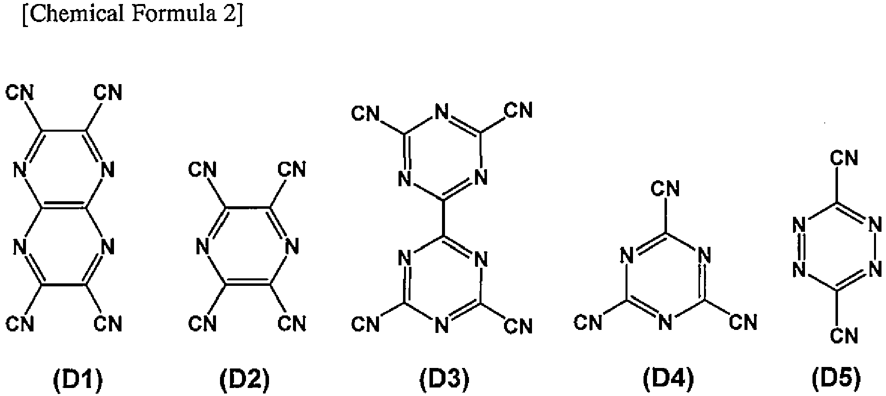

Of these, taking into account the balance between the charge transportability of the resulting thin film, the availability of the compound and the solubility of the compound in organic solvents, a cyano group-substituted nitrogen-containing heteroaromatic compound of formula (D1) is most preferred.

In addition to the above cyano group-substituted nitrogen-containing heteroaromatic compound, the inventive composition may include the following other dopant substances: heteropolyacid compounds, arylsulfonic acid derivatives, tetracyanoquinodimethane derivatives and benzoquinone derivatives. Of these, a heteropolyacid is preferred.

"Heteropolyacid" refers to a polyacid having a structure in which a heteroatom is positioned at the center of the molecule--typically the Keggin-type chemical structure shown in formula (D6) or the Dawson-type chemical structure shown in formula (D7), and which is obtained by the condensation of an isopolyacid that is an oxoacid of vanadium (V), molybdenum (Mo), tungsten (W) or the like with an oxoacid of a different element. Examples of such oxoacids of a different element include primarily oxoacids of silicon (Si), phosphorus (P) and arsenic (As).

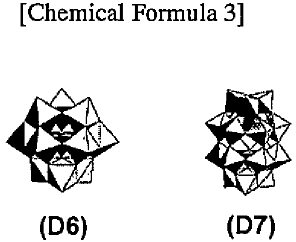

Examples of heteropolyacids include phosphomolybdic acid, silicomolybdic acid, phosphotungstic acid, silicotungstic acid and phosphotungstomolybdic acid. These may be used singly, or two or more may be used in combination. The heteropolyacid used in this invention may be acquired as a commercial product or may be synthesized by a known method.

In particular, when a single heteropolyacid is used, this single heteropolyacid is preferably phosphotungstic acid or phosphomolybdic acid, and more preferably phosphotungstic acid. When two or more heteropolyacids are used, at least one of the two or more heteropolyacids is preferably phosphotungstic acid or phosphomolybdic acid, and more preferably phosphotungstic acid.

Even a heteropolyacid having, in quantitative analysis such as elemental analysis, numbers for the elements which are higher or lower than in the structure indicated by the general formula may be used in this invention, provided that it was acquired as a commercial product or was suitably synthesized according to a known method of synthesis.

For example, phosphotungstic acid is generally represented by the chemical formula H₃(PW₁₂O₄₀)·nH₂O and phosphomolybdic acid is generally represented by the chemical formula H₃(PM₁₂O₄₀)·nH₂O. In quantitative analysis, regardless of whether the numbers for the elements P (phosphorus), O (oxygen) and W (tungsten) or Mo (molybdenum) within these formulas are high or low, so long as the heteropolyacid was acquired as a commercial product or suitably synthesized by a known method of synthesis, it may be used in this invention. In such cases, the mass of the heteropolyacid specified in this invention refers not to the mass of pure phosphotungstic acid within the product of synthesis or the commercial product (phosphotungstic acid content), but rather, in the form that is available as a commercial product or the form that can be isolated by a known method of synthesis, to the total mass in a state that includes water of hydration and other impurities.

The content of dopant substance in the inventive composition is suitably set while taking into account, for example, the type and amount of charge-transporting substance, with the dopant substance generally being included in a molar ratio, relative to unity (1) for the charge-transporting substance, of from about 0.1 to about 10.

The charge-transporting substance included in the inventive composition may be one that is typically used in, for example, the organic EL field.

This is exemplified by various types of charge-transporting compounds, such as arylamine derivatives (aniline derivatives), including oligoaniline derivatives, N,N'-diarylbenzidine derivatives and N,N,N',N'-tetraarylbenzidine derivatives; and thiophene derivatives, including oligothiophene derivatives, thienothiophene derivatives and thienobenzothiophene derivatives.

Of these, aniline derivatives and thiophene derivatives are preferred, and aniline derivatives are more preferred.

In this invention, from the standpoint of preparing a uniform composition that gives a thin film having a high flatness, the molecular weight of the charge-transporting compound is preferably from about 200 to about 9,500. From the standpoint of obtaining a thin film having a better charge transportability, the lower limit is more preferably 300, and even more preferably 400. From the standpoint of preparing a uniform composition that more reproducibly gives a thin film having a high flatness, the upper limit is more preferably 8,000, even more preferably 7,000, still more preferably 6,000, and still yet more preferably 5,000. From the standpoint of preventing separation of the charge-transporting substance when the composition has been rendered into a thin film, it is preferable for the charge-transporting compound to not have a molecular weight distribution (for the dispersity to be 1); that is, it is preferable for the compound to have a single molecular weight.

Illustrative examples of aniline derivatives include those of formula (1) or (2) below.

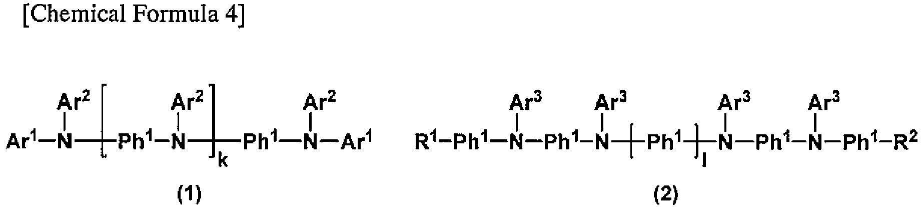

In formula (1), k is an integer from 1 to 10. From the standpoint of increasing the solubility of the compound in organic solvents, k is preferably from 1 to 5, more preferably from 1 to 3, even more preferably 1 or 2, and most preferably 1. In formula (2), the letter "1" is 1 or 2.

In formula (2), R¹ and R² are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom.

The halogen atom is exemplified by fluorine, chlorine, bromine and iodine atoms. A fluorine atom is preferred.

The alkyl group of 1 to 20 carbon atoms may be linear, branched or cyclic. Examples include linear or branched alkyl groups of 1 to 20 carbon atoms, such as methyl, ethyl, n-propyl, isopropyl, n-butyl, isobutyl, s-butyl, t-butyl, n-pentyl, n-hexyl, n-heptyl, n-octyl, n-nonyl and n-decyl groups; and cyclic alkyl groups of 3 to 20 carbon atoms, such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl and bicyclodecyl groups.

Examples of the alkenyl group of 2 to 20 carbon atoms include ethenyl, n-1-propenyl, n-2-propenyl, 1-methylethenyl, n-1-butenyl, n-2-butenyl, n-3-butenyl, 2-methyl-l-propenyl, 2-methyl-2-propenyl, 1-ethylethenyl, 1-methyl-1-propenyl, 1-methyl-2-propenyl, n-1-pentenyl, n-1-decenyl and n-1-eicosenyl groups.

Examples of the alkynyl group of 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1-eicosynyl groups.

Examples of aryl groups of 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl and 9-phenanthryl groups.

Examples of heteroaryl groups of 2 to 20 carbon atoms include oxygen-containing heteroaryl groups such as 2-thienyl, 3-thienyl, 2-furanyl, 3-furanyl, 2-oxazolyl, 4-oxazolyl, 5-oxazolyl, 3-isooxazolyl, 4-isooxazolyl and 5-isooxazolyl groups; sulfur-containing heteroaryl groups such as 2-thiazolyl, 4-thiazolyl, 5-thiazolyl, 3-isothiazolyl, 4-isothiazolyl and 5-isothiazolyl groups; and nitrogen-containing heteroaryl groups such as 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrirnidyl, 4-pyrirnidyl, 5-pyrirnidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl, 1,3,5-triazin-2-yl, 1,2,4,5-tetrazin-3-yl, 1,2,3,4-tetrazin-5-yl, 2-quinolinyl, 3-quinolinyl, 4-quinolinyl, 5-quinolinyl, 6-quinolinyl, 7-quinolinyl, 8-quinolinyl, 1-isoquinolinyl, 3-isoquinolinyl, 4-isoquinolinyl, 5-isoquinolinyl, 6-isoquinolinyl, 7-isoquinolinyl, 8-isoquinolinyl, 2-quinoxanyl, 5-quinoxanyl, 6-quinoxanyl, 2-quinazolinyl, 4-quinazolinyl, 5-quinazolinyl, 6-quinazolinyl, 7-quinazolinyl, 8-quinazolinyl, 3-cinnolinyl, 4-cinnolinyl, 5-cinnolinyl, 6-cinnolinyl, 7-cinnolinyl and 8-cinnolinyl groups.

Of these, R¹ and R² are preferably hydrogen atoms, fluorine atoms, cyano groups, alkyl groups of 1 to 20 carbon atoms which may be substituted with halogen atoms, aryl groups of 6 to 20 carbon atoms which may be substituted with halogen atoms, or heteroaryl groups of 2 to 20 carbon atoms which may be substituted with halogen atoms; more preferably hydrogen atoms, fluorine atoms, cyano groups, alkyl groups of 1 to 10 carbon atoms which may be substituted with halogen atoms, or phenyl groups which may be substituted with halogen atoms; more preferably hydrogen atoms, fluorine atoms, methyl groups or trifluoromethyl groups; and most preferably hydrogen atoms.

In formulas (1) and (2), Ph¹ represents a group of formula (P1)

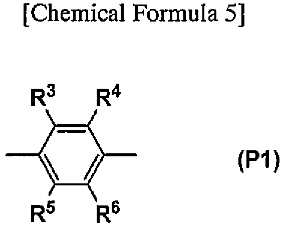

In this formula, R³ to R⁶ are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom. These are exemplified in the same way as described above for R¹ and R².

In particular, R³ to R⁶ are preferably hydrogen atoms, fluorine atoms, cyano groups, alkyl groups of 1 to 20 carbon atoms which may be substituted with halogen atoms, aryl groups of 6 to 20 carbon atoms which may be substituted with halogen atoms, or heteroaryl groups of 2 to 20 carbon atoms which may be substituted with halogen atoms; more preferably hydrogen atoms, fluorine atoms, cyano groups, alkyl groups of 1 to 10 carbon atoms which may be substituted with halogen atoms, or phenyl groups which may be substituted with halogen atoms; even more preferably hydrogen atoms, fluorine atoms, methyl groups or trifluoromethyl groups; and most preferably hydrogen atoms.

Groups which are preferred as Ph¹ include, but are not limited to, the following.

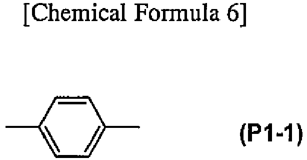

Each Ar¹ in formula (1) is independently any moiety of formulas (B1) to (B11), with any moiety of formulas (B1') to (B11') being especially preferred.

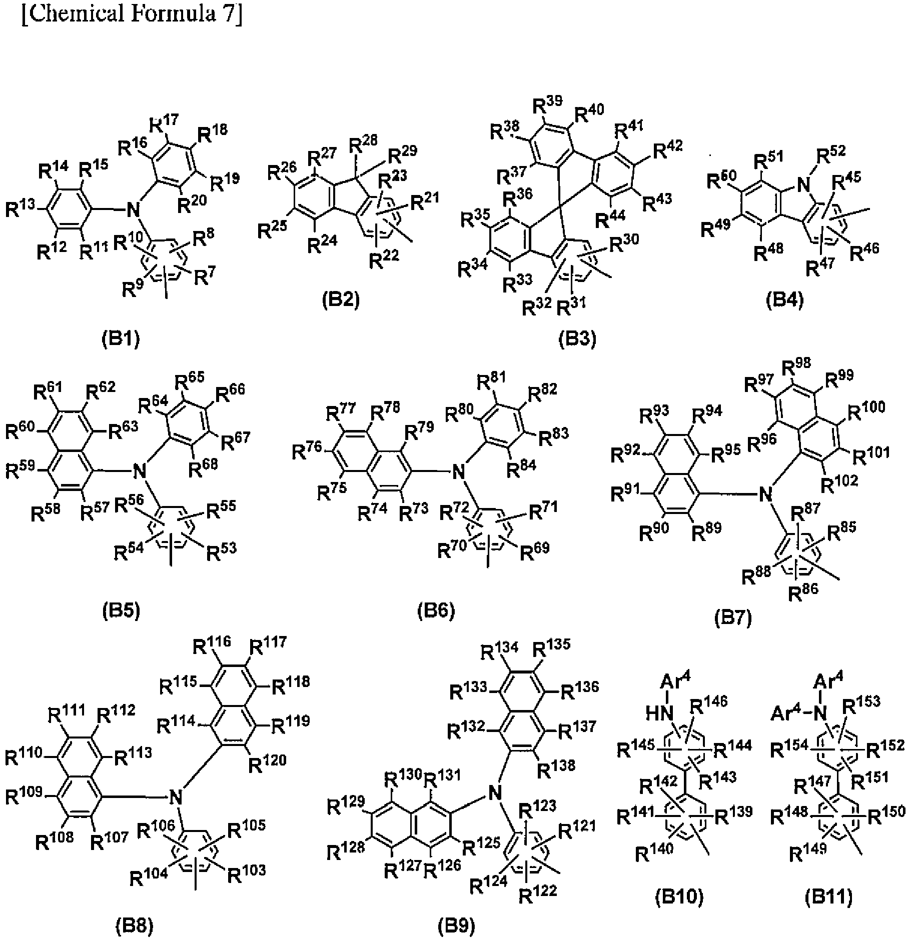

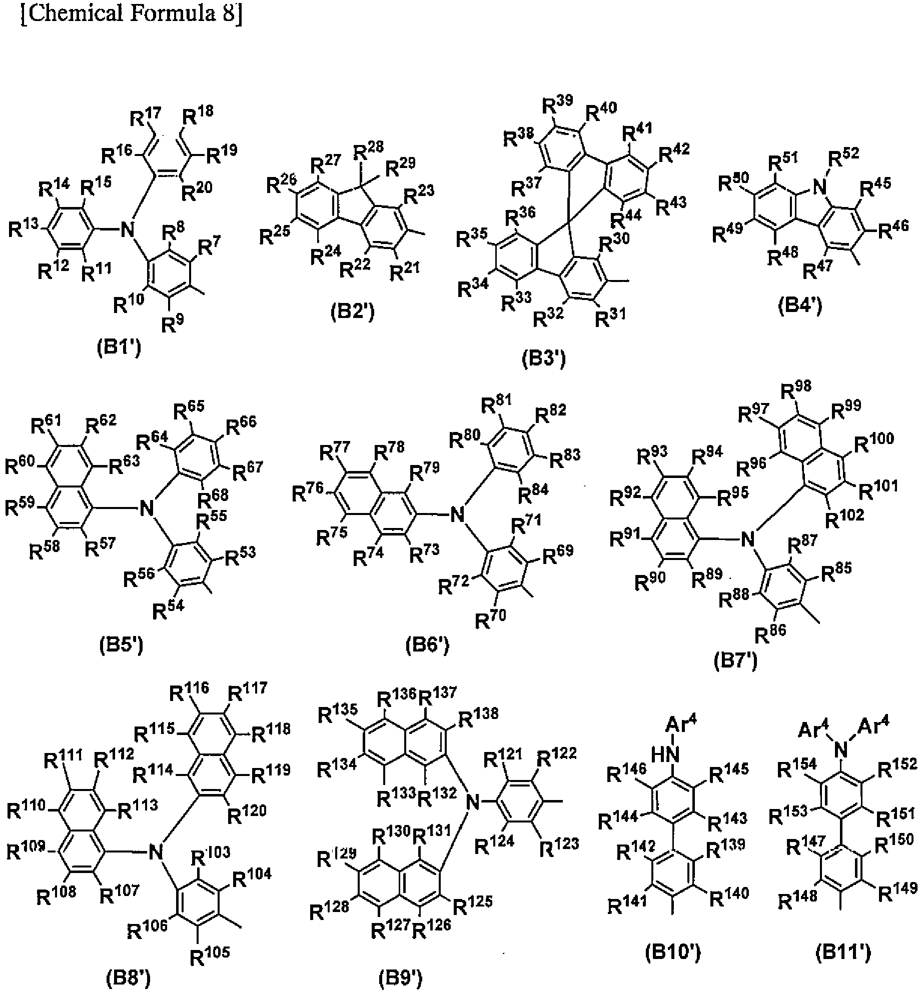

In these formulas, R⁷ to R²⁷, R³⁰ to R⁵¹ and R⁵³ to R¹⁵⁴ are each independently a hydrogen atom, a halogen atom, a nitro group, a cyano group, or a diphenylamino group, alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom; R²⁸ and R²⁹ are each independently an aryl group of 6 to 20 carbon atoms or heteroaryl group of 2 to 20 carbon atoms which may be substituted with Z¹; R⁵² is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹; Z¹ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z²; Z² is a halogen atom, a nitro group, a cyano group, or an aryl group of 6 to 20 carbon atoms or heteroaryl group of 2 to 20 carbon atoms which may be substituted with Z³; Z³ is a halogen atom, a nitro group or a cyano group; Z⁴ is a halogen atom, a nitro group, a cyano group, or an aryl group of 6 to 20 carbon atoms or heteroaryl group of 2 to 20 carbon atoms which may be substituted with Z⁵; and Z⁵ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z³. These halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms are exemplified in the same way as explained above for R¹ and R².

In particular, R⁷ to R²⁷, R³⁰ to R⁵¹ and R⁵³ to R¹⁵⁴ are preferably hydrogen atoms, fluorine atoms, cyano groups, diphenylamino groups which may be substituted with halogen atoms, alkyl groups of 1 to 20 carbon atoms which may be substituted with halogen atoms, aryl groups of 6 to 20 carbon atoms which may be substituted with halogen atoms, or heteroaryl groups of 2 to 20 carbon atoms which may be substituted with halogen atoms; more preferably hydrogen atoms, fluorine atoms, cyano groups, alkyl groups of 1 to 10 carbon atoms which may be substituted with halogen atoms or phenyl groups which may be substituted with halogen atoms; even more preferably hydrogen atoms, fluorine atoms, methyl groups or trifluoromethyl groups; and most preferably hydrogen atoms.

R²⁸ and R²⁹ are preferably aryl groups of 6 to 14 carbon atoms which may be substituted with Z¹ or heteroaryl groups of 2 to 14 carbon atoms which may be substituted with Z¹; more preferably aryl groups of 6 to 14 carbon atoms which may be substituted with Z¹, and even more preferably phenyl groups which may be substituted with Z¹, 1-naphthyl groups which may be substituted with Z¹ or 2-naphthyl groups which may be substituted with Z¹.

R⁵² is preferably a hydrogen atom, an aryl group of 6 to 20 carbon atoms which may be substituted with Z¹, a heteroaryl group of 2 to 20 carbon atoms which may be substituted with Z¹, or an alkyl group of 1 to 20 carbon atoms which may be substituted with Z⁴; more preferably a hydrogen atom, an aryl group of 6 to 14 carbon atoms which may be substituted with Z¹, a heteroaryl group of 2 to 14 carbon atoms which may be substituted with Z¹ or an alkyl group of 1 to 10 carbon atoms which may be substituted with Z⁴; even more preferably a hydrogen atom, an aryl group of 6 to 14 carbon atoms which may be substituted with Z¹, a nitrogen-containing heteroaryl group of 2 to 14 carbon atoms which may be substituted with Z¹, or an alkyl group of 1 to 10 carbon atoms which may be substituted with Z⁴; and still more preferably a hydrogen atom, a phenyl group which may be substituted with Z¹, a 1-naphthyl group which may be substituted with Z¹, a 2-naphthyl group which may be substituted with Z¹, a 2-pyridyl group which may be substituted with Z¹, a 3-pyridyl group which may be substituted with Z¹, a 4-pyridyl group which may be substituted with Z¹ or a methyl group which may be substituted with Z⁴.

Each Ar⁴ is independently an aryl group of 6 to 20 carbon atoms which may be substituted with a diarylamino group wherein each aryl group is an aryl group of 6 to 20 carbon atoms. The aryl group of 6 to 20 carbon atoms is exemplified in the same way as described for R¹ and R². Examples of the diarylamino group include diphenylamino, 1-naphthylphenylamino, di(1-naphthyl)amino, 1-naphthyl-2-naphthylamino and di(2-naphthyl)amino groups.

Ar⁴ is preferably a phenyl, 1-naphthyl, 2-naphthy, 1-anthryl, 2,-anthryl, 9-anthryl, 1-phenanthryl, 2-phenanthryl, 3-phenanthryl, 4-phenanthryl, 9-phenanthryl, p-(diphenylamino)phenyl, p-(1-naphthylphenylamino)phenyl, p-(di(1-naphthyl)amino)phenyl, p-(1-naphthyl-2-naphthylamino)phenyl or p-(di(2-naphthylamino)phenyl group; and more preferably a p-(diphenylamino)phenyl group.

Groups which are preferred as Ar¹ include, but are not limited to, the following. In the formulas below, DPA stands for a diphenylamino group and R⁵² is as defined above.

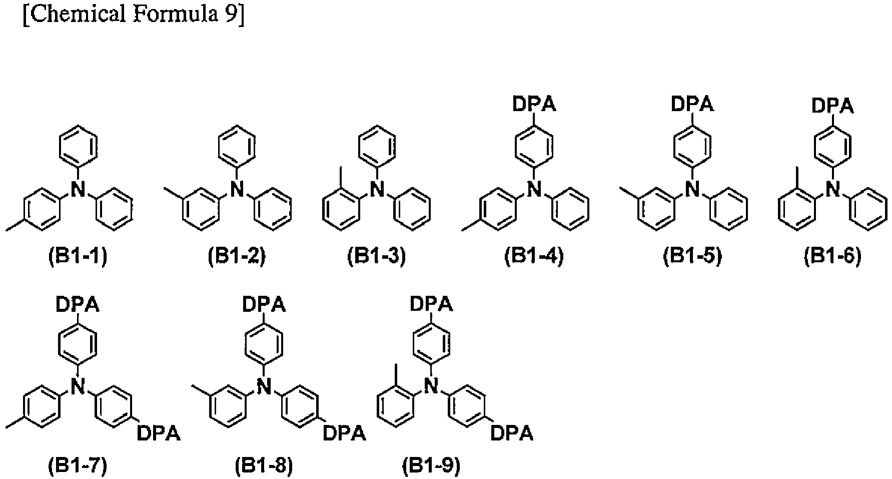

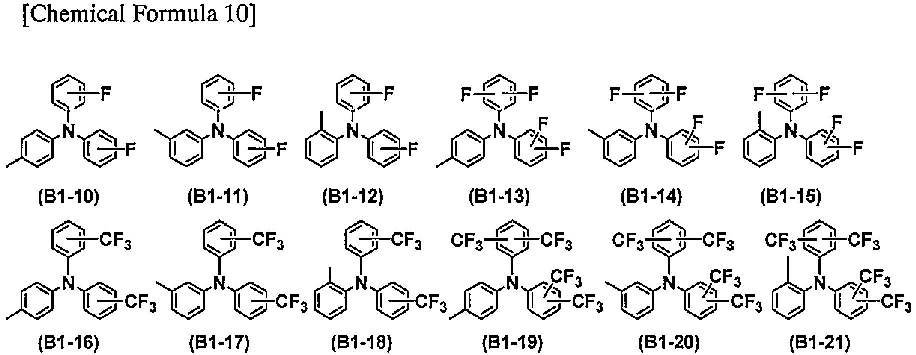

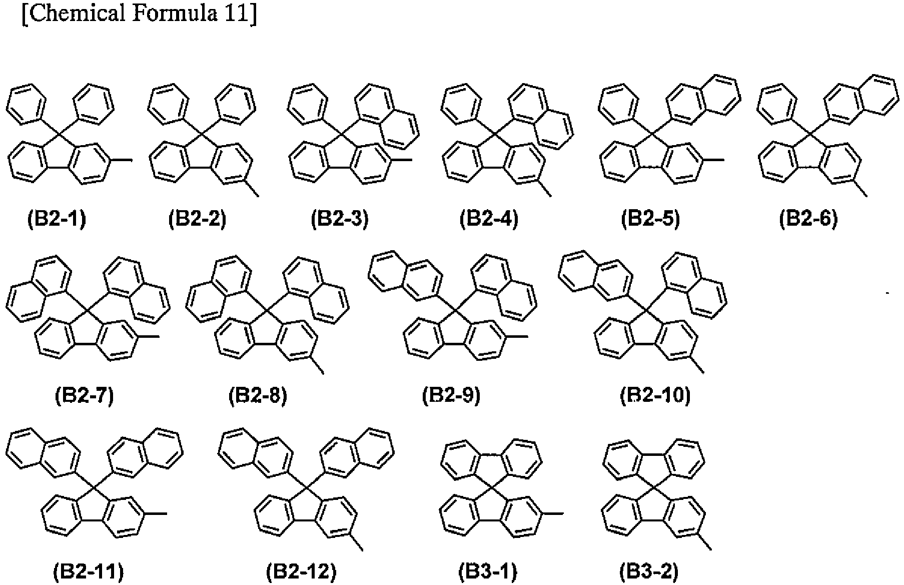

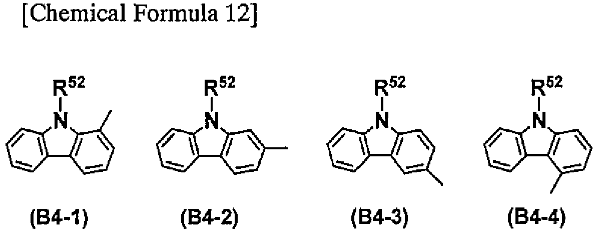

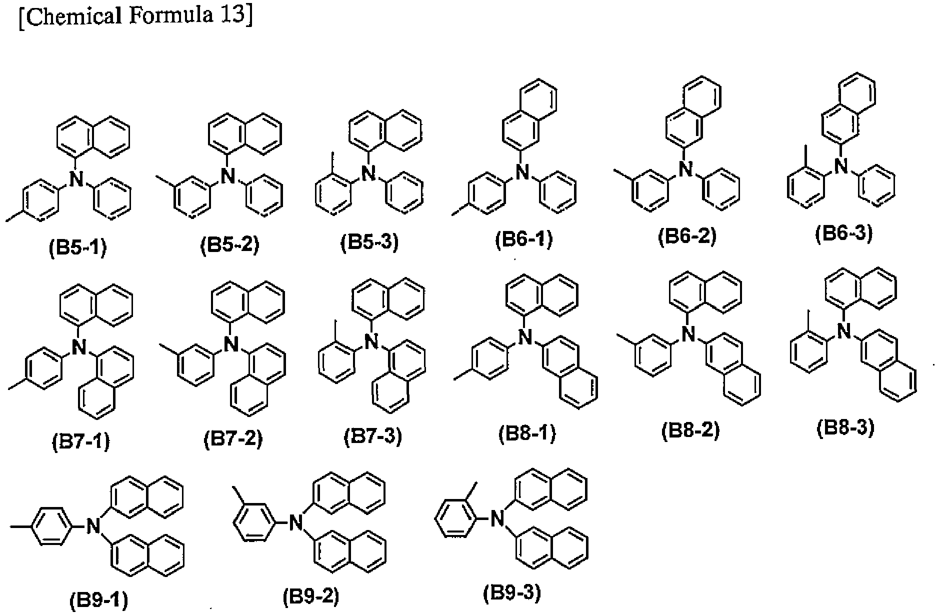

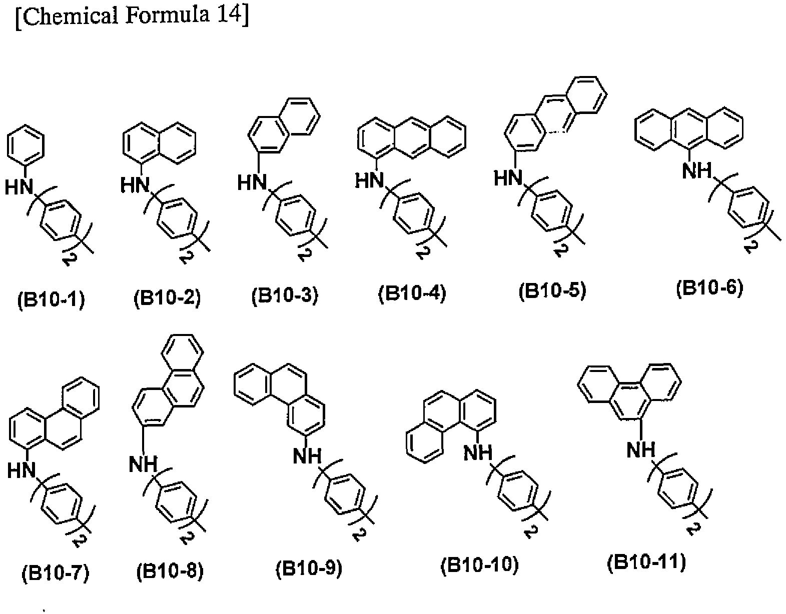

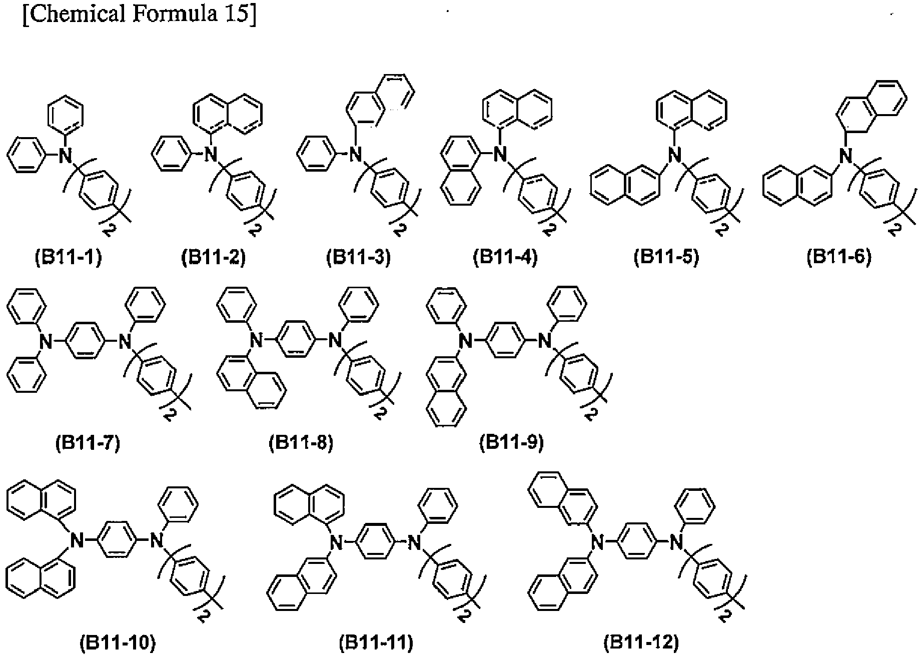

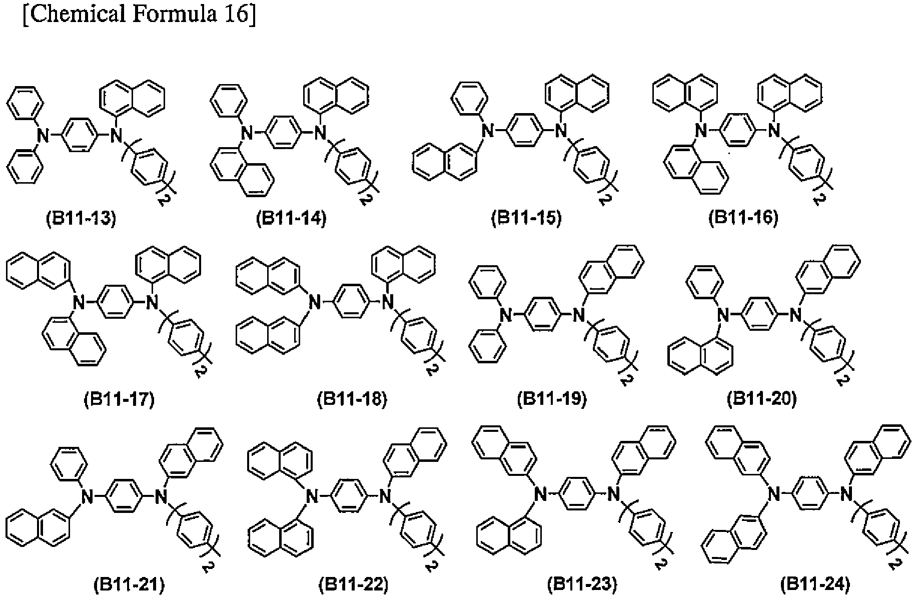

In formula (1), each Ar² is independently a group of any one of formulas (A1) to (A18).

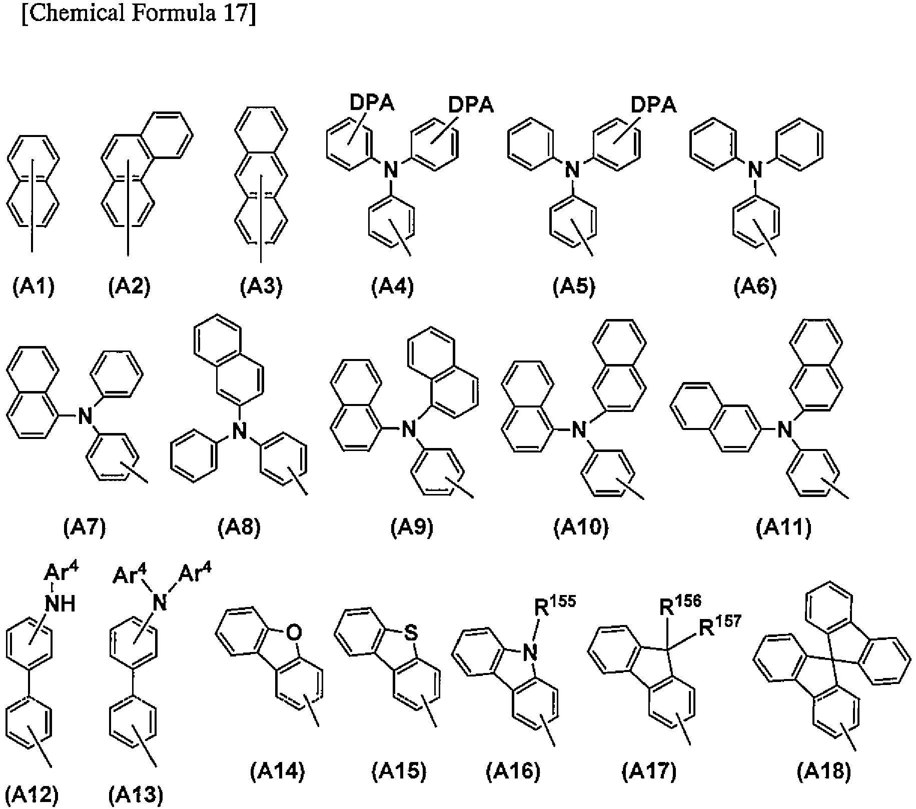

Here, R¹⁵⁵ is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹; R¹⁵⁶ and R¹⁵⁷ are each independently an aryl group of 6 to 20 carbon atoms or heteroaryl group of 2 to 20 carbon atoms which may be substituted with Z¹; and DPA, Ar⁴, Z¹ and Z⁴ are as defined above. These halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms are exemplified in the same way as described above for R¹ and R².

In particular, R¹⁵⁵ is preferably a hydrogen atom, an aryl group of 6 to 20 carbon atoms which may be substituted with Z¹, a heteroaryl group of 2 to 20 carbon atoms which may be substituted with Z¹ or an alkyl group of 1 to 20 carbon atoms which may be substituted with Z⁴; more preferably a hydrogen atom, an aryl group of 6 to 14 carbon atoms which may be substituted with Z¹, a heteroaryl group of 2 to 14 carbon atoms which may be substituted with Z¹ or an alkyl group of 1 to 10 carbon atoms which may be substituted with Z⁴; even more preferably a hydrogen atom, an aryl group of 6 to 14 carbon atoms which may be substituted with Z¹, a nitrogen-containing heteroaryl group of 2 to 14 carbon atoms which may be substituted with Z¹ or an alkyl group of 1 to 10 carbon atoms which may be substituted with Z⁴; and still more preferably a hydrogen atom, a phenyl group which may be substituted with Z¹, a 1-naphthyl group which may be substituted with Z¹, a 2-naphthyl group which may be substituted with Z¹, a 2-pyridyl group which may be substituted with Z¹, a 3-pyridyl group which may be substituted with Z¹, a 4-pyridyl group which may be substituted with Z¹ or a methyl group which may be substituted with Z⁴.

R¹⁵⁶ and R¹⁵⁷ are preferably aryl groups of 6 to 14 carbon atoms which may be substituted with Z¹ or heteroaryl groups of 6 to 14 carbon atoms which may be substituted with Z¹, more preferably aryl groups of 6 to 14 carbon atoms which may be substituted with Z¹; and even more preferably phenyl groups which may be substituted with Z¹, 1-naphthyl groups which may be substituted with Z¹ or 2-naphthyl groups which may be substituted with Z¹.

Groups which are preferred as Ar² include, but are not limited to, the following. In the formulas below, R¹⁵⁵ and DPA are as defined above.

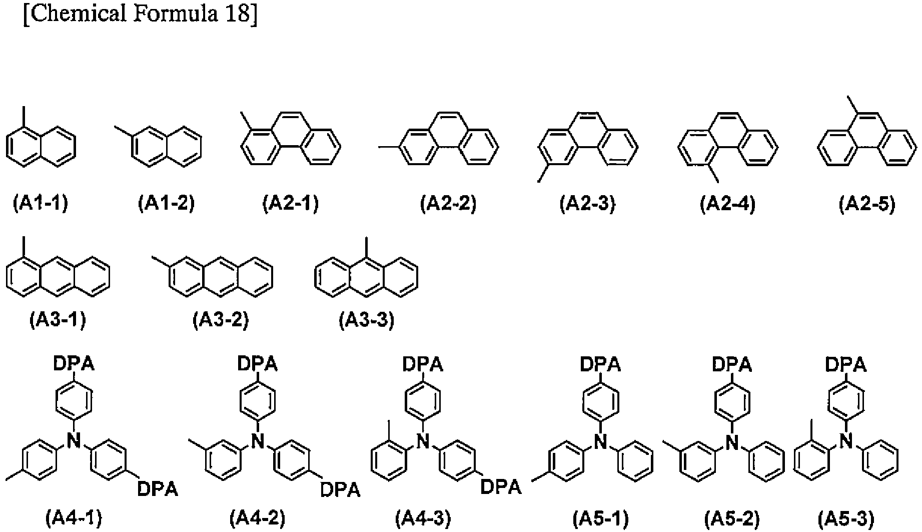

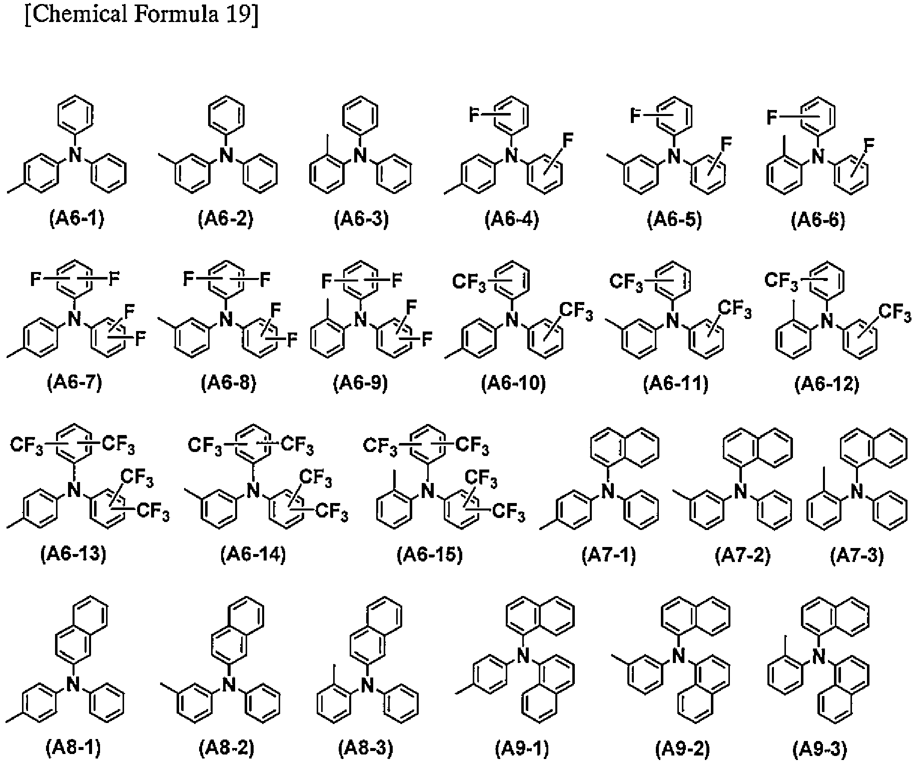

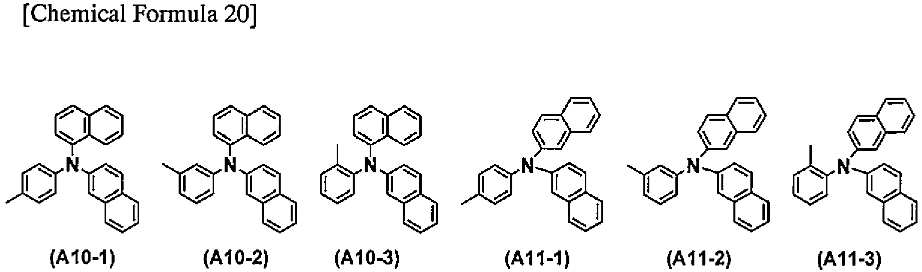

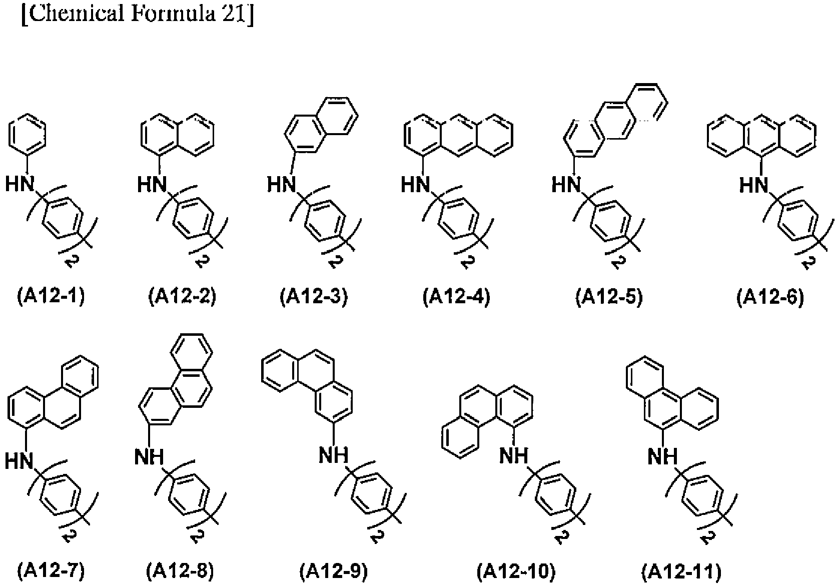

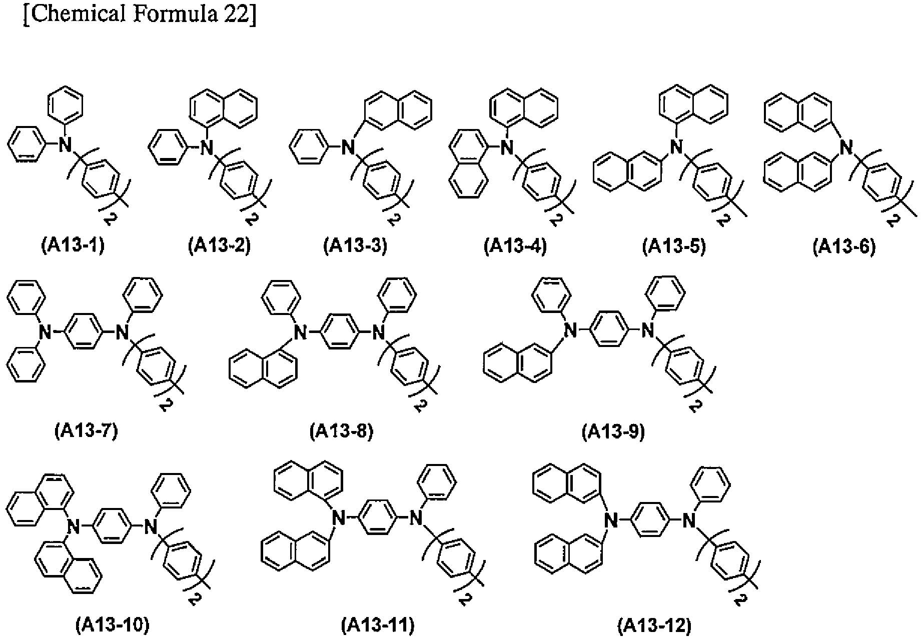

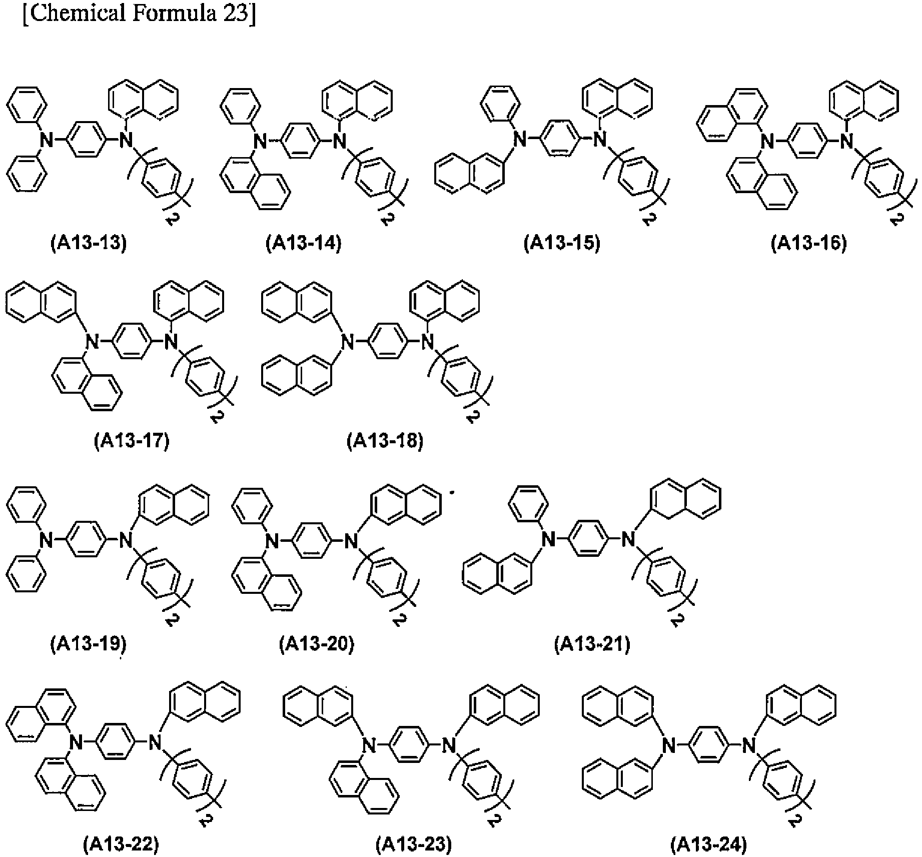

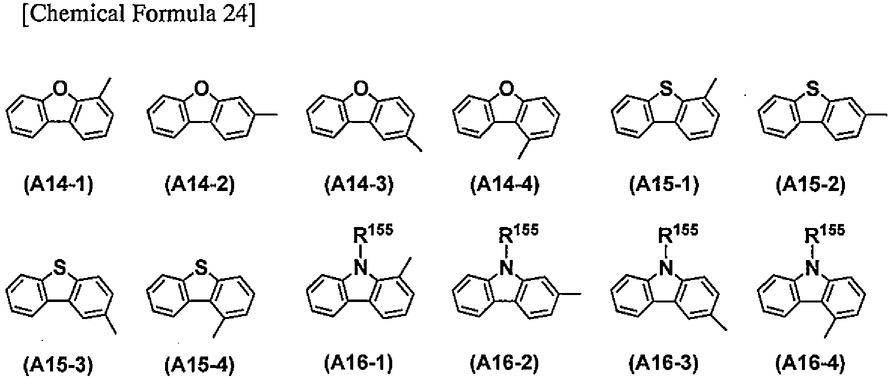

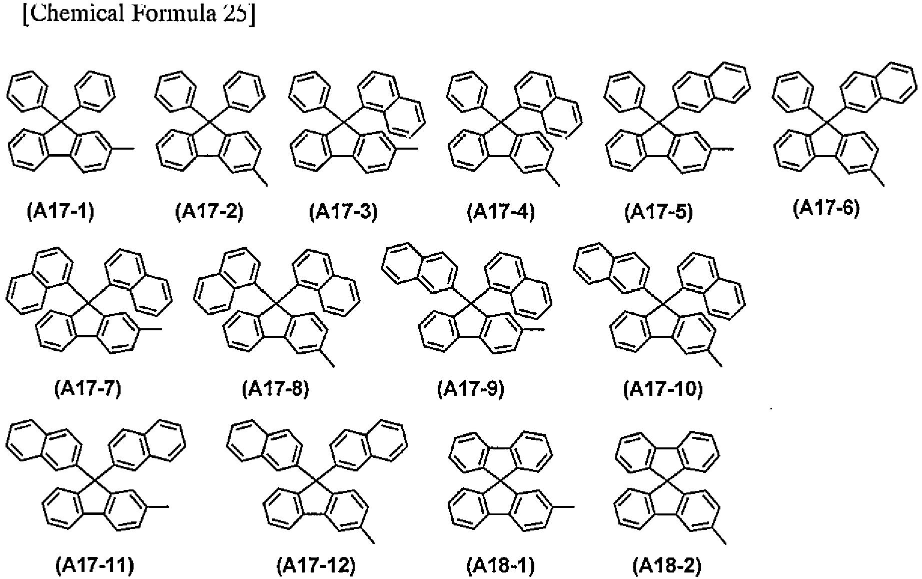

In formula (1), taking into account the ease of synthesizing the aniline derivative to be obtained, it is preferable for all Ar¹ groups to be the same group and for all Ar² groups to be the same group, and more preferably for all Ar¹ and Ar² groups to be the same group. That is, the aniline derivative of formula (1) is more preferably an aniline derivative of formula (1-1) below.

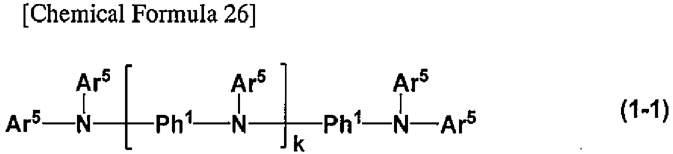

In formula (1-1), Ph¹ and k are as defined above and each Ar⁵ is a group of any of formulas (D1) to (D13), with a group of any of formulas (D1') to (D13') being especially preferred. Also, in the formulas below, R²⁸, R²⁹, R⁵², Ar⁴ and DPA are as defined above. Ar⁵ is exemplified by the same groups as mentioned above as examples of preferred groups for Ar¹.

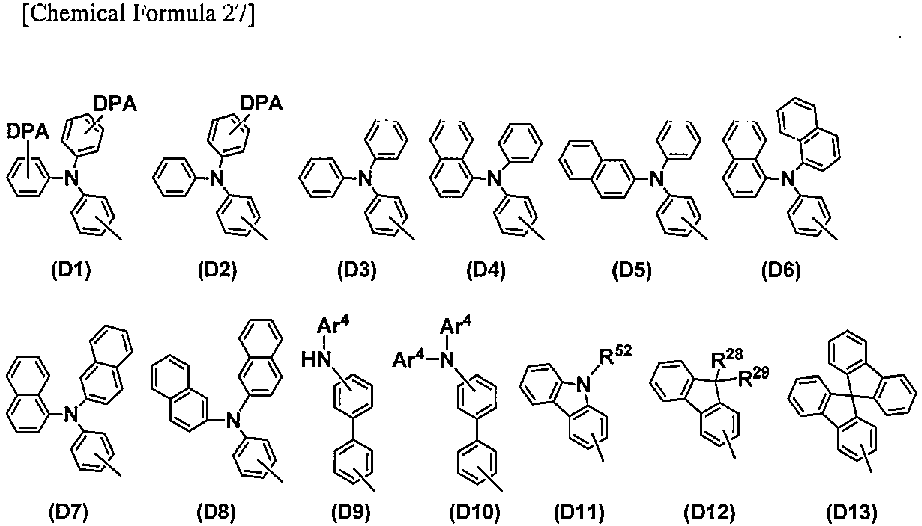

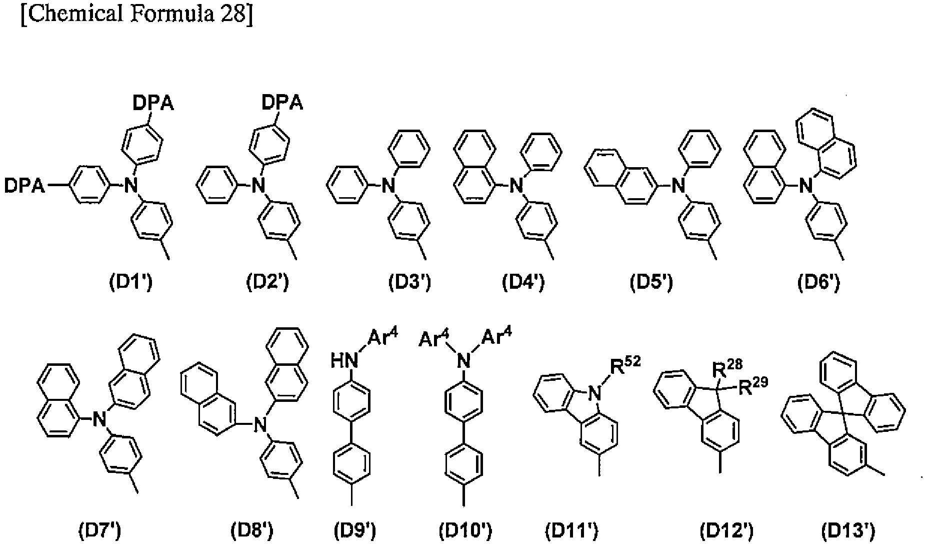

Also, the aniline derivative of formula (1) is preferably an aniline derivative of formula (1-2) because it can be relatively easily synthesized using, as subsequently described, a relatively inexpensive bis(4-aminophenyl)amine as the starting compound and because the resulting aniline derivative has an excellent solubility in organic solvents.

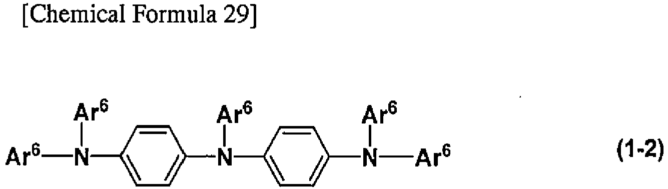

In this formula, each Ar⁶ represents a group of any of the formulas (E1) to (E14). In the following formulas, R⁵² is as defined above.

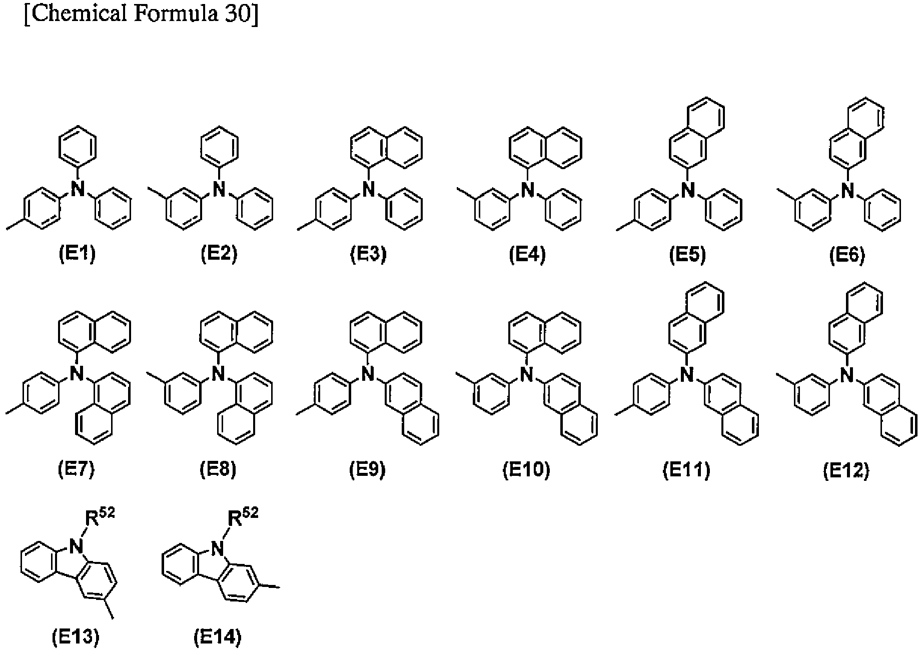

In formula (2), Ar³ is a group of any of formulas (C1) to (C8), with a group of any of formulas (C1') to (C8') being especially preferred. In the formulas below, DPA is as defined above.

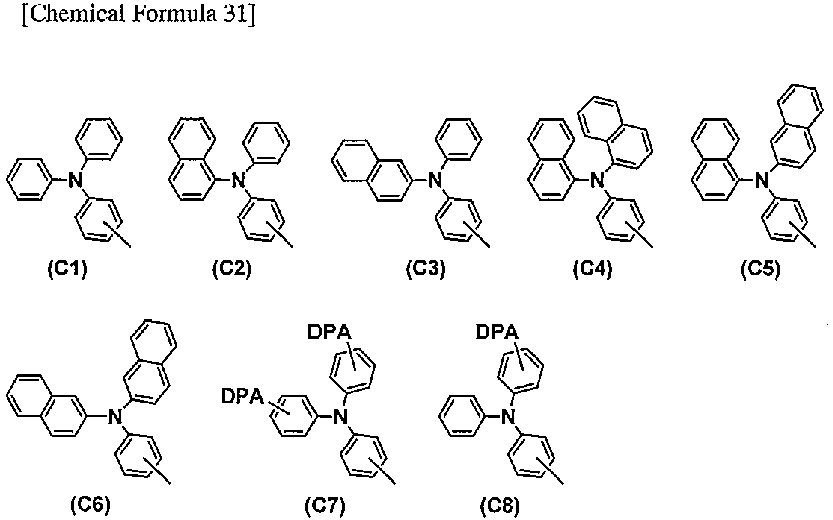

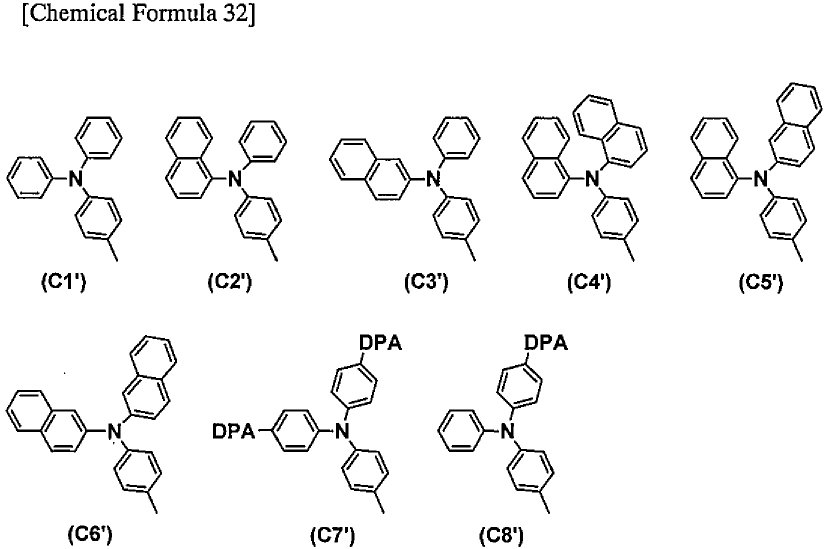

In R²⁸, R²⁹, R⁵² and R¹⁵⁵ to R¹⁵⁷, Z¹ is preferably a halogen atom, a nitro group, a cyano group, an alkyl group of 1 to 10 carbon atoms which may be substituted with Z², an alkenyl group of 2 to 10 carbon atoms which may be substituted with Z² or an alkynyl group of 2 to 10 carbon atoms which may be substituted with Z²; more preferably a halogen atom, a nitro group, a cyano group, an alkyl group of 1 to 3 carbon atoms which may be substituted with Z², an alkenyl group of 2 or 3 carbon atoms which may be substituted with Z² or an alkynyl group of 2 or 3 carbon atoms which may be substituted with Z²; and even more preferably a fluorine atom, an alkyl group of 1 to 3 carbon atoms which may be substituted with Z², an alkenyl group of 2 or 3 carbon atoms which may be substituted with Z² or an alkynyl group of 2 or 3 carbon atoms which may be substituted with Z².

In R²⁸, R²⁹, R⁵² and R¹⁵⁵ to R¹⁵⁷, Z⁴ is preferably a halogen atom, a nitro group, a cyano group, or an aryl group of 6 to 14 carbon atoms which may be substituted with Z⁵; more preferably a halogen atom, a nitro group, a cyano group, or an aryl group of 6 to 10 carbon atoms which may be substituted with Z⁵; even more preferably a fluorine atom or an aryl group of 6 to 10 carbon atoms which may be substituted with Z⁵; and still more preferably a fluorine atom or a phenyl group which may be substituted with Z⁵.

In R²⁸, R²⁹, R⁵² and R¹⁵⁵ to R¹⁵⁷, Z² is preferably a halogen atom, a nitro group, a cyano group, or an aryl group of 6 to 14 carbon atoms which may be substituted with Z³; more preferably a halogen atom, a nitro group, a cyano group, or an aryl group of 6 to 10 carbon atoms which may be substituted with Z³; even more preferably a fluorine atom or an aryl group of 6 to 10 carbon atoms which may be substituted with Z³; and still more preferably a fluorine atom or a phenyl group which may be substituted with Z³.

In R²⁸, R²⁹, R⁵² and R¹⁵⁵ to R¹⁵⁷, Z⁵ is preferably a halogen atom, a nitro group, a cyano group, an alkyl group of 1 to 10 carbon atoms which may be substituted with Z³, an alkenyl group of 2 to 10 carbon atoms which may be substituted with Z³, or an alkynyl group of 2 to 10 carbon atoms which may be substituted with Z³; more preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; and even more preferably a fluorine atom, an alkyl group of 1 to 3 carbon atoms which may be substituted with Z³, an alkenyl group of 2 or 3 carbon atoms which may be substituted with Z³ or an alkynyl group of 2 or 3 carbon atoms which may be substituted with Z³.

In R²⁸, R²⁹, R⁵² and R¹⁵⁵ to R¹⁵⁷, Z³ is preferably a halogen atom, and more preferably a fluorine atom.

In R⁷ to R²⁷, R³⁰ to R⁵¹ and R⁵³ to R¹⁵⁴, Z¹ is preferably a halogen atom, a nitro group, a cyano group, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z²; more preferably a halogen atom or an alkyl group of 1 to 3 carbon atoms which may be substituted with Z²; and even more preferably a fluorine atom or a methyl group which may be substituted with Z².

In R⁷ to R²⁷, R³⁰ to R⁵¹ and R⁵³ to R¹⁵⁴, Z⁴ is preferably a halogen atom, a nitro group, a cyano group, or an aryl group of 6 to 10 carbon atoms which may be substituted with Z⁵; more preferably a halogen atom or an aryl group of 6 to 10 carbon atoms which may be substituted with Z⁵; and even more preferably a fluorine atom or a phenyl group which may be substituted with Z⁵.

In R⁷ to R²⁷, R³⁰ to R⁵¹ and R⁵³ to R¹⁵⁴, Z² is preferably a halogen atom, a nitro group, a cyano group, or an aryl group of 6 to 10 carbon atoms which may be substituted with Z³; more preferably a halogen atom or an aryl group of 6 to 10 carbon atoms which may be substituted with Z³; and even more preferably a fluorine atom or a phenyl group which may be substituted with Z³.

In R⁷ to R²⁷, R³⁰ to R⁵¹ and R⁵³ to R¹⁵⁴, Z⁵ is preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; more preferably a halogen atom or an alkyl group of 1 to 3 carbon atoms which may be substituted with Z³; and even more preferably a fluorine atom or a methyl group which may be substituted with Z³.

In R⁷ to R²⁷, R³⁰ to R⁵¹ and R⁵³ to R¹⁵⁴, Z³ is preferably a halogen atom, and more preferably a fluorine atom.

In the present invention, examples of preferred groups as R⁵² and R¹⁵⁵ include, but are not limited to, those shown below.

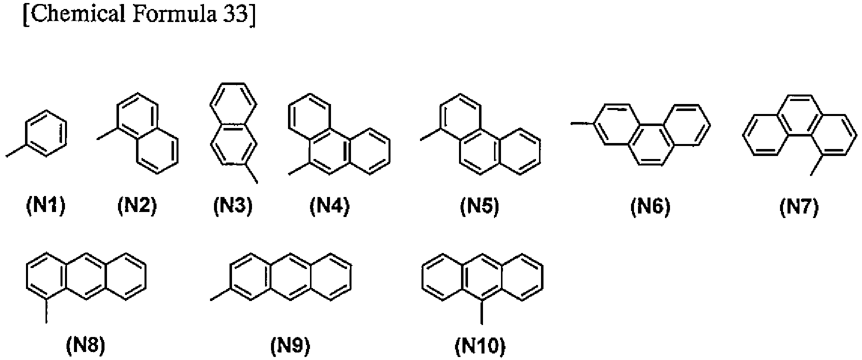

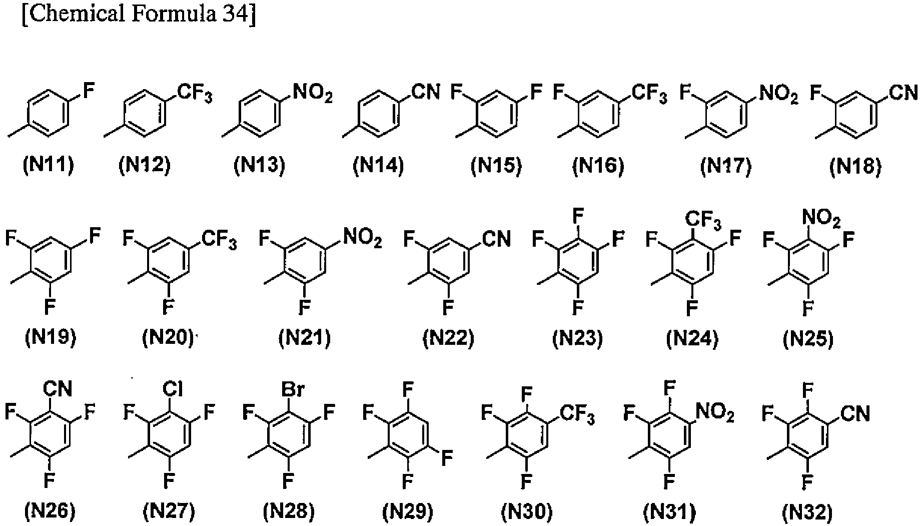

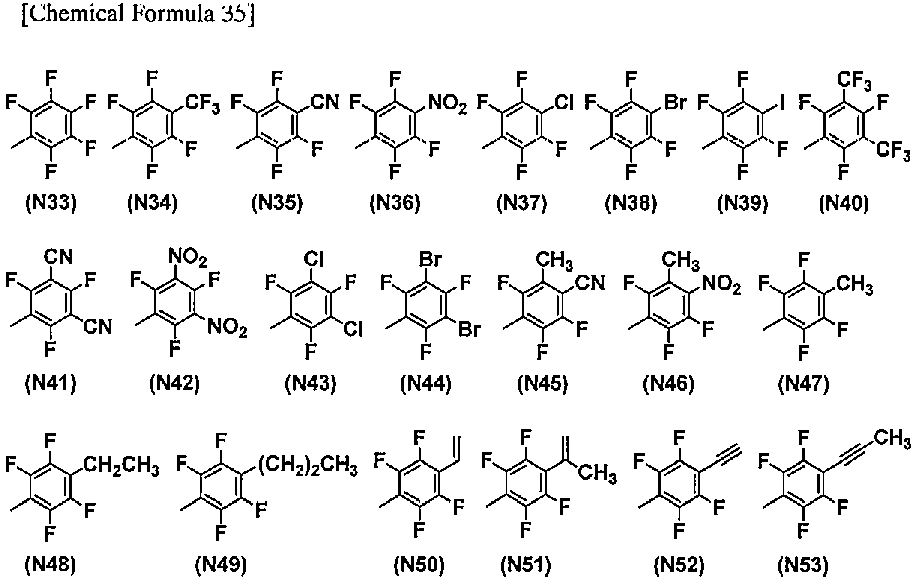

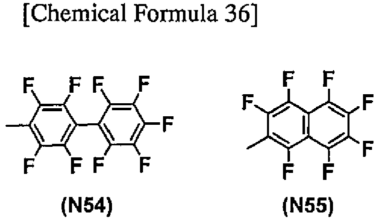

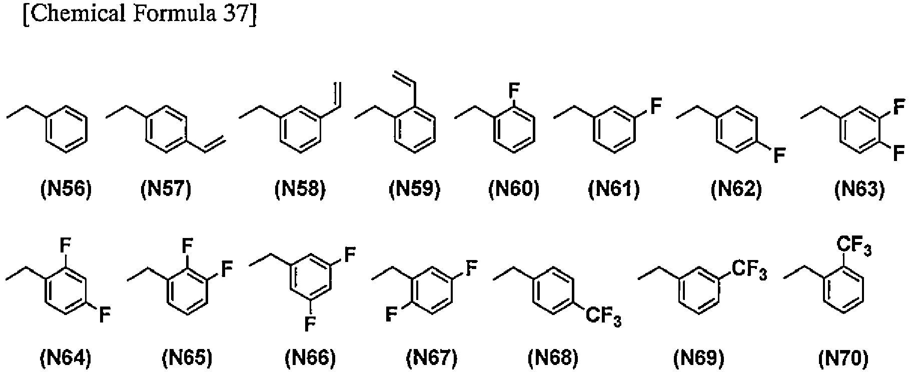

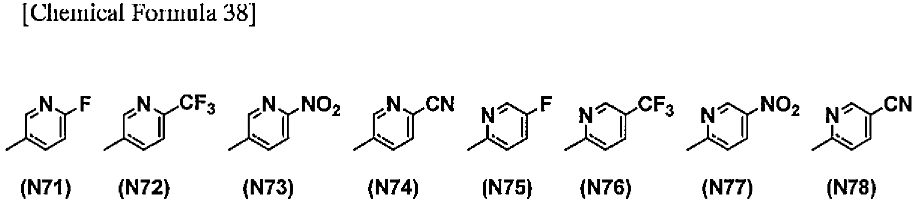

In this invention, the number of carbon atoms on the above alkyl, alkenyl and alkynyl groups is preferably 10 or less, more preferably 6 or less, and even more preferably 4 or less. The number of carbon atoms on the above aryl groups and heteroaryl groups is preferably 14 or less, more preferably 10 or less, and even more preferably 6 or less.

The aniline derivative of formula (1) can be prepared by reacting an amine compound of formula (3) with an aryl compound of formula (4) in the presence of a catalyst. 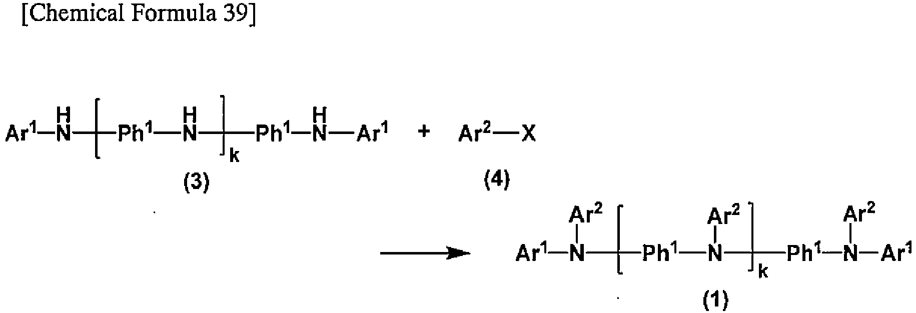 Here, X is a halogen atom or a pseudo-halogen group, and Ar¹, Ar², Ph¹ and k are as defined above.

In particular, the aniline derivative of formula (1-1) can be prepared by reacting an amine compound of formula (7) with an aryl compound of formula (8) in the presence of a catalyst. 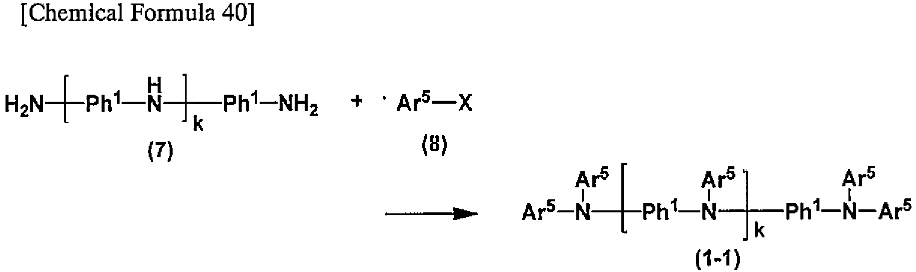 Here, X, Ar⁵, Ph¹ and k are as defined above.

The aniline derivative of formula (1-2) can be prepared by reacting bis(4-aminophenyl)amine with an aryl compound of formula (9) in the presence of a catalyst. 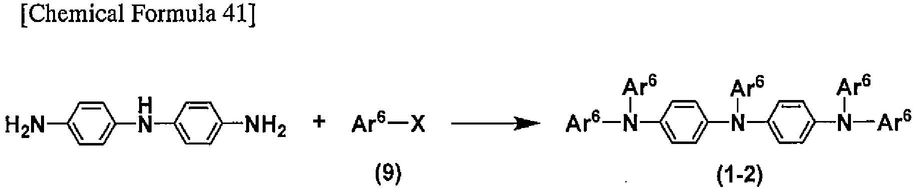 Here, X and Ar⁶ are as defined above.

The aniline derivative of formula (2) can be prepared by reacting an amine compound of formula (5) with an aryl compound of formula (6) in the presence of a catalyst. 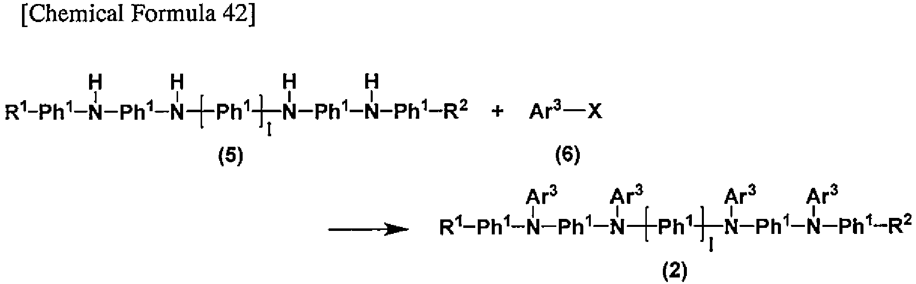 Here, X, R¹, R², Ar³, Ph¹ and the letter "l" are as defined above.

The halogen atom is exemplified in the same way as above. The pseudo-halogen group is exemplified by (fluoro)alkylsulfonyloxy groups such as methanesulfonyloxy, trifluoromethanesulfonyloxy and nanofluorobutanesulfonyloxy groups; and aromatic sulfonyloxy groups such as benzenesulfonyloxy and toluenesulfonyloxy groups.

The charging ratio between the amine compound of formula (3), (5) or (7) or bis(4-aminophenyl)amine and the aryl compound of formula (4), (6), (8) or (9) is preferably set so that the amount of aryl compound, with respect to the molar amount of all NH groups on the amine compound or bis(4-aminophenyl)amine, is at least 1 equivalent, and preferably about 1 to 1.2 equivalents.

Examples of catalysts that may be used in the reaction include copper catalysts such as copper chloride, copper bromide and copper iodide; and palladium catalysts such as tetrakis(triphenylphosphine)palladium (Pd(PPh₃)₄), bis(triphenylphosphine)dichloropalladium (Pd(PPh₃)₂Cl₂), bis(benzylideneacetone)palladium (Pd(dba)₂), tris(benzylideneacetone)dipalladium (Pd₂(dba)₃), bis(tri(t-butylphosphine)palladium (Pd(P-t-Bu₃)₂) and palladium acetate (Pd(OAc)₂). These catalysts may be used singly, or two or more may be used in combination. Also, these catalysts may be used together with suitable known ligands.

Examples of such ligands include tertiary phosphines such as triphenylphosphine, tri-o-tolylphosphine, diphenylmethylphosphine, phenyldimethylphosphine, trimethylphosphine, triethylphosphine, tributylphosphine, tri-t-butylphosphine, di-t-butyl(phenyl)phosphine, di-t-butyl(4-dimethylaminophenyl)phosphine, 1,2-bis(diphenylphosphino)ethane, 1,3-bis(diphenylphosphino)propane, 1,4-bis(diphenylphosphino)butane and 1,1'-bis(diphenylphosphino)ferrocene; and tertiary phosphites such as trimethylphosphite, triethylphosphite and triphenylphosphite.

The amount of catalyst used may be set to about 0.2 mole per mole of the aryl compound of formula (4), (6), (8) or (9), with about 0.15 mole being preferred. When ligands are used, the amount thereof may be set to from 0.1 to 5 equivalents, and preferably from 1 to 2 equivalents, with respect to the metal complex used.

In cases where the starting compounds are all solids or from the standpoint of efficiently obtaining the target aniline derivative, each of the above reactions is carried out in a solvent. When a solvent is used, the type thereof is not particularly limited, provided that it does not have an adverse influence on the reaction. Illustrative examples include aliphatic hydrocarbons (pentane, n-hexane, n-octane, n-decane, decalin, etc.), halogenated aliphatic hydrocarbons (chloroform, dichloromethane, dichloroethane, carbon tetrachloride, etc.), aromatic hydrocarbons (benzene, nitrobenzene, toluene, o-xylene, m-xylene, p-xylene, mesitylene, etc.), halogenated aromatic hydrocarbons (chlorobenzene, bromobenzene, o-dichlorobenzene, m-dichlorobenzene, p-dichlorobenzene, etc.), ethers (diethyl ether, diisopropyl ether, t-butyl methyl ether, tetrahydrofuran, dioxane, 1,2-dimethoxyethane, 1,2-diethoxyethane, etc.), ketones (acetone, methyl ethyl ketone, methyl isobutyl ketone, di-n-butyl ketone, cyclohexanone; etc.), amides (N,N-dimethylformamide, N,N-dimethylacetamide, etc.), lactams and lactones (N-methylpyrrolidone, y-butyrolactone, etc.), ureas (N,N-dimethylimidazolidinone, tetramethylurea, etc.), sulfoxides (dimethylsulfoxide, sulfolane, etc.), and nitriles (acetonitrile, propionitrile, butyronitrile, etc.). These solvents may be used singly, or two or more may be used in admixture.

The reaction temperature may be suitably set in the range of the melting point to the boiling point of the solvent used, with a temperature of from about 0 to about 200°C being preferred, and a temperature of from 20 to 150°C being more preferred.

Following reaction completion, the target aniline derivative can be obtained by work-up in the usual manner.

The amine compound of formula (3') that may be used as the starting material in the method for preparing the aniline derivative of formula (1) above can be efficiently prepared by reacting an amine compound of formula (10) with an aryl compound of formula (11) in the presence of a catalyst. 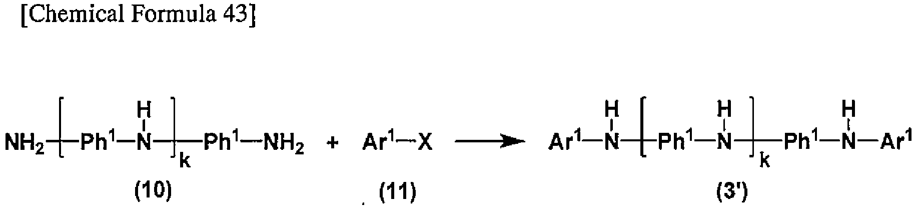 Here, X, Ar¹, Ph¹ and k are as defined above, provided that the two Ar¹ groups are not both groups of formula (B1).

The method for preparing the amine compound of formula (3') involves a coupling reaction between the amine compound of formula (10) and the aryl compound of formula (11). The amine compound of formula (10) and the aryl compound of formula (11) are charged in a molar ratio of about 2 to 2.4 of the aryl compound relative to unity (1) for the amine compound.

The conditions relating to, for example, the catalyst, ligands, solvent and reaction temperature in the coupling reaction are the same as the conditions described above for the method of preparing the aniline derivative of formula (1).

When preparing the aniline derivative of the invention wherein, in formula (1), Ar¹ is a group of formula (B4) in which R⁵² is a hydrogen atom or a group of formula (B10) or Ar² is a group of formula (A12) or a group of formula (A16) in which R¹⁵⁵ (including R⁵² in formula (1-1)) is a hydrogen atom, an aryl compound having protecting groups on the amino groups may be used in the above-described reactions.

Specifically, in the above reactions, in place of an aryl compound of formula (4) wherein Ar² is a group of formula (A12) (formula (G1)), an aryl compound of formula (4) wherein Ar² is a group of formula (A16) and R¹⁵⁵ is a hydrogen atom (formula (G2)), an aryl compound of formula (8) wherein Ar⁵ is a group of formula (D9) (formula (G1)), an aryl compound of formula (8) wherein Ar⁵ is a group of formula (D11) and R⁵² is a hydrogen atom (formula (G2)), an aryl compound of formula (9) wherein Ar⁶ is a group of formula (E13) and R⁵² is a hydrogen atom (formula (G3)), an aryl compound of formula (9) wherein Ar⁶ is a group of formula (E14) and R⁵² is a hydrogen atom (formula (G4)), an aryl compound of formula (11) wherein Ar¹ is a group of formula (B4) and R⁵² is a hydrogen atom (formula (G5)) and an aryl compound of formula (11) wherein Ar¹ is a group of formula (B10) (formula (G6)), aryl compounds in which the amino groups on these various aryl compounds have been protected (formulas (G1P) to (G6P)) are respectively used and, following the reaction of these protected aryl compounds with the amine compounds mentioned above in the presence of a catalyst, deprotection is carried out at a suitable timing. 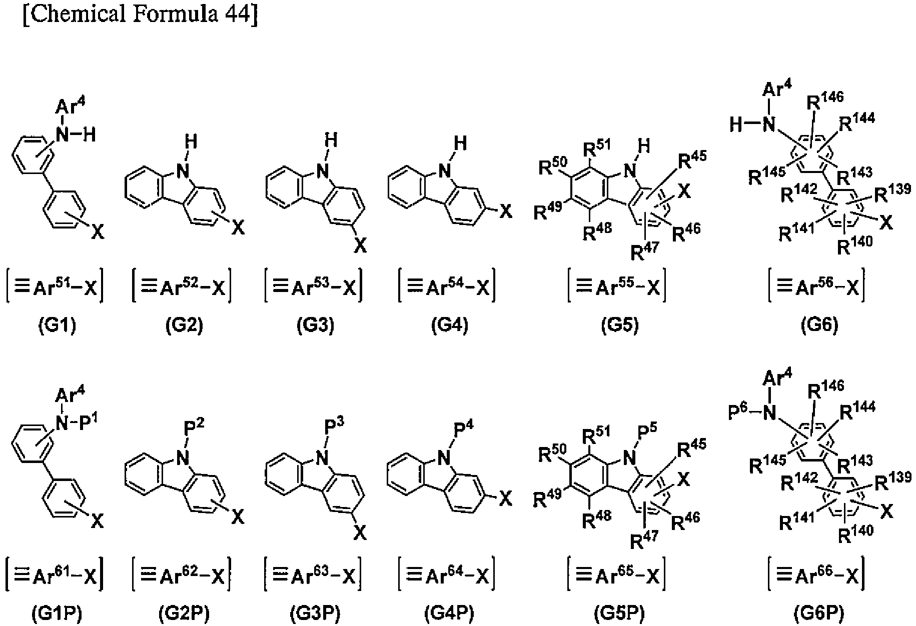 Here, X, R⁴⁵ to R⁵¹, R¹³⁹ to R¹⁴⁶ and Ar⁴ are as defined above.

P¹ to P⁶ are each independently amino group-protecting groups. Conventional protecting groups may be used as these protecting groups. Illustrative examples include, but are not limited to, oxycarbonyl-type protecting groups, such as substituted or unsubstituted alkoxycarbonyl groups (e.g., methoxycarbonyl, ethoxycarbonyl, t-butoxycarbonyl, 2,2,2-trichloroethoxycarbonyl, allyloxycarbonyl and 9-fluorenylmethyloxycarbonyl groups), substituted or unsubstituted aralkyloxycarbonyl groups (e.g., the benzyloxycarbonyl group) and substituted or unsubstituted aryloxycarbonyl groups (e.g., the phenoxycarbonyl group); the formyl group; carbonyl-type protecting groups, such as substituted or unsubstituted alkanoyl groups (e.g., acetyl, trifluoroacetyl and t-butanoyl groups) and substituted or unsubstituted arylcarbonyl groups (e.g., the benzoyl group); alkyl type protecting groups, such as substituted or unsubstituted alkyl groups (e.g., the t-butyl group) and substituted or unsubstituted aralkyl groups (e.g., benzyl, benzhydryl and trityl groups); and substituted or unsubstituted sulfonyl-type protecting groups (e.g., benzenesulfonyl, p-toluenesulfonyl and 2-nitrobenzenesulfonyl groups). Of these, oxycarbonyl-type protecting groups, carbonyl-type protecting groups, and alkyl-type protecting groups are preferred.

Also, Ar⁵¹ to Ar⁵⁶ and Ar⁶¹ to Ar⁶⁶ represent the monovalent groups obtained by excluding X (a halogen atom or a pseudo-halogen group) from the respective aryl compounds. For example, Ar⁶¹ to Ar⁶⁶ represent the following respective groups. 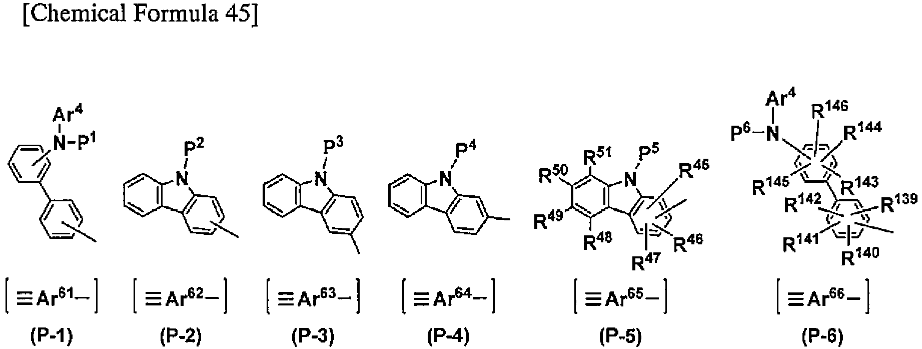 Here, P¹ to P⁶, R⁴⁵ to R⁵¹, R¹³⁹ to R¹⁴⁶ and Ar⁴ are as defined above.

Specific examples of preparation methods which use an aryl compound having the above-described amino group-protecting groups include, but are not limited to, those shown below.

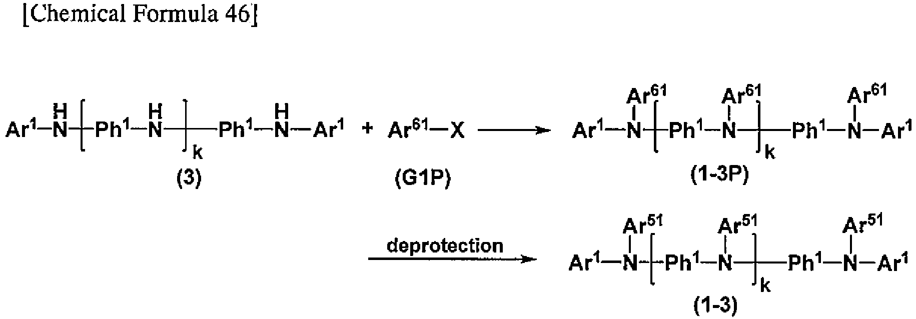

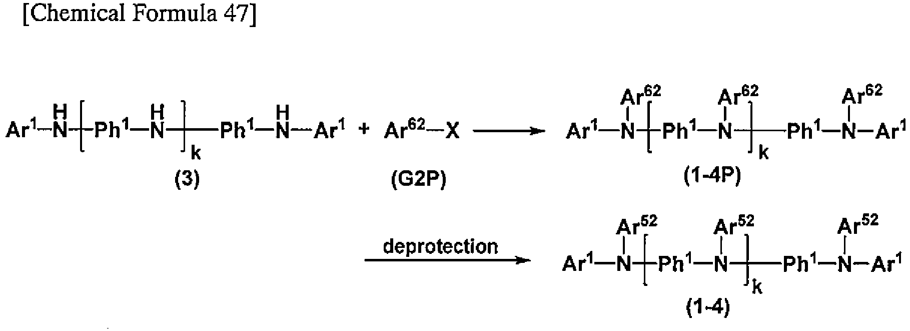

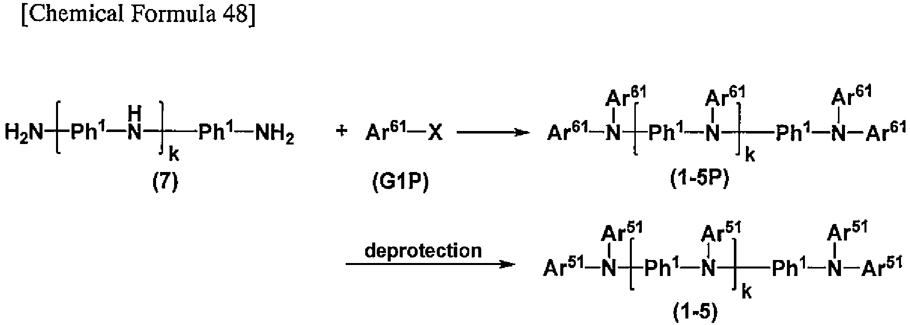

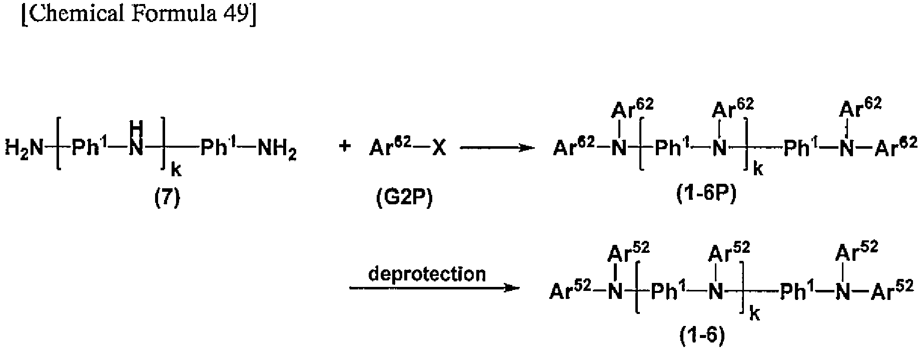

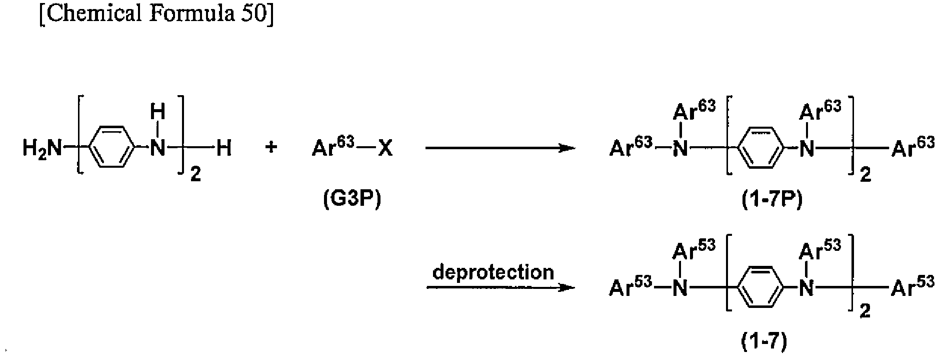

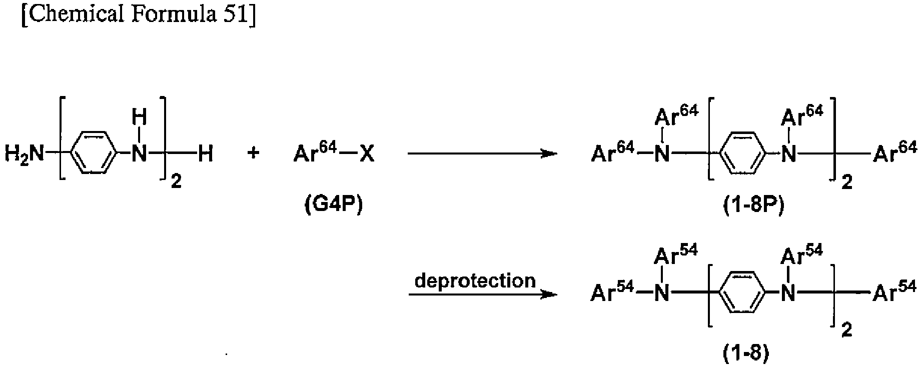

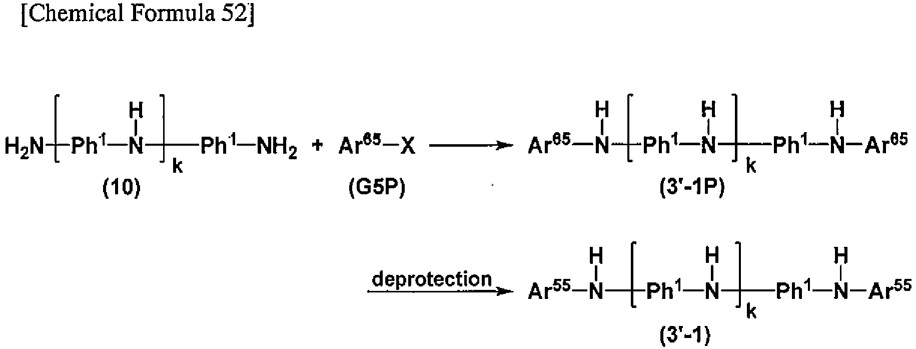

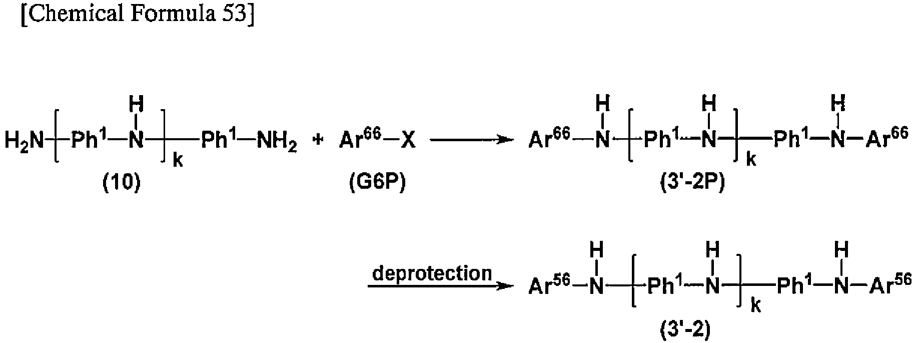

Conditions relating to, for example, the starting material charging ratios, catalysts, ligands, solvents and reaction temperatures in preparation methods which use such protecting group-bearing aryl compounds are the same as the conditions described above in connection with aniline derivatives of formula (1) or amine compounds of formula (3'). Moreover, deprotection may be carried out by a suitable known method while taking into account, for example, the nature of the protecting groups, such as by treatment under acidic or basic conditions or treatment under oxidizing or reducing conditions. To this end, reference may made to, for example, Green's Protective Groups in Organic Synthesis, 4th Edition.

When preparing a tertiary amine moiety-containing aniline derivative of the invention for which, in formula (1), Ar¹ is a group of the formula (B4) in which R⁵² is not a hydrogen atom or a group of the formula (B11) or Ar² is a group of formula (A13) or a group of formula (A16) in which R¹⁵⁵ (including R⁵² in formula (1-1)) is not a hydrogen atom, use may be made of a secondary amine moiety-containing aniline derivative of the invention which has formula (1) wherein Ar¹ is a group of the formula (B4) and R⁵² is a hydrogen atom or a group of formula (B10) or wherein Ar² is a group of formula (A12) or a group of formula (A16) in which R¹⁵⁵ (including R⁵² in formula (1-1)) is a hydrogen atom or of a secondary amine moiety-containing amine compound which has formula (3) wherein Ar¹ is a group of formula (B4) in which R⁵² is a hydrogen atom or a group of formula (B10).

Specifically, as shown below, the amine moiety in the secondary amine moiety-containing aniline derivative or amine compound is reacted with an aryl compound of formula (10) or a hydrocarbon compound of formula (11) or (12).

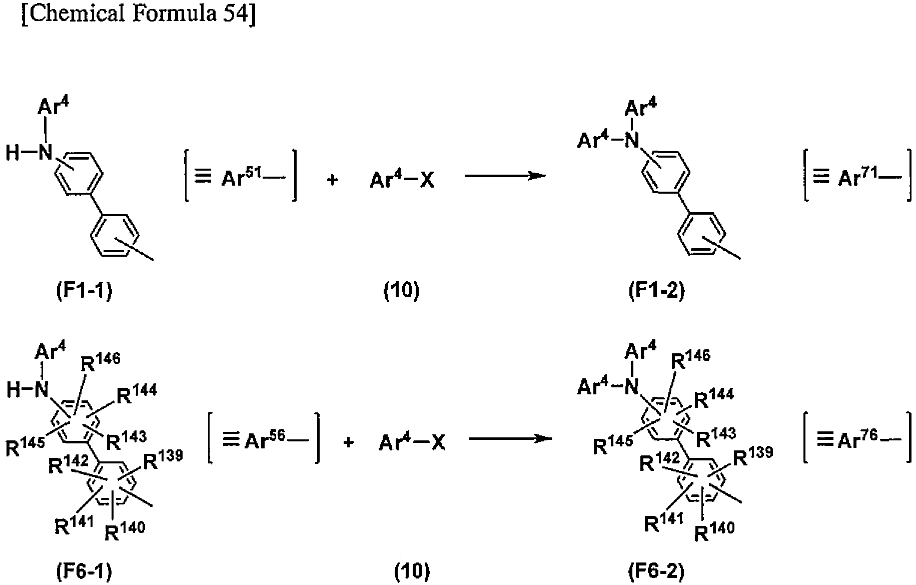

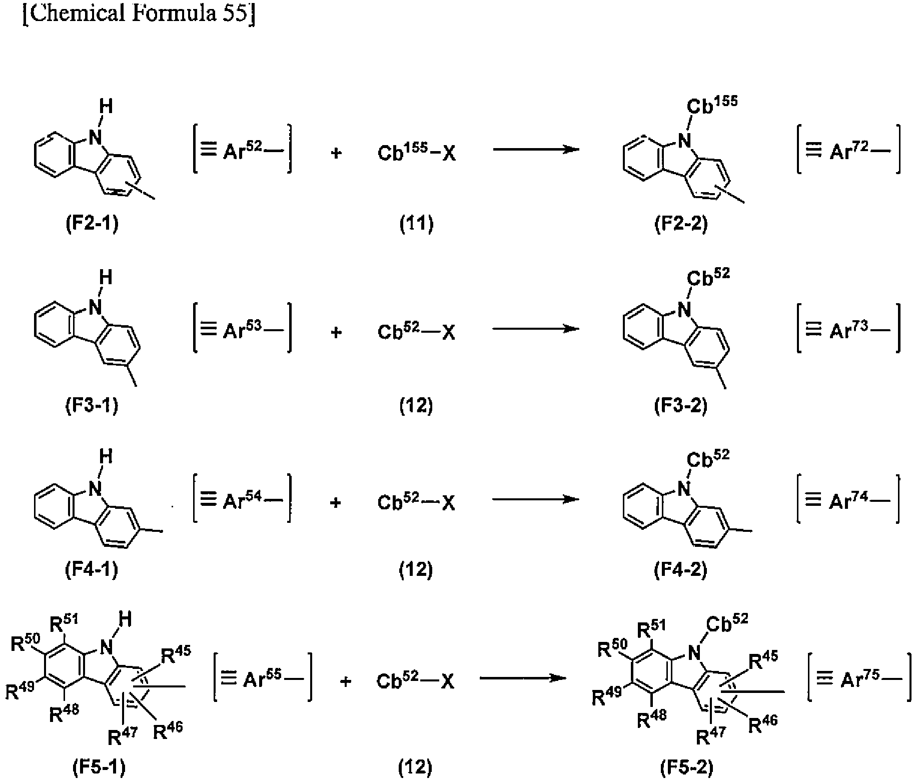

Here, X, R¹³⁹ to R¹⁴⁶, Ar⁴ and R⁴⁵ to R⁵¹ are as defined above. Cb¹⁵⁵ and Cb⁵² are each independently an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹. These alkyl, alkenyl, alkynyl, aryl and heteroaryl groups may be the same as those mentioned above. Z¹ and Z⁴ are as defined above.

Examples of the method of preparation using the above secondary amine moiety-containing aniline derivative or amine compound include, but are not limited to, those shown below.

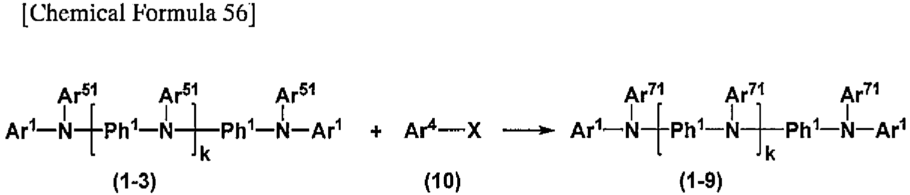

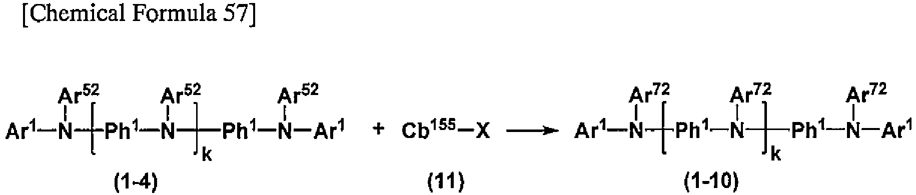

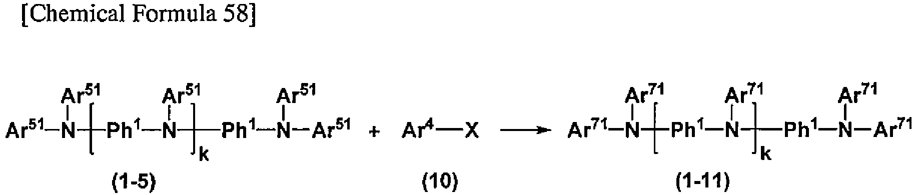

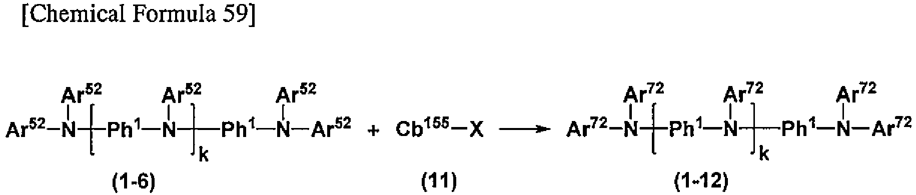

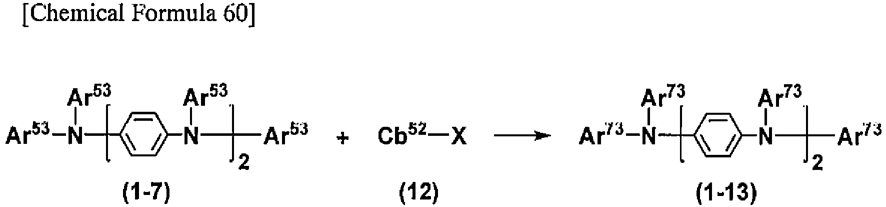

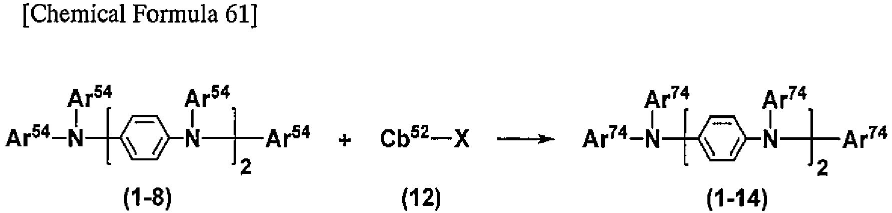

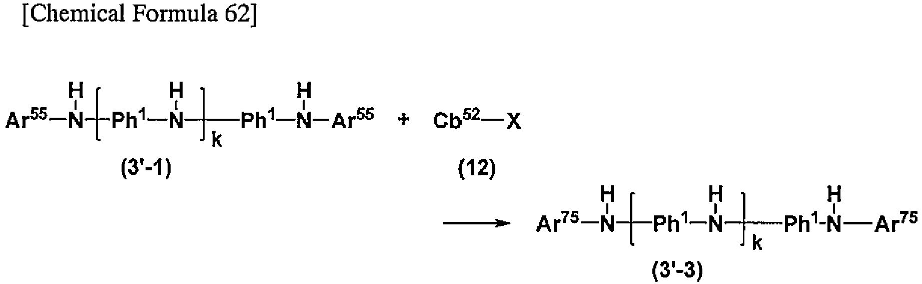

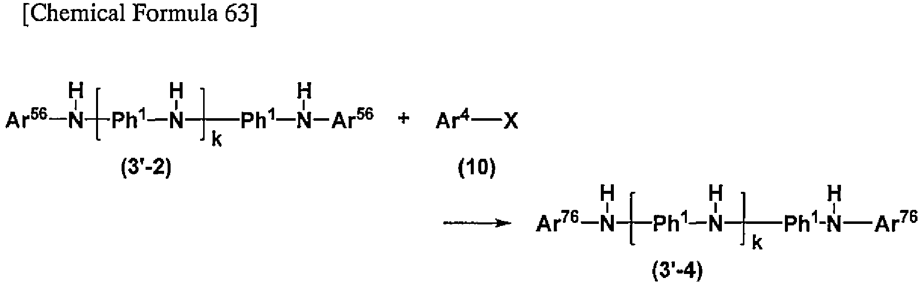

The charging ratio between the aniline derivative of formulas (1-3) to (1-8) and the aryl compound of formula (10) or hydrocarbon compound of formulas (11) and (12) may be set so as to make the amount of aryl compound or hydrocarbon compound at least 1 equivalent, and preferably about 1 to 1.2 equivalents, with respect to the molar amount of all NH groups on the aniline derivative.

The charging ratio between the amine compounds of formulas (3'-1) and (3'-2) and the aryl compound of formula (10) or hydrocarbon compound of formula (12), expressed in terms of the molar ratio, is preferably about 2 to 2.4 of the aryl compound of formula (10) or hydrocarbon compound of formula (12) with respect to unity (1) for the amine compounds of formulas (3'-1) and (3'-2).

Conditions other than the charging ratio are as follows.

When preparing aniline derivatives of formulas (1-9) to (1-14) or amine compounds of formulas (3'-3) and (3'-4) using the above-described catalysts of copper, palladium or the like, the conditions relating to the catalyst, ligand, solvent, reaction temperature and the like that are employed may be the above conditions described for the method of preparing the aniline derivative of formula (1).

When preparing an aniline derivative of any of formulas (1-9) to (1-14) or an amine compound of formula (3'-3) or (3'-4) by a substitution reaction which uses an aryl compound of formula (1), a hydrocarbon compound of formula (11) in which Cb¹⁵⁵ is an alkyl group of 1 to 20 carbon atoms that may be substituted with Z⁴ or an aryl group of 6 to 20 carbon atoms or heteroaryl group of 2 to 20 carbon atoms that may be substituted with Z¹ or a hydrocarbon compound of formula (12) in which Cb⁵² is an alkyl group of 1 to 20 carbon atoms that may be substituted with Z⁴ or an aryl group of 6 to 20 carbon atoms or heteroaryl group of 2 to 20 carbon atoms that may be substituted with Z¹, an aniline derivative of any of formulas (1-3) to (1-8) or an amine compound of formula (3'-1) or (3'-2) is reacted with a base in a solvent and the resulting product is reacted with the hydrocarbon compound of formula (11) or (12) or an aryl compound of formula (10).

Illustrative examples of the base include uncombined alkali metals, alkali metal hydroxides, alkali metal alkoxides, alkali metal carbonates and alkali metal bicarbonates such as lithium, sodium, potassium, lithium hydride, potassium hydroxide, sodium hydride, lithium tert-butoxide, sodium tert-t-butoxide, potassium tert-butoxide, lithium hydroxide, sodium hydroxide, potassium hydroxide, sodium carbonate, potassium carbonate, sodium bicarbonate and potassium bicarbonate; alkaline earth metal carbonates such as calcium carbonate; organolithium compounds such as n-butyllithium, s-butyllithium and t-butyllithium; and amines such as triethylamine, diisopropylethylamine, tetramethylethylenediamine, triethylenediamine and pyridine. However, any base that may be used in this type of reaction is acceptable without particular limitation. Because handling is easy, sodium hydride, sodium carbonate and potassium carbonate are especially preferred.

The amount of base used is about 1 to 1.2 equivalents with respect to the total NH groups in the aniline derivative of formulas (1-3) to (1-8), and is about 2 to 2.4 per mole of the amine compounds of formula (3'-1) and (3'-2).

The solvent is exemplified by the solvents mentioned above for the method of preparing the aniline derivative of formula (1). The reaction temperature, which should be suitably set in the range from the melting point to the boiling point of the solvent used, is from about 20°C to about 150°C.

Following reaction completion, workup such as separatory treatment, column chromatography, re-precipitation and recrystallization is carried out in the usual manner.

Although not a hard-and-fast rule on account of influences by the structure of the starting materials, the type of solvent used and the like, when X is a fluorine atom, a substitution reaction is preferred, and when X is an atom other than fluorine, a reaction that uses a catalyst is preferred.

The amine compound of formula (3) wherein the two Ar¹ groups are both groups of formula (B1) which may be used as the starting material in the method of preparing an aniline derivative of formula (1) above can be synthesized in accordance with the method of WO 2008/129947 or WO 2013/08466.

Illustrative examples of the aniline derivative of formula (1) or (2) include, but are not limited to, those shown below. In the tables, "Me" stands for a methyl group, "Et" stands for an ethyl group, "Prⁿ" stands for an n-propyl group, "Prⁱ" stands for an i-propyl group, "Buⁿ" stands for an n-butyl group, "Buⁱ" stands for an i-butyl group, "Bu^{s}" stands for an s-butyl group, "Bu^{t}" stands for a t-butyl group, "DPA" stands for a diphenylamino group, and "SBF" stands for a 9,9'-spirobi[9H-fluoren]-2-yl group.

**[Table 1]**

| | | | | | | | |
|---|---|---|---|---|---|---|---|
| 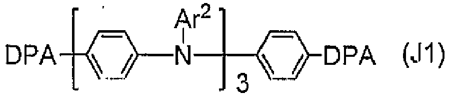 | | | | | | | |

| Compound | Ar² | Compound | Ar² | Compound | Ar² | Compound | Ar² |
|---|---|---|---|---|---|---|---|
| (J1-1) | (A1-1) | (J1-27) | (A6-11) | (J1-53) | (A12-7) | (J1-79) | (A13-22) |
| (J1-2) | (A1-2) | (J1-28) | (A6-12) | (J1-54) | (A12-8) | (J1-80) | (A13-23) |
| (J1-3) | (A2-1) | (J1-29) | (A6-13) | (J1-55) | (A12-9) | (J1-81) | (A13-24) |
| (J1-4) | (A2-2) | (J1-30) | (A6-14) | (J1-56) | (A12-10) | (J1-82) | (A14-1) |
| (J1-5) | (A2-3) | (J1-31) | (A6-15) | (J1-57) | (A12-11) | (J1-83) | (A14-2) |
| (J1-6) | (A2-4) | (J1-32) | (A7-1) | (J1-58) | (A13-1) | (J1-84) | (A14-3) |
| (J1-7) | (A2-5) | (J1-33) | (A7-2) | (J1-59) | (A13-2) | (J1-85) | (A14-4) |
| (J1-8) | (A3-1) | (J1-34) | (A7-3) | (J1-60) | (A13-3) | (J1-86) | (A15-1) |
| (J1-9) | (A3-2) | (J1-35) | (A8-1) | (J1-61) | (A13-4) | (J1-87) | (A15-2) |
| (J1-10) | (A3-3) | (J1-36) | (A8-2) | (J1-62) | (A13-5) | (J1-88) | (A15-3) |
| (J1-11) | (A4-1) | (J1-37) | (A8-3) | (J1-63) | (A13-6) | (J1-89) | (A15-4) |
| (J1-12) | (A4-2) | (J1-38) | (A9-1) | (J1-64) | (A13-7) | (J1-90) | (A17-1) |
| (J1-13) | (A4-3) | (J1-39) | (A9-2) | (J1-65) | (A13-8) | (J1-91) | (A17-2) |
| (J1-14) | (A5-1) | (J1-40) | (A9-3) | (J1-66) | (A13-9) | (J1-92) | (A17-3) |
| (J1-15) | (A5-2) | (J1-41) | (A10-1) | (J1-67) | (A13-10) | (J1-93) | (A17-4) |
| (J1-16) | (A5-3) | (J1-42) | (A10-2) | (J1-68) | (A13-11) | (J1-94) | (A17-5) |
| (J1-17) | (A6-1) | (J1-43) | (A10-3) | (J1-69) | (A13-12) | (J1-95) | (A17-6) |
| (J1-18) | (A6-2) | (J1-44) | (A11-1) | (J1-70) | (A13-13) | (J1-96) | (A17-7) |
| (J1-19) | (A6-3) | (J1-45) | (A11-2) | (J1-71) | (A13-14) | (J1-97) | (A17-8) |
| (J1-20) | (A6-4) | (J1-46) | (A11-3) | (J1-72) | (A13-15) | (J1-98) | (A17-9) |
| (J1-21) | (A6-5) | (J1-47) | (A12-1) | (J1-73) | (A13-16) | (J1-99) | (A17-10) |
| (J1-22) | (A6-6) | (J1-48) | (A12-2) | (J1-74) | (A13-17) | (J1-100) | (A17-11) |
| (J1-23) | (A6-7) | (J1-49) | (A12-3) | (J1-75) | (A13-18) | (J1-101) | (A17-12) |
| (J1-24) | (A6-8) | (J1-50) | (A12-4) | (J1-76) | (A13-19) | (J1-102) | (A18-1) |
| (J1-25) | (A6-9) | (J1-51) | (A12-5) | (J1-77) | (A13-20) | (J1-103) | (A18-2) |
| (J1-26) | (A6-10) | (J1-52) | (A12-6) | (J1-78) | (A13-21) | | |

**[Table 2]**

| | | | | | | | |
|---|---|---|---|---|---|---|---|
| 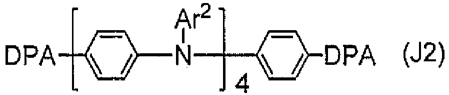 | | | | | | | |

| Compound | Ar² | Compound | Ar² | Compound | Ar² | Compound | Ar² |
|---|---|---|---|---|---|---|---|
| (J2-1) | (A1-1) | (J2-27) | (A6-11) | (J2-53) | (A12-7) | (J2-79) | (A13-22) |
| (J2-2) | (A1-2) | (J2-28) | (A6-12) | (J2-54) | (A12-8) | (J2-80) | (A13-23) |
| (J2-3) | (A2-1) | (J2-29) | (A6-13) | (J2-55) | (A12-9) | (J2-81) | (A13-24) |
| (J2-4) | (A2-2) | (J2-30) | (A6-14) | (J2-56) | (A12-10) | (J2-82) | (A14-1) |
| (J2-5) | (A2-3) | (J2-31) | (A6-15) | (J2-57) | (A12-11) | (J2-83) | (A14-2) |
| (J2-6) | (A2-4) | (J2-32) | (A7-1) | (J2-58) | (A13-1) | (J2-84) | (A14-3) |
| (J2-7) | (A2-5) | (J2-33) | (A7-2) | (J2-59) | (A13-2) | (J2-85) | (A14-4) |
| (J2-8) | (A3-1) | (J2-34) | (A7-3) | (J2-60) | (A13-3) | (J2-86) | (A15-1) |
| (J2-9) | (A3-2) | (J2-35) | (A8-1) | (J2-61) | (A13-4) | (J2-87) | (A15-2) |
| (J2-10) | (A3-3) | (J2-36) | (A8-2) | (J2-62) | (A13-5) | (J2-88) | (A15-3) |
| (J2-11) | (A4-1) | (J2-37) | (A8-3) | (J2-63) | (A13-6) | (J2-89) | (A15-4) |
| (J2-12) | (A4-2) | (J2-38) | (A9-1) | (J2-64) | (A13-7) | (J2-90) | (A17-1) |
| (J2-13) | (A4-3) | (J2-39) | (A9-2) | (J2-65) | (A13-8) | (J2-91) | (A17-2) |
| (J2-14) | (A5-1) | (J2-40) | (A9-3) | (J2-66) | (A13-9) | (J2-92) | (A17-3) |
| (J2-15) | (A5-2) | (J2-41) | (A10-1) | (J2-67) | (A13-10) | (J2-93) | (A17-4) |
| (J2-16) | (A5-3) | (J2-42) | (A10-2) | (J2-68) | (A13-11) | (J2-94) | (A17-5) |
| (J2-17) | (A6-1) | (J2-43) | (A10-3) | (J2-69) | (A13-12) | (J2-95) | (A17-6) |
| (J2-18) | (A6-2) | (J2-44) | (A11-1) | (J2-70) | (A13-13) | (J2-96) | (A17-7) |
| (J2-19) | (A6-3) | (J2-45) | (A11-2) | (J2-71) | (A13-14) | (J2-97) | (A17-8) |
| (J2-20) | (A6-4) | (J2-46) | (A11-3) | (J2-72) | (A13-15) | (J2-98) | (A17-9) |
| (J2-21) | (A6-5) | (J2-47) | (A12-1) | (J2-73) | (A13-16) | (J2-99) | (A17-10) |
| (J2-22) | (A6-6) | (J2-48) | (A12-2) | (J2-74) | (A13-17) | (J2-100) | (A17-11) |
| (J2-23) | (A6-7) | (J2-49) | (A12-3) | (J2-75) | (A13-18) | (J2-101) | (A17-12) |
| (J2-24) | (A6-8) | (J2-50) | (A12-4) | (J2-76) | (A13-19) | (J2-102) | (A18-1) |
| (J2-25) | (A6-9) | (J2-51) | (A12-5) | (J2-77) | (A13-20) | (J2-103) | (A18-2) |
| (J2-26) | (A6-10) | (J2-52) | (A12-6) | (J2-78) | (A13-21) | | |

**[Table 3]**

| | | | | | | | |
|---|---|---|---|---|---|---|---|
| 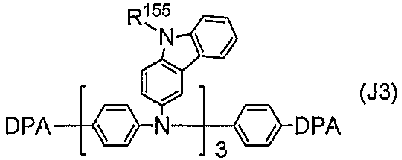 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J3-1) | (N1) | (J3-27) | (N27) | (J3-53) | (N53) | (J3-79) | -H |
| (J3-2) | (N2) | (J3-28) | (N28) | (J3-54) | (N54) | (J3-80) | -Me |
| (J3-3) | (N3) | (J3-29) | (N29) | (J3-55) | (N55) | (J3-81) | -Et |
| (J3-4) | (N4) | (J3-30) | (N30) | (J3-56) | (N56) | (J3-82) | -Prⁿ |
| (J3-5) | (N5) | (J3-31) | (N31) | (J3-57) | (N57) | (J3-83) | -Prⁱ |
| (J3-6) | (N6) | (J3-32) | (N32) | (J3-58) | (N58) | (J3-84) | -Buⁿ |
| (J3-7) | (N7) | (J3-33) | (N33) | (J3-59) | (N59) | (J3-85) | -Buⁱ |
| (J3-8) | (N8) | (J3-34) | (N34) | (J3-60) | (N60) | (J3-86) | -Bu^{s} |
| (J3-9) | (N9) | (J3-35) | (N35) | (J3-61) | (N61) | (J3-87) | -Bu^{t} |
| (J3-10) | (N10) | (J3-36) | (N36) | (J3-62) | (N62) | | |
| (J3-11) | (N11) | (J3-37) | (N37) | (J3-63) | (N63) | | |
| (J3-12) | (N12) | (J3-38) | (N38) | (J3-64) | (N64) | | |
| (J3-13) | (N13) | (J3-39) | (N39) | (J3-65) | (N65) | | |
| (J3-14) | (N14) | (J3-40) | (N40) | (J3-66) | (N66) | | |
| (J3-15) | (N15) | (J3-41) | (N41) | (J3-67) | (N67) | | |
| (J3-16) | (N16) | (J3-42) | (N42) | (J3-68) | (N68) | | |
| (J3-17) | (N17) | (J3-43) | (N43) | (J3-69) | (N69) | | |
| (J3-18) | (N18) | (J3-44) | (N44) | (J3-70) | (N70) | | |
| (J3-19) | (N19) | (J3-45) | (N45) | (J3-71) | (N71) | | |
| (J3-20) | (N20) | (J3-46) | (N46) | (J3-72) | (N72) | | |
| (J3-21) | (N21) | (J3-47) | (N47) | (J3-73) | (N73) | | |
| (J3-22) | (N22) | (J3-48) | (N48) | (J3-74) | (N74) | | |
| (J3-23) | (N23) | (J3-49) | (N49) | (J3-75) | (N75) | | |
| (J3-24) | (N24) | (J3-50) | (N50) | (J3-76) | (N76) | | |
| (J3-25) | (N25) | (J3-51) | (N51) | (J3-77) | (N77) | | |
| (J3-26) | (N26) | (J3-52) | (N52) | (J3-78) | (N78) | | |

**[Table 4]**

| | | | | | | | |
|---|---|---|---|---|---|---|---|
| 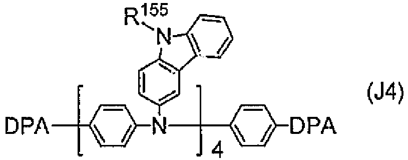 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J4-1) | (N1) | (J4-27) | (N27) | (J4-53) | (N53) | (J4-79) | -H |
| (J4-2) | (N2) | (J4-28) | (N28) | (J4-54) | (N54) | (J4-80) | -Me |
| (J4-3) | (N3) | (J4-29) | (N29) | (J4-55) | (N55) | (J4-81) | -Et |
| (J4-4) | (N4) | (J4-30) | (N30) | (J4-56) | (N56) | (J4-82) | -Prⁿ |
| (J4-5) | (N5) | (J4-31) | (N31) | (J4-57) | (N57) | (J4-83) | -Prⁱ |
| (J4-6) | (N6) | (J4-32) | (N32) | (J4-58) | (N58) | (J4-84) | -Buⁿ |
| (J4-7) | (N7) | (J4-33) | (N33) | (J4-59) | (N59) | (J4-85) | -Buⁱ |
| (J4-8) | (N8) | (J4-34) | (N34) | (J4-60) | (N60) | (J4-86) | -Bu^{s} |
| (J4-9) | (N9) | (J4-35) | (N35) | (J4-61) | (N61) | (J4-87) | -Bu^{t} |
| (J4-10) | (N10) | (J4-36) | (N36) | (J4-62) | (N62) | | |
| (J4-11) | (N11) | (J4-37) | (N37) | (J4-63) | (N63) | | |
| (J4-12) | (N12) | (J4-38) | (N38) | (J4-64) | (N64) | | |
| (J4-13) | (N13) | (J4-39) | (N39) | (J4-65) | (N65) | | |
| (J4-14) | (N14) | (J4-40) | (N40) | (J4-66) | (N66) | | |
| (J4-15) | (N15) | (J4-41) | (N41) | (J4-67) | (N67) | | |
| (J4-16) | (N16) | (J4-42) | (N42) | (J4-68) | (N68) | | |
| (J4-17) | (N17) | (J4-43) | (N43) | (J4-69) | (N69) | | |
| (J4-18) | (N18) | (J4-44) | (N44) | (J4-70) | (N70) | | |
| (J4-19) | (N19) | (J4-45) | (N45) | (J4-71) | (N71) | | |
| (J4-20) | (N20) | (J4-46) | (N46) | (J4-72) | (N72) | | |
| (J4-21) | (N21) | (J4-47) | (N47) | (J4-73) | (N73) | | |
| (J4-22) | (N22) | (J4-48) | (N48) | (J4-74) | (N74) | | |
| (J4-23) | (N23) | (J4-49) | (N49) | (J4-75) | (N75) | | |
| (J4-24) | (N24) | (J4-50) | (N50) | (J4-76) | (N76) | | |
| (J4-25) | (N25) | (J4-51) | (N51) | (J4-77) | (N77) | | |
| (J4-26) | (N26) | (J4-52) | (N52) | (J4-78) | (N78) | | |

**[Table 5]**

| | | | | | | | |
|---|---|---|---|---|---|---|---|
| 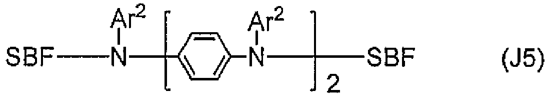 | | | | | | | |

| Compound | Ar² | Compound | Ar² | Compound | Ar² | Compound | Ar² |
|---|---|---|---|---|---|---|---|
| (J5-1) | (A1-1) | (J5-27) | (A6-11) | (J5-53) | (A12-7) | (J5-79) | (A13-22) |
| (J5-2) | (A1-2) | (J5-28) | (A6-12) | (J5-54) | (A12-8) | (J5-80) | (A13-23) |
| (J5-3) | (A2-1) | (J5-29) | (A6-13) | (J5-55) | (A12-9) | (J5-81) | (A13-24) |
| (J5-4) | (A2-2) | (J5-30) | (A6-14) | (J5-56) | (A12-10) | (J5-82) | (A14-1) |
| (J5-5) | (A2-3) | (J5-31) | (A6-15) | (J5-57) | (A12-11) | (J5-83) | (A14-2) |
| (J5-6) | (A2-4) | (J5-32) | (A7-1) | (J5-58) | (A13-1) | (J5-84) | (A14-3) |
| (J5-7) | (A2-5) | (J5-33) | (A7-2) | (J5-59) | (A13-2) | (J5-85) | (A14-4) |
| (J5-8) | (A3-1) | (J5-34) | (A7-3) | (J5-60) | (A13-3) | (J5-86) | (A15-1) |
| (J5-9) | (A3-2) | (J5-35) | (A8-1) | (J5-61) | (A13-4) | (J5-87) | (A15-2) |
| (J5-10) | (A3-3) | (J5-36) | (A8-2) | (J5-62) | (A13-5) | (J5-88) | (A15-3) |
| (J5-11) | (A4-1) | (J5-37) | (A8-3) | (J5-63) | (A13-6) | (J5-89) | (A15-4) |
| (J5-12) | (A4-2) | (J5-38) | (A9-1) | (J5-64) | (A13-7) | (J5-90) | (A17-1) |
| (J5-13) | (A4-3) | (J5-39) | (A9-2) | (J5-65) | (A13-8) | (J5-91) | (A17-2) |
| (J5-14) | (A5-1) | (J5-40) | (A9-3) | (J5-66) | (A13-9) | (J5-92) | (A17-3) |
| (J5-15) | (A5-2) | (J5-41) | (A10-1) | (J5-67) | (A13-10) | (J5-93) | (A17-4) |
| (J5-16) | (A5-3) | (J5-42) | (A10-2) | (J5-68) | (A13-11) | (J5-94) | (A17-5) |
| (J5-17) | (A6-1) | (J5-43) | (A10-3) | (J5-69) | (A13-12) | (J5-95) | (A17-6) |
| (J5-18) | (A6-2) | (J5-44) | (A11-1) | (J5-70) | (A13-13) | (J5-96) | (A17-7) |
| (J5-19) | (A6-3) | (J5-45) | (A11-2) | (J5-71) | (A13-14) | (J5-97) | (A17-8) |
| (J5-20) | (A6-4) | (J5-46) | (A11-3) | (J5-72) | (A 13-15) | (J5-98) | (A17-9) |
| (J5-21) | (A6-5) | (J5-47) | (A12-1) | (J5-73) | (A13-16) | (J5-99) | (A17-10) |
| (J5-22) | (A6-6) | (J5-48) | (A12-2) | (J5-74) | (A13-17) | (J5-100) | (A17-11) |
| (J5-23) | (A6-7) | (J5-49) | (A12-3) | (J5-75) | (A13-18) | (J5-101) | (A17-12) |
| (J5-24) | (A6-8) | (J5-50) | (A12-4) | (J5-76) | (A13-19) | (J5-102) | (A18-1) |
| (J5-25) | (A6-9) | (J5-51) | (A12-5) | (J5-77) | (A13-20) | (J5-103) | (A18-2) |
| (J5-26) | (A6-10) | (J5-52) | (A12-6) | (J5-78) | (A13-21) | | |

**[Table 6]**

| | | | | | | | |
|---|---|---|---|---|---|---|---|
| 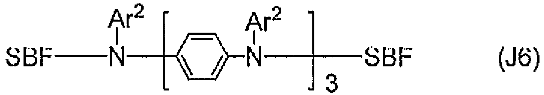 | | | | | | | |

| Compound | Ar² | Compound | Ar² | Compound | Ar² | Compound | Ar² |
|---|---|---|---|---|---|---|---|
| (J6-1) | (A1-1) | (J6-27) | (A6-11) | (J6-53) | (A12-7) | (J6-79) | (A13-22) |
| (J6-2) | (A1-2) | (J6-28) | (A6-12) | (J6-54) | (A12-8) | (J6-80) | (A13-23) |
| (J6-3) | (A2-1) | (J6-29) | (A6-13) | (J6-55) | (A12-9) | (J6-81) | (A13-24) |
| (J6-4) | (A2-2) | (J6-30) | (A6-14) | (J6-56) | (A12-10) | (J6-82) | (A14-1) |
| (J6-5) | (A2-3) | (J6-31) | (A6-15) | (J6-57) | (A12-11) | (J6-83) | (A14-2) |
| (J6-6) | (A2-4) | (J6-32) | (A7-1) | (J6-58) | (A13-1) | (J6-84) | (A14-3) |
| (J6-7) | (A2-5) | (J6-33) | (A7-2) | (J6-59) | (A13-2) | (J6-85) | (A14-4) |
| (J6-8) | (A3-1) | (J6-34) | (A7-3) | (J6-60) | (A13-3) | (J6-86) | (A15-1) |
| (J6-9) | (A3-2) | (J6-35) | (A8-1) | (J6-61) | (A13-4) | (J6-87) | (A15-2) |
| (J6-10) | (A3-3) | (J6-36) | (A8-2) | (J6-62) | (A13-5) | (J6-88) | (A15-3) |
| (J6-11) | (A4-1) | (J6-37) | (A8-3) | (J6-63) | (A13-6) | (J6-89) | (A15-4) |
| (J6-12) | (A4-2) | (J6-38) | (A9-1) | (J6-64) | (A13-7) | (J6-90) | (A17-1) |
| (J6-13) | (A4-3) | (J6-39) | (A9-2) | (J6-65) | (A13-8) | (J6-91) | (A17-2) |
| (J6-14) | (A5-1) | (J6-40) | (A9-3) | (J6-66) | (A13-9) | (J6-92) | (A17-3) |
| (J6-15) | (A5-2) | (J6-41) | (A10-1) | (J6-67) | (A13-10) | (J6-93) | (A17-4) |
| (J6-16) | (A5-3) | (J6-42) | (A10-2) | (J6-68) | (A13-11) | (J6-94) | (A17-5) |
| (J6-17) | (A6-1) | (J6-43) | (A10-3) | (J6-69) | (A13-12) | (J6-95) | (A17-6) |
| (J6-18) | (A6-2) | (J6-44) | (A11-1) | (J6-70) | (A13-13) | (J6-96) | (A17-7) |
| (J6-19) | (A6-3) | (J6-45) | (A11-2) | (J6-71) | (A13-14) | (J6-97) | (A17-8) |
| (J6-20) | (A6-4) | (J6-46) | (A11-3) | (J6-72) | (A13-15) | (J6-98) | (A17-9) |
| (J6-21) | (A6-5) | (J6-47) | (A12-1) | (J6-73) | (A13-16) | (J6-99) | (A17-10) |
| (J6-22) | (A6-6) | (J6-48) | (A12-2) | (J6-74) | (A13-17) | (J6-100) | (A17-11) |
| (J6-23) | (A6-7) | (J6-49) | (A12-3) | (J6-75) | (A13-18) | (J6-101) | (A17-12) |
| (J6-24) | (A6-8) | (J6-50) | (A 12-4) | (J6-76) | (A13-19) | (J6-102) | (A18-1) |
| (J6-25) | (A6-9) | (J6-51) | (A12-5) | (J6-77) | (A13-20) | (J6-103) | (A18-2) |
| (J6-26) | (A6-10) | (J6-52) | (A12-6) | (J6-78) | (A13-21) | | |

**[Table 7]**

| | | | | | | | |
|---|---|---|---|---|---|---|---|
| 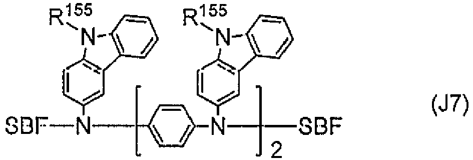 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J7-1) | (N1) | (J7-27) | (N27) | (J7-53) | (N53) | (J7-79) | -H |
| (J7-2) | (N2) | (J7-28) | (N28) | (J7⁻54) | (N54) | (J7-80) | -Me |
| (J7-3) | (N3) | (J7-29) | (N29) | (J7-55) | (N55) | (J7-81) | -Et |
| (J7-4) | (N4) | (J7-30) | (N30) | (J7-56) | (N56) | (J7-82) | -Prⁿ |
| (J7-5) | (N5) | (J7-31) | (N31) | (J7-57) | (N57) | (J7-83) | -Prⁱ |
| (J7-6) | (N6) | (J7-32) | (N32) | (J7-58) | (N58) | (J7-84) | -Buⁿ |
| (J7-7) | (N7) | (J7-33) | (N33) | (J7-59) | (N59) | (J7-85) | -Bu^{l} |
| (J7-8) | (N8) | (J7-34) | (N34) | (J7-60) | (N60) | (J7-86) | -Bu^{s} |
| (J7-9) | (N9) | (J7-35) | (N35) | (J7-61) | (N61) | (J7-87) | -Bu^{t} |
| (J7-10) | (N10) | (J7-36) | (N36) | (J7-62) | (N62) | | |
| (J7-11) | (N11) | (J7-37) | (N37) | (J7-63) | (N63) | | |
| (J7-12) | (N12) | (J7-38) | (N38) | (J7-64) | (N64) | | |
| (J7-13) | (N13) | (J7-39) | (N39) | (J7-65) | (N65) | | |
| (J7-14) | (N14) | (J7-40) | (N40) | (J7-66) | (N66) | | |
| (J7-15) | (N15) | (J7-41) | (N41) | (J7-67) | (N67) | | |
| (J7-16) | (N16) | (J7-42) | (N42) | (J7-68) | (N68) | | |
| (J7-17) | (N17) | (J7-43) | (N43) | (J7-69) | (N69) | | |
| (07-18) | (N18) | (J7-44) | (N44) | (J7-70) | (N70) | | |
| (J7-19) | (N19) | (J7-45) | (N45) | (J7-71) | (N71) | | |
| (J7-20) | (N20) | (J7-46) | (N46) | (J7-72) | (N72) | | |
| (J7-21) | (N21) | (J7-47) | (N47) | (J7-73) | (N73) | | |
| (J7-22) | (N22) | (J7-48) | (N48) | (J7-74) | (N74) | | |
| (J7-23) | (N23) | (J7-49) | (N49) | (J7-75) | (N75) | | |
| (J7-24) | (N24) | (J7-50) | (N50) | (J7-76) | (N76) | | |
| (J7-25) | (N25) | (J7-51) | (N51) | (J7-77) | (N77) | | |
| (J7-26) | (N26) | (J7-52) | (N52) | (J7-78) | (N78) | | |

**[Table 8]**

| | | | | | | | |
|---|---|---|---|---|---|---|---|
| 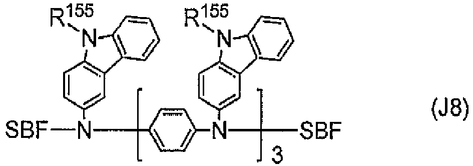 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J8-1) | (N1) | (J8-27) | (N27) | (J8-53) | (N53) | (J8-79) | -H |
| (J8-2) | (N2) | (J8-28) | (N28) | (J8-54) | (N54) | (J8-80) | -Me |
| (J8-3) | (N3) | (J8-29) | (N29) | (J8-55) | (N55) | (J8-81) | -Et |
| (J8-4) | (N4) | (J8-30) | (N30) | (J8-56) | (N56) | (J8-82) | -Prⁿ |
| (J8-5) | (N5) | (J8-31) | (N31) | (J8-57) | (N57) | (J8-83) | -Pr^{l} |
| (J8-6) | (N6) | (J8-32) | (N32) | (J8-58) | (N58) | (J8-84) | -Buⁿ |
| (J8-7) | (N7) | (J8-33) | (N33) | (J8-59) | (N59) | (J8-85) | -Buⁱ |
| (J8-8) | (N8) | (J8-34) | (N34) | (J8-60) | (N60) | (J8-86) | -Bu^{s} |
| (J8-9) | (N9) | (J8-35) | (N35) | (J8-61) | (N61) | (J8-87) | -Bu^{t} |
| (J8-10) | (N10) | (J8-36) | (N36) | (J8-62) | (N62) | | |
| (J8-11) | (N11) | (J8-37) | (N37) | (J8-63) | (N63) | | |
| (J8-12) | (N12) | (J8-38) | (N38) | (J8-64) | (N64) | | |
| (J8-13) | (N13) | (J8-39) | (N39) | (J8-65) | (N65) | | |
| (J8-14) | (N14) | (J8-40) | (N40) | (J8-66) | (N66) | | |
| (J8-15) | (N15) | (J8-41) | (N41) | (J8-67) | (N67) | | |
| (J8-16) | (N16) | (J8-42) | (N42) | (J8-68) | (N68) | | |
| (J8-17) | (N17) | (J8-43) | (N43) | (J8-69) | (N69) | | |
| (J8-18) | (N18) | (J8-44) | (N44) | (J8-70) | (N70) | | |
| (J8-19) | (N19) | (J8-45) | (N45) | (J8-71) | (N71) | | |
| (J8-20) | (N20) | (J8-46) | (N46) | (J8-72) | (N72) | | |
| (J8-21) | (N21) | (J8-47) | (N47) | (J8-73) | (N73) | | |
| (J8-22) | (N22) | (J8-48) | (N48) | (J8-74) | (N74) | | |
| (J8-23) | (N23) | (J8-49) | (N49) | (J8-75) | (N75) | | |
| (J8-24) | (N24) | (J8-54) | (N50) | (J8-76) | (N76) | | |
| (J8-25) | (N25) | (J8-51) | (N51) | (J8-77) | (N77) | | |
| (J8-26) | (N26) | (J8-52) | (N52) | (J8-78) | (N78) | | |

**[Table 9]**

| | | | | | | | |
|---|---|---|---|---|---|---|---|
| 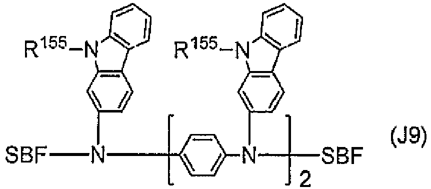 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J9-1) | (N1) | (J9-27) | (N27) | (J9-53) | (N53) | (J9-79) | -H |
| (J9-2) | (N2) | (J9-28) | (N28) | (J9-54) | (N54) | (J9-80) | -Me |
| (J9-3) | (N3) | (J9-29) | (N29) | (J9-55) | (N55) | (J9-81) | -Et |
| (J0-4) | (N4) | (J0-30) | (N30) | (J9-56) | (N56) | (J9-82) | -Prⁿ |
| (J9-5) | (N5) | (J9-31) | (N31) | (J9-57) | (N57) | (J9-83) | -Prⁱ |
| (J9-6) | (N6) | (J9-32) | (N32) | (J9-58) | (N58) | (J9-84) | -Buⁿ |
| (J9-7) | (N7) | (J9-33) | (N33) | (J9-59) | (N59) | (J9-85) | -Buⁱ |
| (J9-8) | (N8) | (J9-34) | (N34) | (J9-60) | (N60) | (J9-86) | -Bu^{s} |
| (J9-9) | (N9) | (J9-35) | (N35) | (J9-61) | (N61) | (J9-87) | -Bu^{t} |
| (J9-10) | (N10) | (J9-36) | (N36) | (J9-62) | (N62) | | |
| (J9-11) | (N11) | (J9-37) | (N37) | (J9-63) | (N63) | | |
| (J9-12) | (N12) | (J9-38) | (N38) | (J9-64) | (N64) | | |
| (J9-13) | (N13) | (J9-39) | (N39) | (J9-65) | (N65) | | |
| (J9-14) | (N14) | (J9-40) | (N40) | (J9-66) | (N66) | | |
| (J9-15) | (N15) | (J9-41) | (N41) | (J9-67) | (N67) | | |
| (J9-16) | (N16) | (J9-42) | (N42) | (J9-68) | (N68) | | |
| (J9-17) | (N17) | (J9-43) | (N43) | (J9-69) | (N69) | | |
| (J9-18) | (N18) | (J9-44) | (N44) | (J9-70) | (N70) | | |
| (J9-19) | (N19) | (J9-45) | (N45) | (J9-71) | (N71) | | |
| (J9-20) | (N20) | (J9-46) | (N46) | (J9-72) | (N72) | | |
| (J9-21) | (N21) | (J9-47) | (N47) | (J9-73) | (N73) | | |
| (J9-22) | (N22) | (J9-48) | (N48) | (J9-74) | (N74) | | |
| (J9-23) | (N23) | (J9-49) | (N49) | (J9-75) | (N75) | | |
| (J9-24) | (N24) | (J9-50) | (N50) | (J9-76) | (N76) | | |
| (J9-25) | (N25) | (J9-51) | (N51) | (J9-77) | (N77) | | |
| (J9-26) | (N26) | (J9-52) | (N52) | (J9-78) | (N78) | | |

**[Table 10]**

| | | | | | | | |
|---|---|---|---|---|---|---|---|
| 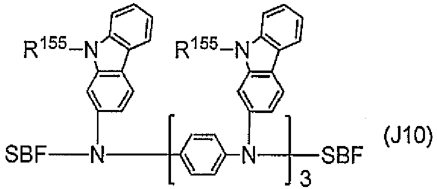 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J10-1) | (N1) | (J10-27) | (N27) | (J10-53) | (N53) | (J10-79) | -H |
| (J10-2) | (N2) | (J10-28) | (N28) | (J10-54) | (N54) | (J10-80) | -Me |
| (J10-3) | (N3) | (J10-29) | (N29) | (J10-55) | (N55) | (J10-81) | -Et |
| (J10-4) | (N4) | (J10-30) | (N30) | (J10-50) | (N56) | (J10-82) | -Prⁿ |
| (J10-5) | (N5) | (J10-31) | (N31) | (J10-57) | (N57) | (J10-83) | -Prⁱ |
| (J10-6) | (N6) | (J10-32) | (N32) | (J10-58) | (N58) | (J10-84) | -Buⁿ |
| (J10-7) | (N7) | (J10-33) | (N33) | (J10-59) | (N59) | (J10-85) | -Buⁱ |
| (J10-8) | (N8) | (J10-34) | (N34) | (J10-60) | (N60) | (J10-86) | -Bu^{s} |
| (J10-9) | (N9) | (J10-35) | (N35) | (J10-61) | (N61) | (J10-87) | -Bu^{t} |
| (J10-10) | (N10) | (J10-36) | (N36) | (J10-62) | (N62) | | |
| (J10-11) | (N11) | (J10-37) | (N37) | (J10-63) | (N63) | | |
| (J10-12) | (N12) | (J10-38) | (N38) | (J10-64) | (N64) | | |
| (J10-13) | (N13) | (J10-39) | (N39) | (J10-65) | (N65) | | |
| (J10-14) | (N14) | (J10-40) | (N40) | (J10-66) | (N66) | | |
| (J10-15) | (N15) | (J10-41) | (N41) | (J10-67) | (N67) | | |
| (J10-16) | (N16) | (J10-42) | (N42) | (J10-68) | (N68) | | |
| (J10-17) | (N17) | (J10-43) | (N43) | (J10-69) | (N69) | | |
| (J10-18) | (N18) | (J10-44) | (N44) | (J10-70) | (N70) | | |
| (J10-19) | (N19) | (J10-45) | (N45) | (J10-71) | (N71) | | |
| (J10-20) | (N20) | (J10-46) | (N46) | (J10-72) | (N72) | | |
| (J10-21) | (N21) | (J10-47) | (N47) | (J10-73) | (N73) | | |
| (J10-22) | (N22) | (J10-48) | (N48) | (J10-74) | (N74) | | |
| (J10-23) | (N23) | (J10-49) | (N49) | (J10-75) | (N75) | | |
| (J10-24) | (N24) | (J10-50) | (N50) | (J10-76) | (N76) | | |
| (J10-25) | (N25) | (J10-51) | (N51) | (J10-77) | (N77) | | |
| (J10-26) | (N26) | (J10-52) | (N52) | (J10-78) | (N78) | | |

**[Table 11]**

| | | | | | | | |
|---|---|---|---|---|---|---|---|
| 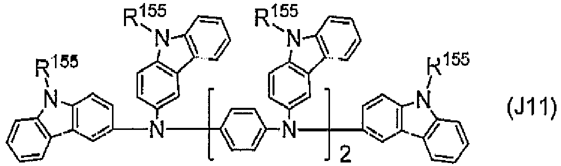 | | | | | | | |

| Compound | R¹⁵⁵ | Compound | R¹¹⁵ | Compound | R¹⁵⁵ | Compound | R¹⁵⁵ |
|---|---|---|---|---|---|---|---|
| (J11-1) | (N1) | (J11-27) | (N27) | (J11-53) | (N53) | (J11-79) | -H |
| (J11-2) | (N2) | (J11-28) | (N28) | (J11-54) | (N54) | (J11-80) | -Me |
| (J11-3) | (N3) | (J11-29) | (N29) | (J11-55) | (N55) | (J11-81) | -Et |
| (J11-4) | (N4) | (J11-30) | (N30) | (J11-56) | (N56) | (J11-82) | -Prⁿ |
| (J11-5) | (N5) | (J11-31) | (N31) | (J11-57) | (N57) | (J11-83) | -Prⁱ |
| (J11-6) | (N6) | (J11-32) | (N32) | (J11-58) | (N58) | (J11-84) | -Buⁿ |
| (J11-7) | (N7) | (J11-33) | (N33) | (J11-59) | (N59) | (J11-85) | -Buⁱ |
| (J11-8) | (N8) | (J11-34) | (N34) | (J11-60) | (N60) | (J11-86) | -Bu^{s} |
| (J11-9) | (N9) | (J11-35) | (N35) | (J11-61) | (N61) | (J11-87) | -Bu^{t} |
| (J11-10) | (N10) | (J11-36) | (N36) | (J11-62) | (N62) | | |
| (J11-11) | (N11) | (J11-37) | (N37) | (J11-63) | (N63) | | |
| (J11-12) | (N12) | (J11-38) | (N38) | (J11-64) | (N64) | | |
| (J11-13) | (N13) | (J11-39) | (N39) | (J11-65) | (N65) | | |
| (J11-14) | (N14) | (J11-40) | (N40) | (J11-66) | (N66) | | |
| (J11-15) | (N15) | (J11-41) | (N41) | (J11-67) | (N67) | | |
| (J11-16) | (N16) | (J11-42) | (N42) | (J11-68) | (N68) | | |
| (J11-17) | (N17) | (J11-43) | (N43) | (J11-69) | (N69) | | |
| (J11-18) | (N18) | (J11-44) | (N44) | (J11-70) | (N70) | | |
| (J11-19) | (N19) | (J11-45) | (N45) | (J11-71) | (N71) | | |
| (J11-20) | (N20) | (J11-46) | (N46) | (J11-72) | (N72) | | |
| (J11-21) | (N21) | (J11-47) | (N47) | (J11-73) | (N73) | | |
| (J11-22) | (N22) | (J11-48) | (N48) | (J11-74) | (N74) | | |
| (J11-23) | (N23) | (J11-49) | (N49) | (J11-75) | (N75) | | |
| (J11-24) | (N24) | (J11-50) | (N50) | (J11-76) | (N76) | | |
| (J11-25) | (N25) | (J11-51) | (N51) | (J11-77) | (N77) | | |
| (J11-26) | (N26) | (J11-52) | (N52) | (J11-78) | (N78) | | |

**[Table 12]**

| | | | | | | | |
|---|---|---|---|---|---|---|---|
| 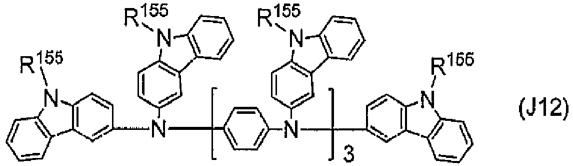 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J12-1) | (N1) | (J12-27) | (N27) | (J12-53) | (N53) | (J12-79) | -H |
| (J12⁻2) | (N2) | (J12-28) | (N28) | (J12-54) | (N54) | (J12-80) | -Me |
| (J12-3) | (N3) | (J12-29) | (N29) | (J12-55) | (N55) | (J12-81) | -Et |
| (J12-4) | (N4) | (J12-30) | (N30) | (J12-56) | (N56) | (J12-82) | -Prⁿ |
| (J12-5) | (N5) | (J12-31) | (N31) | (J12-57) | (N57) | (J12-83) | -Pr^{l} |
| (J12-6) | (N6) | (J12-32) | (N32) | (J12-58) | (N58) | (J12-84) | -Buⁿ |
| (J12-7) | (N7) | (J12-33) | (N33) | (J12-59) | (N59) | (J12-85) | -Bu^{l} |
| (J12-8) | (N8) | (J12-34) | (N34) | (J12-60) | (N60) | (J12-86) | -Bu^{s} |
| (J12-9) | (N9) | (J12-35) | (N35) | (J12-61) | (N61) | (J12-87) | -Bu^{t} |
| (J12-10) | (N10) | (J12-36) | (N36) | (J12-62) | (N62) | | |
| (J12-11) | (N11) | (J12-37) | (N37) | (J12-63) | (N63) | | |
| (J12-12) | (N12) | (J12-38) | (N38) | (J12-64) | (N64) | | |
| (J12-13) | (N13) | (J12-39) | (N39) | (J12-65) | (N65) | | |
| (J12-14) | (N14) | (J12-40) | (N40) | (J12-66) | (N66) | | |
| (J12-15) | (N15) | (J12-41) | (N41) | (J12-67) | (N67) | | |
| (J12-16) | (N16) | (J12-42) | (N42) | (J12-68) | (N68) | | |
| (J12-17) | (N17) | (J12-43) | (N43) | (J12-69) | (N69) | | |
| (J12-18) | (N18) | (J12-44) | (N44) | (J12-70) | (N70) | | |
| (J12-19) | (N19) | (J12-45) | (N45) | (J12-71) | (N71) | | |
| (J12-20) | (N20) | (J12-46) | (N46) | (J12-72) | (N72) | | |
| (J12-21) | (N21) | (J12-47) | (N47) | (J12-73) | (N73) | | |
| (J12-22) | (N22) | (J12-48) | (N48) | (J12-74) | (N74) | | |
| (J12-23) | (N23) | (J12-49) | (N49) | (J12-75) | (N75) | | |
| (J12-24) | (N24) | (J12-50) | (N50) | (J12-76) | (N76) | | |
| (J12-25) | (N25) | (J12-51) | (N51) | (J12-77) | (N77) | | |
| (J12-26) | (N26) | (J12-52) | (N52) | (J12-78) | (N78) | | |

**[Table 13]**

| | | | | | | | |
|---|---|---|---|---|---|---|---|
| 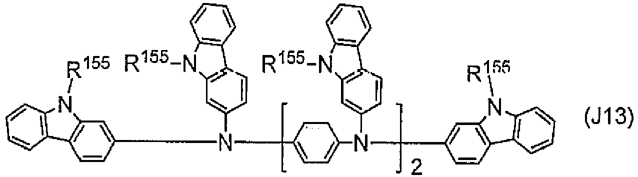 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J13-1) | (N1) | (J 13-27) | (N27) | (J13-53) | (N53) | (J13-79) | -H |
| (J13-2) | (N2) | (J13-28) | (N28) | (J13-54) | (N54) | (J13-80) | -Me |
| (J13-3) | (N3) | (J13-29) | (N29) | (J13-55) | (N55) | (J13-81) | -Et |
| (J13 4) | (N4) | (J13-30) | (N30) | (J13-56) | (N56) | (J13-82) | -Prⁿ |
| (J13-5) | (N5) | (J13-31) | (N31) | (J13-57) | (N57) | (J13-83) | -Pr^{l} |
| (J13-6) | (N6) | (J13-32) | (N32) | (J13-58) | (N58) | (J13-84) | -Buⁿ |
| (J13-7) | (N7) | (J13-33) | (N33) | (J13⁻59) | (N59) | (J13-85) | -Bu^{l} |
| (J13-8) | (N8) | (J13-34) | (N34) | (J13-60) | (N60) | (J13-86) | -Bu^{s} |
| (J13-9) | (N9) | (J13-35) | (N35) | (J13-61) | (N61) | (J13-87) | -Bu^{t} |
| (J13-10) | (N10) | (J13-36) | (N36) | (J13-62) | (N62) | | |
| (J13-11) | (N11) | (J13-37) | (N37) | (J13-63) | (N63) | | |
| (J13-12) | (N12) | (J13-38) | (N38) | (J13-64) | (N64) | | |
| (J13-13) | (N13) | (J13-39) | (N39) | (J13-65) | (N65) | | |
| (J13-14) | (N14) | (J13-40) | (N40) | (J13-66) | (N66) | | |
| (J13-15) | (N15) | (J13-41) | (N41) | (J13-67) | (N67) | | |
| (J13-16) | (N16) | (J13-42) | (N42) | (J13-68) | (N68) | | |
| (J13-17) | (N17) | (J13-43) | (N43) | (J13-69) | (N69) | | |
| (J13-18) | (N18) | (J13-44) | (N44) | (J13-70) | (N70) | | |
| (J13-19) | (N19) | (J13-45) | (N45) | (J13-71) | (N71) | | |
| (J13-20) | (N20) | (J13-46) | (N46) | (J13-72) | (N72) | | |
| (J13-21) | (N21) | (J13-47) | (N47) | (J13-73) | (N73) | | |
| (J13-22) | (N22) | (J13-48) | (N48) | (J13-74) | (N74) | | |
| (J13-23) | (N23) | (J13-49) | (N49) | (J13-75) | (N75) | | |
| (J13-24) | (N24) | (J13-50) | (N50) | (J13-76) | (N76) | | |
| (J13-25) | (N25) | (J13-51) | (N51) | (J13-77) | (N77) | | |
| (J13-26) | (N26) | (J13-52) | (N52) | (J13-78) | (N78) | | |

**[Table 14]**

| | | | | | | | |
|---|---|---|---|---|---|---|---|
| 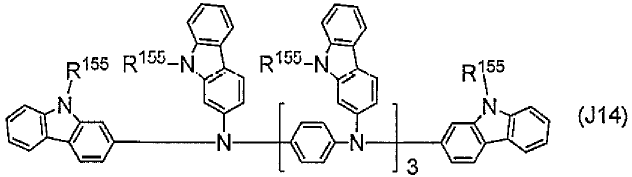 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J14-1) | (N1) | (J14-27) | (N27) | (J14-53) | (N53) | (J14-79) | -H |
| (J14-2) | (N2) | (J14-28) | (N28) | (J14-54) | (N54) | (J14-80) | -Me |
| (J14-3) | (N3) | (J14-29) | (N29) | (J14-55) | (N55) | (J14-81) | -Et |
| (J14-4) | (N4) | (J14-30) | (N30) | (J14-56) | (N56) | (J14-82) | -Prⁿ |
| (J14-5) | (N5) | (J14-31) | (N31) | (J14-57) | (N57) | (J14-83) | -Pr^{l} |
| (J14-6) | (N6) | (J14-32) | (N32) | (J14-58) | (N58) | (J14-84) | -Buⁿ |
| (J 14-7) | (N7) | (J14-33) | (N33) | (J14-59) | (N59) | (J14-85) | -Bu^{l} |
| (J14-8) | (N8) | (J14-34) | (N34) | (J14-60) | (N60) | (J14-86) | -Bu^{s} |
| (J14-9) | (N9) | (J14-35) | (N35) | (J14-61) | (N61) | (J14-87) | -Bu^{t} |
| (J14-10) | (N10) | (J14-36) | (N36) | (J14-62) | (N62) | | |
| (J14-11) | (N11) | (J14-37) | (N37) | (J14-63) | (N63) | | |
| (J14-12) | (N12) | (J14-38) | (N38) | (J14-64) | (N64) | | |
| (J14-13) | (N13) | (J14-39) | (N39) | (J14-65) | (N65) | | |
| (J14-14) | (N14) | (J14-40) | (N40) | (J14-66) | (N66) | | |
| (J14-15) | (N15) | (J14-41) | (N41) | (J14-67) | (N67) | | |
| (J14-16) | (N16) | (J14-42) | (N42) | (J14-68) | (N68) | | |
| (J14-17) | (N17) | (J14-43) | (N43) | (J14-69) | (N69) | | |
| (J14-18) | (N18) | (J14-44) | (N44) | (J14-70) | (N70) | | |
| (J14-19) | (N19) | (J14-45) | (N45) | (J14-71) | (N71) | | |
| (J14-20) | (N20) | (J14-46) | (N46) | (J14-72) | (N72) | | |
| (J14-21) | (N21) | (J14-47) | (N47) | (J14-73) | (N73) | | |
| (J14-22) | (N22) | (J14-48) | (N48) | (J14-74) | (N74) | | |
| (J14-23) | (N23) | (J14-49) | (N49) | (J14-75) | (N75) | | |
| (J14-24) | (N24) | (J14-50) | (N50) | (J14-76) | (N76) | | |
| (J14-25) | (N25) | (J14-51) | (N51) | (J14-77) | (N77) | | |
| (J14-26) | (N26) | (J14-52) | (N52) | (J14-78) | (N78) | | |

**[Table 15]**

| | | | | | | | |
|---|---|---|---|---|---|---|---|
| 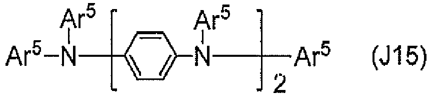 | | | | | | | |

| Compound | Ar⁵ | Compound | Ar⁵ | Compound | Ar⁵ | Compound | Ar⁵ |
|---|---|---|---|---|---|---|---|
| (J15-1) | (A1-1) | (J15-27) | (A6-11) | (J15-53) | (A12-7) | (J15-79) | (A13-22) |
| (J15-2) | (A1-2) | (J15-28) | (A6-12) | (J15-54) | (A12-8) | (J15-80) | (A13-23) |
| (J15-3) | (A2-1) | (J15-29) | (A6-13) | (J15-55) | (A12-9) | (J15-81) | (A13-24) |
| (J15-4) | (A2-2) | (J15-30) | (A6-14) | (J15-56) | (A12-10) | (J15-82) | (A14-1) |
| (J15-5) | (A2-3) | (J15-31) | (A6-15) | (J15-57) | (A12-11) | (J15-83) | (A14-2) |
| (J15-6) | (A2-4) | (J15-32) | (A7-1) | (J15-58) | (A13-1) | (J15-84) | (A14-3) |
| (J15-7) | (A2-5) | (J15-33) | (A7-2) | (J15-59) | (A13-2) | (J15-85) | (A14-4) |
| (J15-8) | (A3-1) | (J15-34) | (A7-3) | (J15-60) | (A13-3) | (J15-86) | (A15-1) |
| (J15-9) | (A3-2) | (J15-35) | (A8-1) | (J15-61) | (A13-4) | (J15-87) | (A15-2) |
| (J15-10) | (A3-3) | (J15-36) | (A8-2) | (J15-62) | (A13-5) | (J15-88) | (A15-3) |
| (J15-11) | (A4-1) | (J15-37) | (A8-3) | (J15-63) | (A13-6) | (J15-89) | (A15-4) |
| (J15-12) | (A4-2) | (J15-38) | (A9-1) | (J15-64) | (A13-7) | (J15-90) | (A17-1) |
| (J15-13) | (A4-3) | (J15-39) | (A9-2) | (J15-65) | (A13-8) | (J15-91) | (A17-2) |
| (J15-14) | (A5-1) | (J15-40) | (A9-3) | (J15-66) | (A13-9) | (J15-92) | (A17-3) |
| (J15-15) | (A5-2) | (J15-41) | (A10-1) | (J15-67) | (A13-10) | (J15-93) | (A17-4) |
| (J15-16) | (A5-3) | (J15-42) | (A10-2) | (J15-68) | (A13-11) | (J15-94) | (A17-5) |
| (J15-17) | (A6-1) | (J15-43) | (A10-3) | (J15-69) | (A13-12) | (J15-95) | (A17-6) |
| (J15-18) | (A6-2) | (J15-44) | (A11-1) | (J15-70) | (A13-13) | (J15-96) | (A17-7) |
| (J15-19) | (A6-3) | (J15-45) | (A11-2) | (J15-71) | (A13-14) | (J15-97) | (A17-8) |
| (J15-20) | (A6-4) | (J15-46) | (A11-3) | (J15-72) | (A13-15) | (J15-98) | (A17-9) |
| (J15-21) | (A6-5) | (J15-47) | (A12-1) | (J15-73) | (A13-16) | (J15-99) | (A17-10) |
| (J15-22) | (A6-6) | (J15-48) | (A12-2) | (J15-74) | (A13-17) | (J15-100) | (A17-11) |
| (J15-23) | (A6-7) | (J15-49) | (A12-3) | (J15-75) | (A13-18) | (J15-101) | (A17-12) |
| (J15-24) | (A6-8) | (J15-50) | (A12-4) | (J15-76) | (A13-19) | (J15-102) | (A18-1) |
| (J15-25) | (A6-9) | (J15-51) | (A12-5) | (J15-77) | (A13-20) | (J15-103) | (A18-2) |
| (J15-26) | (A6-10) | (J15-52) | (A12-6) | (J15-78) | (A13-21) | | |

**[Table 16]**

| | | | | | | | |
|---|---|---|---|---|---|---|---|
| 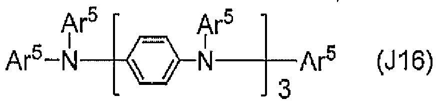 | | | | | | | |

| Compound | Ar⁵ | Compound | Ar⁵ | Compound | Ar⁵ | Compound | Ar⁵ |
|---|---|---|---|---|---|---|---|
| (J16-1) | (A1-1) | (J16-27) | (A6-11) | (J16-53) | (A12-7) | (J16-79) | (A13-22) |
| (J16-2) | (A1-2) | (J16-28) | (A6-12) | (J16-54) | (A12-8) | (J16-80) | (A13-23) |
| (J16-3) | (A2-1) | (J16-29) | (A6-13) | (J16-55) | (A12-9) | (J16-81) | (A13-24) |
| (J16-4) | (A2-2) | (J16-30) | (A6-14) | (J16-56) | (A12-10) | (J16-82) | (A14-1) |
| (J16-5) | (A2-3) | (J16-31) | (A6-15) | (J16-57) | (A12-11) | (J16-83) | (A14-2) |
| (J16-6) | (A2-4) | (J16-32) | (A7-1) | (J16-58) | (A13-1) | (J10-84) | (A14-3) |
| (J16-7) | (A2-5) | (J16-33) | (A7-2) | (J16-59) | (A13-2) | (J16-85) | (A14-4) |
| (J16-8) | (A3-1) | (J16-34) | (A7-3) | (J16-60) | (A13-3) | (J16-86) | (A15-1) |
| (J16-9) | (A3-2) | (J16-35) | (A8-1) | (J16-61) | (A13-4) | (J16-87) | (A15-2) |
| (J16-10) | (A3-3) | (J16-36) | (A8-2) | (J16-62) | (A13-5) | (J16-88) | (A15-3) |
| (J16-11) | (A4-1) | (J16-37) | (A8-3) | (J16-63) | (A13-6) | (J16-89) | (A15-4) |
| (J16-12) | (A4-2) | (J16-38) | (A9-1) | (J16-64) | (A13-7) | (J16-90) | (A17-1) |
| (J16-13) | (A4-3) | (J16-39) | (A9-2) | (J16-65) | (A13-8) | (J16-91) | (A17-2) |
| (J16-14) | (A5-1) | (J16-40) | (A9-3) | (J16-66) | (A13-9) | (J16-92) | (A17-3) |
| (J16-15) | (A5-2) | (J16-41) | (A10-1) | (J16-67) | (A13-10) | (J16-93) | (A17-4) |
| (J16-16) | (A5-3) | (J16-42) | (A10-2) | (J16-68) | (A13-11) | (J16-94) | (A17-5) |
| (J16-17) | (A6-1) | (J16-43) | (A10-3) | (J16-69) | (A13-12) | (J16-95) | (A17-6) |
| (J16-18) | (A6-2) | (J16-44) | (A11-1) | (J16-70) | (A13-13) | (J16-96) | (A17-7) |
| (J16-19) | (A6-3) | (J16-45) | (A11-2) | (J16-71) | (A13-14) | (J16-97) | (A17-8) |
| (J16-20) | (A6-4) | (J16-46) | (A11-3) | (J16-72) | (A13-15) | (J16-98) | (A17-9) |
| (J16-21) | (A6-5) | (J16-47) | (A12-1) | (J16-73) | (A13-16) | (J16-99) | (A17-10) |
| (J16-22) | (A6-6) | (J16-48) | (A12-2) | (J16-74) | (A13-17) | (J16-100) | (A17-11) |
| (J16-23) | (A6-7) | (J16-49) | (A12-3) | (J16-75) | (A13-18) | (J16-101) | (A17-12) |
| (J16-24) | (A6-8) | (J16-50) | (A12-4) | (J16-76) | (A13-19) | (J16-102) | (A18-1) |
| (J16-25) | (A6-9) | (J16-51) | (A12-5) | (J16-77) | (A13-20) | (J16-103) | (A18-2) |
| (J16-26) | (A6-10) | (J16-52) | (A12-6) | (J16-78) | (A13-21) | | |

**[Table 17]**

| | | | | | | | |
|---|---|---|---|---|---|---|---|
| 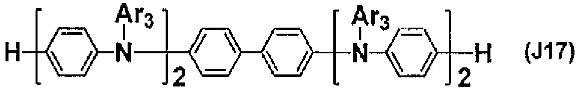 | | | | | | | |

| Compound | Ar³ | Compound | Ar³ | Compound | Ar³ | Compound | Ar³ |
|---|---|---|---|---|---|---|---|
| (J17-1) | (C1') | (J17-3) | (C3') | (J17-5) | (C5') | (J17-7) | (C7') |
| (J17-2) | (C2') | (J17-4) | (C4') | (J17-6) | (C6') | (J17-8) | (C8') |

**[Table 18]**

| | | | | | | | |
|---|---|---|---|---|---|---|---|
| 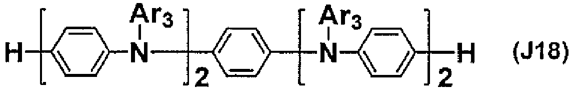 | | | | | | | |

| Compound | Ar³ | Compound | Ar³ | Compound | Ar³ | Compound | Ar³ |
|---|---|---|---|---|---|---|---|
| (J18-1) | (C1') | (J18-3) | (C3') | (J18-5) | (C5') | (J18-7) | (C7') |
| (J18-2) | (C2') | (J18-4) | (C4') | (J18-6) | (C6') | (J18-8) | (C8') |

A good solvent that is capable of fully dissolving the charge-transporting substance and the dopant substance may be used as the organic solvent included in the inventive composition.

Illustrative examples of such good solvents include, but are not limited to, organic solvents such as N,N-dimethylformamide, N,N-dimethylacetamide, N,N-dimethylbutyramide, N,N-diethylbutyramide, N,N-methylethylbutyramide, N,N-dimethylisobutyramide, N,N-diethylisobutyramide, N-ethyl-N-methylisobutyramide, N-methylpyrrolidone and 1,3-dimethyl-2-imidazolidinone. These solvents may be of one type used alone, or two or more may be used in admixture. The amount of use may be set to from 5 to 100 wt% of the overall solvent used.

In this invention, in addition to the above organic solvent, other organic solvents may be included for such purposes as to increase the substrate wettability, adjust the solvent surface tension, adjust the polarity, and adjust the boiling point. Such other organic solvents include, but are not limited to, preferably glycols, triols, alkylene glycol monoalkyl ethers, alkylene glycol dialkyl ethers, dialkylene glycol monoalkyl ethers and dialkylene glycol dialkyl ethers, and more preferably glycols, alkylene glycol monoalkyl ethers and dialkylene glycol monoalkyl ethers. These solvents may be used singly or two or more may be used in admixture. The amount of use thereof is determined by the amount of the good solvent used together.

Of these, it is preferable to include, as such other organic solvents aside from the good solvent: diethylene glycol, triethylene glycol, dipropylene glycol, 1,2-ethanediol, 1,2-propanediol, 1,2-butanediol, 2,3-butanediol, 1,3-butanediol, 1,4-butanediol, ethylene glycol monomethyl ether, ethylene glycol monoethyl ether, ethylene glycol propyl ether, ethylene glycol isopropyl ether, ethylene glycol monobutyl ether, ethylene glycol monoisobutyl ether, propylene glycol monomethyl ether, propylene glycol monoethyl ether, propylene glycol monopropyl ether, propylene glycol monoisopropyl ether, propylene glycol monobutyl ether, propylene glycol monoisobutyl ether, diethylene glycol monomethyl ether, diethylene glycol monoethyl ether, diethylene glycol propyl ether, diethylene glycol isopropyl ether, diethylene glycol monobutyl ether, diethylene glycol monoisobutyl ether, dipropylene glycol monomethyl ether, dipropylene glycol monoethyl ether, dipropylene glycol monopropyl ether, dipropylene glycol monoisopropyl ether, dipropylene glycol monobutyl ether and dipropylene glycol monoisobutyl ether; and even more preferably to include diethylene glycol, triethylene glycol, dipropylene glycol, 1,2-ethanediol, 1,2-propanediol, 1,2-butanediol, 2,3-butanediol, 1,3-butanediol, 1,4-butanediol, ethylene glycol monomethyl ether, propylene glycol monomethyl ether, diethylene glycol monomethyl ether and dipropylene glycol monomethyl ether. By selecting the solvent to be used from among solvents such as these while taking into account the types and amounts of the charge-transporting substances and dopants, a composition having the desired liquid properties can easily be prepared.

In this invention, from the standpoint of obtaining a charge-transporting thin film of excellent flatness, the above charge-transporting substance and the above dopant substance are dissolved in the above organic solvents (when other ingredients such as an organosilane compound are included, those ingredients are also dissolved in the above organic solvents).

The inventive composition has a viscosity which is suitably set in accordance with the thickness and other properties of the thin film to be produced and the solids concentration, but is generally from 1 to 50 mPa·s at 25°C, and has a surface tension which is generally from 20 to 50 mN/m.

The inventive composition may include an organosilane compound. In cases where a thin film obtained from the composition is used as a hole-injecting layer in an organic EL device, including an organosilane compound makes it possible to increase the ability to inject holes into a layer, such as a hole-transporting layer or a light-emitting layer, that is deposited on the opposite side from the anode so as to be in contact with the hole-injecting layer.

Examples of such organosilane compounds include dialkoxysilane compounds, trialkoxysilane compounds and tetraalkoxysilane compounds. These may be used singly, or two or more may be used in combination.

In this invention, the organosilane compound preferably includes one type selected from among dialkoxysilane compounds and trialkoxysilane compounds, more preferably includes a trialkoxysilane compound, and even more preferably includes a fluorine atom-containing trialkoxysilane compound.

These alkoxysilane compounds are exemplified by the compounds of formulas (S1) to (S3) below.

Si(OR)₄ (S1)

SiR'(OR)₃ (S2)

Si(R')₂(OR)₂ (S3)

Here, each R is independently an alkyl group of 1 to 20 carbon atoms which may be substituted with Z⁶, an alkenyl group of 2 to 20 carbon atoms which may be substituted with Z⁶, an alkynyl group of 2 to 20 carbon atoms which may be substituted with Z⁶, an aryl group of 6 to 20 carbon atoms which may be substitute with Z⁷ or a heteroaryl group of 2 to 20 carbon atoms which may be substituted with Z⁷; and each R' is independently an alkyl group of 1 to 20 carbon atoms which may be substituted with Z⁸, an alkenyl group of 2 to 20 carbon atoms which may be substituted with Z⁸, an alkynyl group of 2 to 20 carbon atoms which may be substituted with Z⁸, an aryl group of 6 to 20 carbon atoms which may be substituted with Z⁹, or a heteroaryl group of 2 to 20 carbon atoms which may be substituted with Z⁹.

Z⁶ is a halogen atom, an aryl group of 6 to 20 carbon atoms which may be substituted with Z¹⁰, or a heteroaryl group of 2 to 20 carbon atoms which may be substituted with Z¹⁰. Z⁷ is a halogen atom, an alkyl group of 1 to 20 carbon atoms which may be substituted with Z¹⁰, an alkenyl group of 2 to 20 carbon atoms which may be substituted with Z¹⁰, or an alkynyl group of 2 to 20 carbon atoms which may be substituted with Z¹⁰.

Z⁸ is a halogen atom, an aryl group of 6 to 20 carbon atoms which may be substituted with Z¹⁰, a heteroaryl group of 2 to 20 carbon atoms which may be substituted with Z¹⁰, an epoxycyclohexyl group, a glycidoxy group, a methacryloxy group, an acryloxy group, a ureido group (-NHCONH₂), a thiol group, an isocyanate group (-NCO), an amino group, a -NHY¹ group, or a -NY²Y³ group. Z⁹ is a halogen atom, an alkyl group of 1 to 20 carbon atoms which may be substituted with Z¹⁰, an alkenyl group of 2 to 20 carbon atoms which may be substituted with Z¹⁰, an alkynyl group of 2 to 20 carbon atoms which may be substituted with Z¹⁰, an epoxycyclohexyl group, a glycidoxy group, a methacryloxy group, an acryloxy group, a ureido group (-NHCONH₂), a thiol group, an isocyanate group (-NCO), an amino group, a -NHY¹ group, or a -NY²Y³ group. Y¹ to Y³ are each independently an alkyl group of 1 to 20 carbon atoms which may be substituted with Z¹⁰, an alkenyl group of 2 to 20 carbon atoms which may be substituted with Z¹⁰, an alkynyl group of 2 to 20 carbon atoms which may be substituted with Z¹⁰, an aryl group of 6 to 20 carbon atoms which may be substituted with Z¹⁰, or a heteroaryl group of 2 to 20 carbon atoms which may be substituted with Z¹⁰.

Z¹⁰ is a halogen atom, an amino group, a nitro group, a cyano group or a thiol group.

The halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms in formulas (S1) to (S3) are exemplified in the same way as above.

The number of carbon atoms on the alkyl groups, alkenyl groups and alkynyl groups in R and R' is preferably 10 or less, more preferably 6 or less, and even more preferably 4 or less.

The number of carbon atoms on the aryl groups and heteroaryl groups is preferably 14 or less, more preferably 10 or less, and even more preferably 6 or less.

R is preferably an alkyl group of 1 to 20 carbon atoms or alkenyl group of 2 to 20 carbon atoms which may be substituted with Z⁶, or an aryl group of 6 to 20 carbon atoms which may be substituted with Z⁷; more preferably an alkyl group of 1 to 6 carbon atoms or alkenyl group of 2 to 6 carbon atoms which may be substituted with Z⁶, or a phenyl group which may be substituted with Z⁷; even more preferably an alkyl group of 1 to 4 carbon atoms which may be substituted with Z⁶ or a phenyl group which may be substituted with Z⁷; and still more preferably a methyl group or ethyl group which may be substituted with Z⁶.

R' is preferably an alkyl group of 1 to 20 carbon atoms which may be substituted with Z⁸ or an aryl group of 6 to 20 carbon atoms which may be substituted with Z⁹; more preferably an alkyl group of 1 to 10 carbon atoms which may be substituted with Z⁸ or an aryl group of 6 to 14 carbon atoms which may be substituted with Z⁹; even more preferably an alkyl group of 1 to 6 carbon atoms which may be substituted with Z⁸ or an aryl group of 6 to 10 carbon atoms which may be substituted with Z⁹, and still more preferably an alkyl group of 1 to 4 carbon atoms which may be substituted with Z⁸ or a phenyl group which may be substituted with Z⁹.

When there are a plurality of R groups, they may all be the same or may differ. When there are a plurality of R' groups, they may all be the same or may differ.

Z⁶ is preferably a halogen atom or an aryl group of 6 to 20 carbon atoms which may be substituted with Z¹⁰, more preferably a fluorine atom or a phenyl group which may be substituted with Z¹⁰, and most preferably does not exist (i.e., is non-substituting).

Z⁷ is preferably a halogen atom or an alkyl group of 6 to 20 carbon atoms which may be substituted with Z¹⁰, more preferably a fluorine atom or an alkyl group of 1 to 10 carbon atoms which may be substituted with Z¹⁰, and most preferably does not exist (i.e., is non-substituting).

Z⁸ is preferably a halogen atom, a phenyl group which may be substituted with Z¹⁰, a furanyl group which may be substituted with Z¹⁰, an epoxycyclohexyl group, a glycidoxy group, a methacryloxy group, an acryloxy group, a ureido group, a thiol group, an isocyanate group, an amino group, a phenylamino group which may be substituted with Z¹⁰, or a diphenylamino group which may be substituted with Z¹⁰; more preferably a halogen atom; and even more preferably a fluorine atom or does not exist (i.e., is non-substituting).

Z⁹ is preferably a halogen atom, an alkyl group of 1 to 20 carbon atoms which may be substituted with Z¹⁰, a furanyl group which may be substituted with Z¹⁰, an epoxycyclohexyl group, a glycidoxy group, a methacryloxy group, an acryloxy group, a ureido group, a thiol group, an isocyanate group, an amino group, a phenylamino group which may be substituted with Z¹⁰, or a diphenylamino group which may be substituted with Z¹⁰; more preferably a halogen atom; and even more preferably a fluorine atom or does not exist (i.e., is non-substituting).

Z¹⁰ is preferably a halogen atom, and more preferably a fluorine atom or does not exist (i.e., is non-substituting).

Examples of organosilane compounds that may be used in this invention include, but are not limited to, the following.

Specific examples of dialkoxysilane compounds include dimethyldimethoxysilane, dimethyldiethoxysilane, methylethyldimethoxysilane, diethyldimethoxysilane, diethyldiethoxysilane, methylpropyldimethoxysilane, methylpropyldiethoxysilane, diisopropyldimethoxysilane, phenylmethyldimethoxysilane, vinylmethyldimethoxysilane, 3-glycidoxypropylm ethyldimethoxysilane, 3-glycidoxypropylmethyldiethox ysilane, 3-(3,4-epoxycyclohexyl)ethylmethyldimethoxysilane, 3-methacryloxypropylmethyldimethoxysilane, 3-methacryloxypropylmethyldiethoxysilane, 3-mercaptopropylmethyldimethoxysilane, γ-aminopropylmethyldiethoxysilane, N-(2-aminoethyl)aminopropylmethyldimethoxysilane and 3,3,3-trifluoropropylmethyldimethoxysilane.

Specific examples of trialkoxysilane compounds include methyltrimethoxysilane, methyltriethoxysilane, ethyltrimethoxysilane, ethyltriethoxysilane, propyltrimethoxysilane, propyltriethoxysilane, butyltrimethoxysilane, butyltriethoxysilane, pentyltrimethoxysilane, pentyltriethoxysilane, heptyltrimethoxysilane, heptyltriethoxysilane, octyltrimethoxysilane, octyltriethoxysilane, dodecyltrimethoxysilane, dodecyltriethoxysilane, hexadecyltrimethoxysilane, hexadecyltriethoxysilane, octadecyltrimethoxysilane, octadecyltriethoxysilane, phenyltrimethoxysilane, phenyltriethoxysilane, vinyltrimethoxysilane, vinyltriethoxysilane, γ-aminopropyltrimethoxysilane, 3-aminopropyltriethoxysilane, γ-glycidoxypropyltrimethoxysilane, 3-glycidoxypropyltricthoxysilanc, γ-methacryloxypropyltrimethoxysilane, γ-methacryloxypropyltriethoxysilane, triethoxy(4-trifluoromethyl)phenyl)silane, dodecyltriethoxysilane, 3,3,3-trifluoropropyltrimethoxysilane, (triethoxysilyl)cyclohexane, perfluorooctylethyltriethoxysilane, triethoxyfluorosilane, tridecafluoro-1,1,2,2-tetrahydrooctyltriethoxysilane, pentafluorophenyltrimethoxysilane, pentafluorophenyltriethoxysilane, 3-(heptafluoroisopropoxy)propyltriethoxysilane, heptadecafluoro-1,1,2,2-tetrahydrodecyltriethoxysilane, triethoxy-2-thienylsilane and 3-(triethoxysilyl)furan.

Specific examples of tetraalkoxysilane compounds include tetraethoxysilane, tetramethoxysilane and tetrapropoxysilane.

Of these, 3,3,3-trifluoropropylmethyldimethoxysilane, triethoxy(4-(trifluoromethyl)phenyl)silane, 3,3,3-trifluoropropyltrimethoxysilane, perfluorooctylethyltriethoxysilane, pentafluorophenyltrimethoxysilane and pentafluorophenyltriethoxysilane are preferred.

When the inventive composition includes an organosilane compound, the content thereof, based on the overall mass of the charge-transporting substance and the dopant substance, is generally about 0.1 to 50 wt%. However, to suppress a decrease in charge transportability of the resulting thin film and also increase the ability to inject holes into a hole-transporting layer or the like that is deposited on the above-described cathode side so as to be in contact with the hole-injecting layer consisting of the thin film obtained from this composition, the content is preferably about 0.5 to 40 wt%, more preferably about 0.8 to 30 wt%, and even more preferably about 1 to 20 wt%.

The viscosity of the inventive composition, which is set as appropriate for the thickness and other properties of the thin film to be produced and the solids concentration, is generally from 1 to 50 mPa·s at 25°C. The surface tension is generally from 20 to 50 mN/m.

The solids concentration of the inventive composition, which is set as appropriate based on such considerations as the viscosity, surface tension and other properties of the composition and the thickness and other properties of the thin film to be produced, is generally from about 0.1 to about 20.0 wt%. To improve the coating properties of the composition, the solids concentration is preferably from about 0.5 to about 10.0 wt%, and more preferably from about 1.0 to about 5.0 wt%. As used herein, "solids" refers to the charge-transporting substance and dopant substance included in the inventive composition.

The method of preparing the composition is not particularly limited. Examples include the method of first dissolving the charge-transporting substance in a solvent and adding thereto the dopant substance, and the method of dissolving a mixture of the charge-transporting substance and the dopant substance in a solvent.

Alternatively, in cases where there are a plurality of organic solvents, first the charge-transporting substance and the dopant substance may be dissolved in a solvent that dissolves these well, and the other solvents may be added thereto, or the charge-transporting substance and the dopant substance may be successively dissolved in a mixed solvent of the plurality of organic solvents or may be dissolved therein at the same time.

In this invention, from the standpoint of reproducibly obtaining this films having a high-flatness, it is desirable for the composition to be obtained by dissolving the charge-transporting substance, the dopant substance and other ingredients in the organic solvent and then filtering the solution using a submicron-order filter or the like.

The charge-transporting thin film of the invention can be formed on a substrate by applying the above-described charge-transporting thin film-forming composition of the invention onto the substrate and then baking the applied composition.

Examples of the method for applying the composition include, but are not limited to, dipping, spin coating, transfer printing, roll coating, brush coating, inkjet printing, spraying and slit coating. To reproducibly obtain charge-transporting thin films having a high flatness, the method of application is preferably spin coating, inkjet printing or spraying. It is preferable to adjust the viscosity and surface tension of the composition according to the method of application.

In this invention, to reproducibly obtain thick charge-transporting films having a uniform film surface and high charge transportability, it is preferable to bake the composition in an open-air atmosphere.

The baking temperature is suitably set in the range of about 100 to 260°C while taking into account such factors as the intended use of the resulting thin film, the degree of charge transportability to be imparted to the thin film, and the type and boiling point of the solvent. When the thin film thus obtained is to be used as a hole-injecting layer in an organic EL device, the baking temperature is preferably between about 140°C and about 250°C, and more preferably between about 145°C and about 240°C. The baking time varies with the baking temperature and thus cannot be strictly specified, but is generally from 1 minute to 1 hour.

During baking, a temperature change in two or more steps may be applied for such purposes as to achieve more uniform film formability or to cause the reaction to proceed on the substrate. Heating may be carried out using a suitable apparatus such as a hot plate or an oven.

The thickness of the charge-transporting thin film is not particularly limited. However, when the thin film is to be used as a hole-injecting layer in an organic EL device, a film thickness of from 5 to 200 nm is preferred. Methods for changing the film thickness include, for example, changing the solids concentration in the composition and changing the amount of solution on the substrate during coating.

The charge-transporting thin film of the invention can be suitably used as a hole-injecting layer in an organic EL device, although use as a charge-transporting functional layer such as a hole-injecting-and-transporting layer is also possible.

The organic EL device of the invention has a pair of electrodes and additionally has, between these electrodes, the above-described charge-transporting thin film of the invention.

Typical organic EL device configurations include, but are not limited to, configurations (a) to (f) below. In these configurations, where necessary, an electron-blocking layer or the like may be provided between the light-emitting layer and the anode, and a hole-blocking layer or the like may be provided between the light-emitting layer and the cathode. Alternatively, the hole-injecting layer, hole-transporting layer or hole-injecting-and-transporting layer may also have the function of, for example, an electron-blocking layer; and the electron-injecting layer, electron-transporting layer or electron-injecting-and-transporting layer may also have the function of, for example, a hole-blocking layer.
(a) anode/hole-injecting layer/hole-transporting layer/light-emitting layer/electron-transporting layer/electron-injecting layer/cathode
(b) anode/hole-injecting layer/hole-transporting layer/light-emitting layer/electron-injecting-and-transporting layer/cathode
(c) anode/hole-injecting-and-transporting layer/light-emitting layer/electron-transporting layer/electron-injecting layer/cathode
(d) anode/hole-injecting-and-transporting layer/light-emitting layer/electron-injecting-and-transporting layer/cathode
(e) anode/hole-injecting layer/hole-transporting layer/light-emitting layer/cathode
(f) anode/hole-injecting-and-transporting layer/light-emitting layer/cathode

As used herein, "hole-injecting layer," "hole-transporting layer" and "hole-injecting-and-transporting layer" refer to layers which are formed between the light-emitting layer and the anode and which have the function of transporting holes from the anode to the light-emitting layer. When only one layer of hole-transporting material is provided between the light-emitting layer and the anode, this is a "hole-injecting-and-transporting layer"; when two or more layers of hole-transporting material are provided between the light-emitting layer and the anode, the layer that is closer to the anode is a "hole-injecting layer" and the other layer is a "hole-transporting layer." In particular, thin films having not only an ability to accept holes from the anode but also an excellent ability to inject holes into the hole-transporting layer and the light-emitting layer may be used as, respectively, the hole-injecting layer and the holc-injccting-and-transporting layer.

In addition, "electron-injecting layer," "electron-transporting layer" and "electron-injecting-and-transporting layer" refer to layers which are formed between the light-emitting layer and the cathode and which have the function of transporting electrons from the cathode to the light-emitting layer. When only one layer of electron-transporting material is provided between the light-emitting layer and the cathode, this is an "electron-injecting-and-transporting layer"; when two or more layers of electron-transporting material are provided between the light-emitting layer and the cathode, the layer that is closer to the cathode is an "electron-injecting layer" and the other layer is an "electron-transporting layer."

The "light-emitting layer" is an organic layer having a light-emitting function. When a doping system is used, this layer includes a host material and a dopant material. The function of the host material is primarily to promote the recombination of electrons and holes and to confine the resulting excitons within the light-emitting layer. The function of the dopant material is to cause the excitons obtained by recombination to efficiently luminesce. In the case of a phosphorescent device, the host material functions primarily to confine within the light-emitting layer the excitons generated by the dopant.

The materials and method employed to fabricate an organic EL device using the inventive composition are exemplified by, but not limited to, those described below.

The electrode substrate to be used is preferably cleaned beforehand by liquid washing with, for example, a cleaning agent, alcohol or pure water. When the substrate is an anode substrate, it is preferably subjected to surface treatment such as UV/ozone treatment or oxygen-plasma treatment just prior to use. However, surface treatment need not be carried out in cases where the anode material is composed primarily of organic substances.

An example of a method for producing the organic EL device of the invention in which a thin-film obtained from the inventive composition serves as the hole-injecting layer is described below.

Using the above-described method, a hole-injecting layer is formed on an electrode by applying the inventive composition onto an anode substrate, and baking the applied composition. A hole-transporting layer, light-emitting layer, electron-transporting layer, election-injecting layer and cathode are then provided in this order on the hole-injecting layer. The hole-transporting layer, light-emitting layer, electron-transporting layer and electron-injecting layer may be formed by either vapor deposition processes or coating processes (wet processes), depending on the properties of the material to be used.

Illustrative examples of anode materials include transparent electrodes such as indium-tin oxide (ITO) and indium-zinc oxide (IZO), and metal anodes made of a metal such as aluminum or an alloy of such a metal. An anode material on which planarizing treatment has been carried out is preferred. Use can also be made of polythiophene derivatives and polyaniline derivatives having a high charge transportability.

Examples of other metals that may make up the metal anode include, but are not limited to, scandium, titanium, vanadium, chromium, manganese, iron, cobalt, nickel, copper, zinc, gallium, yttrium, zirconium, niobium, molybdenum, ruthenium, rhodium, palladium, cadmium, indium, scandium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof.

Specific examples of hole-transporting layer-forming materials include the following hole-transporting low-molecular-weight materials: triarylamines such as (triphenylamine) dimer derivatives, [(triphenylamine) dimer] spirodimer, N,N'-bis(naphthalen-1-yl)-N,N'-bis(phenyl)benzidine(α-NPD), N,N'-bis(naphthalen-2-yl)-N,N'-bis(phenyl)benzidine, N,N'-bis(3-methylphenyl)-N,N'-bis(phenyl)benzidine, N,N'-bis(3-methylphenyl)-N,N'-bis(phenyl)-9,9-spirobifluorene, N,N'-bis(naphthalen-1-yl)-N,N'-bis(phenyl)-9,9-spirobifluorene, N,N'-bis(3-methylphenyl)-N,N'-bis(phenyl)-9,9-dimethylfluorene, N,N'-bis(naphthalen-1-yl)-N,N'-bis(phenyl)-9,9-dimethylfluorene, N,N'-bis(3-methylphenyl)-N,N'-bis(phenyl)-9,9-diphenylfluorene, N,N'-bis(naphthalen-1-yl)-N,N'-bis(phenyl)-9,9-diphenylfluorene, N,N'-bis(naphthalen-1-yl)-N,N'-bis(phenyl)-2,2'-dimethylbenzidine, 2,2',7,7'-tetrakis(N,N-diphenylamino)-9,9-spirobifluorene, 9,9-bis[4-(N,N-bis-biphenyl-4-ylamino)phenyl]-9H-fluorene, 9,9-bis[4-(N,N-bis-naphthalen-2-ylamino)phenyl]-9H-fluorene, 9,9-bis[4-(N-naphthalen-1-yl-N-phenylamino)phenyl]-9H-fluorene, 2,2',7,7'-tetrakis[N-naphthalenyl(phenyl)amino]-9,9-spirobifluorene, N,N'-bis(phenanthren-9-yl)-N,N' -bis(phenyl)benzidine, 2,2'-bis[N,N-bis(biphenyl-4-yl)amino]-9,9-spirobifluorene, 2,2'-bis(N,N-diphenylamino)-9,9-spirobifluorene, di[4-(N,N-di(p-tolyl)amino)phenyl]cyclohexane, 2,2',7,7' -tetra(N,N-di(p-tolyl)amino)-9,9-spirobifluorene, N,N,N' ,N' -tetra-naphthalen-2-yl-benzidine, N,N,N',N'-tetra(3-methylphenyl)-3,3'-dimethylbenzidine, N,N'-di(naphthalenyl)-N,N'-di(naphthalen-2-yl)benzidine, N,N,N' ,N' -tetra(naphthalenyl)benzidine, N,N'-di(naphthalen-2-yl)-N,N'-diphenylbenzidine-1-4-diamine, N¹,N⁴-diphenyl-N¹,N⁴-di(m-tolyl)benzene-1,4-diamine, N²,N², N⁶,N⁶-tetraphenylnaphthalene-2,6-diamine, tris(4-(quinolin-8-yl)phenyl)amine, 2,2'-bis(3-(N,N-di(p-tolyl)amino)phenyl)biphenyl, 4,4',4"-tris[3-methylphenyl(phenyl)amino]triphenylamine (m-MTDATA) and 4,4',4"-tris[1-naphthyl(phenyl)amino]triphenylamine (1-TNATA); and oligothiophenes such as 5,5"-bis-{4-[bis(4-methylphenyl)amino]phenyl}-2,2':5',2"-terthiophene (BMA-3T).

Specific examples of light-emitting layer-forming materials include tris(8-quinolinolate) aluminum(III) (Alq₃), bis(8-quinolinolate) zinc(II) (Znq₂), bis(2-methyl-8-quinolinolate)-4-(p-phenylphenolate) aluminum(III) (BAlq), 4,4'-bis(2,2-diphenylvinyl)biphenyl, 9,10-di(naphthalen-2-yl)anthracene, 2-t-butyl-9,10-di(naphthalen-2-yl)anthracene, 2,7-bis[9,9-di(4-methylphenyl)-fluoren-2-yl]-9,9-di(4-methylphenyl)fluorene, 2-methyl-9,10-bis(naphthalen-2-yl)anthracene, 2-(9,9-spirobifluoren-2-yl)-9,9-spirobifluorene, 2,7-bis(9,9-spirobifluoren-2-yl)-9,9-spirobifluorene, 2-[9,9-di(4-methylphenyl)-fluoren-2-yl]-9,9-di(4-methylphenyl)fluorene, 2,2'-dipyrenyl-9,9-spirobifluorene, 1,3,5-tris(pyren-1-yl)benzene, 9,9-bis[4-(pyrenyl)phenyl]-9H-fluorene, 2,2'-bi(9,10-diphenylanthracene), 2,7-dipyrenyl-9,9-spirobifluorene, 1,4-di(pyren-1-yl)benzene, 1,3-di(pyren-1-yl)benzene, 6,13-di(biphenyl-4-yl)pentacene, 3,9-di(naphthalen-2-yl)perylene, 3,10-di(naphthalen-2-yl)perylene, tris[4-(pyrenyl)-phenyl]amine, 10,10' -di(biphenyl-4-yl)-9,9' -bianthracene, N,N'-di(naphthalen-1-yl)-N,N'-diphenyl[1,1':4',1":4",1'''-quaterphenyl]-4,4'''-diamine, 4,4'-di[10-(naphthalen-1-yl)anthracen-9-yl]biphenyl, dibenzol{[f,f']-4,4',7,7'-tetraphenyl}diindeno[1,2,3-cd:1',2',3'-lm]perylene, 1-(7-(9,9'-bianthracen-10-yl)-9,9-dimethyl-9H-fluoren-2-yl)pyrene, 1-(7-(9,9'-bianthracen-10-yl)-9,9-dihexyl-9H-fluoren-2-yl)pyrene, 1,3-bis(carbazol-9-yl)benzene, 1,3,5-tris(carbazol-9-yl)benzene, 4,4',4"-tris(carbazol-9-yl)triphenylamine, 4,4'-bis(carbazol-9-yl)biphenyl (CBP), 4,4'-bis(carbazol-9-yl)-2,2'-dimethylbiphenyl, 2,7-bis(carbazol-9-yl)-9,9-dimethylfluorene, 2,2',7,7'-tetrakis(carbazol-9-yl)-9,9-spirobifluorene, 2,7-bis(carbazol-9-yl)-9,9-di(p-tolyl)fluorene, 9,9-bis[4-(carbazol-9-yl)-phenyl]fluorene, 2,7-bis(carbazol-9-yl)-9,9-spirobifluorene, 1,4-bis(triphenylsilyl)benzene, 1,3-bis(triphenylsilyl)benzene, bis(4-N,N-diethylamino-2-methylphenyl)-4-methylphenylmethane, 2,7-bis(carbazol-9-yl)-9,9-dioctylfluorene, 4,4"-di(triphenylsilyl)-p-terphenyl, 4,4'-di(triphenylsilyl)biphenyl, 9-(4-t-butylphenyl)-3,6-bis(triphenylsilyl)-9H-carbazole, 9-(4-t-butylphenyl)-3,6-ditrityl-9H-carbazole, 9-(4-t-butylphenyl)-3,6-bis(9-(4-methoxyphenyl)-9H-fluoren-9-yl)-9H-carbazole, 2,6-bis(3-(9H-carbazol-9-yl)phenyl)pyridine, triphenyl(4-(9-phenyl-9H-fluoren-9-yl)phenyl)silane, 9,9-dimethyl-N,N-diphenyl-7-(4-(1-phenyl-1H-benzo[d]imidazol-2-yl)phenyl)-9H-fluoren-2-amine, 3,5-bis(3-(9H-carbazol-9-yl)phenyl)pyridine, 9,9-spirobifluoren-2-yl-diphenyl-phosphine oxide, 9,9'-(5-triphenylsilyl)-1,3-phenylene)bis(9H-carbazole), 3-(2,7-bis(diphenylphosphoryl)-9-phenyl-9H-fluoren-9-yl)-9-phenyl-9H-carbazole, 4,4,8,8,12,12-hexa(p-tolyl)-4H-8H-12H-12C-azadibenzo[cd,mn]pyrene, 4,7-di(9H-carbazol-9-yl)-1,10-phenanthroline, 2,2'-bis(4-(carbazol-9-yl)phenyl)biphenyl, 2,8-bis(diphenylphosphoryl)dibenzo[b,d]thiophene, bis(2-methylphenyl)diphenylsilane, bis[3,5-di(9H-carbazol-9-yl)phenyl] diphenylsilane, 3,6-bis(carbazol-9-yl)-9-(2-ethylhexyl)-9H-carbazole, 3-(diphenylphosphoryl)-9-(4-(diphenylphosphoryl)phenyl)-9H-carbazole and 3,6-bis[(3,5-diphenyl)phenyl] -9-phenylcarbazole.
The light-emitting layer may be formed by co-vapor deposition with a light-emitting dopant.

Specific examples of light-emitting dopants include 3-(2-benzothiazolyl)-7-(diethylamino)coumarin, 2,3,6,7-tetrahydro-1,1,7,7-tetramethyl-1H,5H,11H-10-(2-benzothiazolyl)quinolidino-[9,9a,1gh] coumarin, quinacridone, N,N'-dimethyl-quinacridone, tris(2-phenylpyridine) iridium(III) (Ir(ppy)₃), bis(2-phenylpyridine) (acetylacetonate) iridium(III) (Ir(ppy)₂(acac)), tris[2-(p-tolyl]pyridine) iridium(III) (Ir(mppy)₃), 9,10-bis[N,N-di(p-tolyl)amino]anthracene, 9,10-bis[phenyl(m-tolyl)amino]anthracene, bis[2-(2-hydroxyphenyl)benzothiazolate] zinc(II), N¹⁰,N¹⁰,N¹⁰,N¹⁰-tetra(p-tolyl)-9,9'-bianthracene-10,10'-diamine, N¹⁰,N¹⁰,N¹⁰,N¹⁰ -tetraphenyl-9,9' -bianthracene-10,10' -diamine, N¹⁰,N¹⁰-diphenyl-N¹⁰,N¹⁰-dinaphthalenyl-9,9'-bianthracene-10,10'-diamine, 4,4'-bis(9-ethyl-3-carbazovinylene)-1,1'-biphenyl, perylene, 2,5,8,11-tetra-t-butylperylene, 1,4-bis[2-(3-N-ethylcarbazolyl)vinyl]benzene, 4,4'-bis[4-(di-p-tolylamino)styryl]biphenyl, 4-(di-p-tolylamino)-4'-[(di-p-tolylamino)styryl]stilbene, bis[3,5-difluoro-2-(2-pyridyl)phenyl-(2-carboxypyridyl)] iridium(III), 4,4'-bis[4-(diphenylamino)styryl]biphenyl, bis(2,4-difluorophenylpyridinato)tetrakis(1-pyrazolyl)borate iridium(III), N,N'-bis(naphthalen-2-yl)-N,N'-bis(phenyl)-tris(9,9-dimethylfluorenylene), 2,7-bis{2-[phenyl(m-tolyl)amino]-9,9-dimethylfluoren-7-yl}-9,9-dimethyl-fluorene, N-(4-((E)-2-(6((E)-4-(diphenylamino)styryl)naphthalen-2-yl)vinyl)phenyl)-N-phenylbenzenamine, fac-iridium(III)tris(1-phenyl-3-methylbenzimidazolin-2-ylidene-C,C²), mer-iridium(III) tris(1-phenyl-3-methylbenzimidazolin-2-ylidene-C,C²), 2,7-bis[4-(diphenylamino)styryl]-9,9-spirobifluorene, 6-methyl-2-(4-(9-(4-(6-methylbenzo[d]thiazol-2-yl)phenyl)anthracen-10-yl)phenyl)benzo-[d]thiazole, 1,4-di[4-(N,N-diphenyl)amino]styrylbenzene, 1,4-bis(4-(9H-carbazol-9-yl)styryl)benzene, (E)-6-(4-(diphenylamino)styryl)-N,N-diphenylnaphthalen-2-amine, bis(2,4-difluorophenylpyridinato)(5-(pyridin-2-yl)-1H-tetrazolate) iridium(III), bis(3-trifluoromethyl-5-(2-pyridyl)pyrazole)((2,4-difluorobenzyl)diphenylphosphinate) iridium(III), bis(3-trifluoromethyl-5-(2-pyridyl)pyrazolate)(benzyldiphenylphosphinate) iridium(III), bis(1-(2,4-difluorobenzyl)-3-methylbenzimidazolium)(3-(trifluoromethyl)-5-(2-pyridyl)-1,2,4-triazolate) iridium(III), bis(3-trifluoromethyl-5-(2-pyridyl)pyrazolate)(4',6'-difluorophenylpyridinate) iridium(III), bis(4',6'-difluorophenylpyridinato)(3,5-bis(trifluoromethyl)-2-(2'-pyridyl)pyrrolate) iridium(III), bis(4',6'-difluorophenylpyridinato)(3-(trifluoromethyl)-5-(2-pyridyl)-1,2,4-triazolate) iridium (III), (Z)-6-mesityl-N-(6-mesitylquinolin-2(1H)-ylidene)quinoline-2-amine-BF₂, (E)-2-(2-(4-(dimethylamino)styryl)-6-methyl-4H-pyran-4-ylidene)malononitrile, 4-(dicyanomethylene)-2-methyl-6-julolidyl-9-enyl-4-H-pyran, 4-(dicyanomethylene)-2-methyl-6-(1,1,7,7-tetramethyljulolidyl-9-enyl)-4H-pyran, 4-(dicyanomethylene)-2-t-butyl-6-(1,1,7,7-tetramethyljulolidin-4-ylvinyI)-4H-pyran, tris(dibenzoylmethane)phenanthroline europium(III), 5,6,11,12-tetraphenylnaphthacene, bis(2-benzo[b]thiophen-2-yl-pyridine)(acetylacetonate) iridium(III), tris(1-phenylisoquinoline) iridium(III), bis(1-phenylisoquinoline)(acetylacetonate) iridium(III), bis[1-(9,9-dimethyl-9H-fluoren-2-yl)isoquinoline](acetylacetonate)iridium(III), bis [2-(9,9-dimethyl-9H-fluoren-2-yl)quinoline] (acetylacetonate) iridium(III), tris[4,4'-di-t-butyl-(2,2')-bipyridine] ruthenium(III)·bis(hexafluorophosphate), tris(2-phenylquinoline) iridium(III), bis(2-phenylquinoline)(acetylacetonate) iridium(III), 2,8-di-t-butyl-5,11-bis(4-t-butylphenyl)-6,12-diphenyltetracene, bis(2-phenylbenzothiazolate)(acetylacetonate) iridium(III), platinum 5,10,15,20-tetraphenyltetrabenzoporphyrin, osmium(II) bis(3-trifluoromethyl-5-(2-pyridine)pyrazolate)dimethylphenylphosphine, osmium(II) bis (3-trifluoromethyl)-5-(4-t-butylpyridyl)-1,2,4-triazolate)diphenylmethyl-phosphine, osmium(II) bis(3-(trifluoromethyl)-5-(2-pyridyl)-1,2,4-triazole)dimethylphenylphosphine, osmium(II) bis(3-(trifluoromethyl)-5-(4-t-butylpyridyl)-1,2,4-triazolate)dimethylphenyl-phosphine, bis[2-(4-n-hexylphenyl)quinoline](acetylacetonate) iridium(III), tris[2-(4-n-hexylphenyl)quinoline] iridium(III), tris[2-phenyl-4-methylquinoline] iridium(III), bis(2-phenylquinoline)(2-(3-methylphenyl)pyridinate) iridium(III), bis(2-(9,9-diethyl-fluoren-2-yl)-1-phenyl-1H-benzo[d]imidazolato)(acetylacetonate) iridium(III), bis(2-phenylpyridine) (3-(pyridin-2-yl)-2H-chromen-2-onate) iridium(III), bis(2-phenylquinoline)(2,2,6,6-tetramethylheptane-3,5-dionate) iridium(III), bis(phenylisoquinoline)(2,2,6,6-tetramethylheptane-3,5-dionate) iridium(III), iridium(III) bis(4-phenylthieno[3,2-c]pyridinato-N,C²)acetylacetonate, (E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)malononitrile, bis(3-trifluoromethyl-5-(1-isoquinolyl)pyrazolate)(methyldiphenylphosphine) ruthenium, bis[(4-n-hexylphenyl)isoquinoline](acetylacetonate) iridium(III), platinum(II) octaethylporphin, bis(2-methyldibenzo[f,h]quinoxaline)(acetylacetonate) iridium(III) and tris[(4-n-hexylphenyl)isoquinoline] iridium(III).

Specific examples of electron-transporting layer-forming materials include lithium 8-hydroxyquinolinate, 2,2',2"-(1,3,5-benzinetriyl)-tris(1-phenyl-1-H-benzimidazole), 2-(4-biphenyl)-5-(4-t-butylphenyl)-1,3,4-oxadiazole, 2,9-dimethyl-4,7-diphenyl-1,10-phenanthroline, 4,7-diphenyl-1,10-phenanthroline, bis(2-methyl-8-quinolinolate)-4-(phenylphenolato)aluminum, 1,3-bis[2-(2,2'-bipyridin-6-yl)-1,3,4-oxadiazo-5-yl]benzene, 6,6'-bis[5-(biphenyl-4-yl)-1,3,4-oxadiazo-2-yl]-2,2'-bipyridine, 3-(4-biphenyl)-4-phenyl-5-t-butylphenyl-1,2,4-triazole, 4-(naphthalen-1-yl)-3,5-diphenyl-4H-1,2,4-triazole, 2,9-bis(naphthalen-2-yl)-4,7-diphenyl-1,10-phenanthroline, 2,7-bis[2-(2,2'-bipyridin-6-yl)-1,3,4-oxadiazo-5-yl]-9,9-dimethylfluorene, 1,3-bis[2-(4-t-butylphenyl)-1,3,4-oxadiazo-5-yl]benzene, tris(2,4,6-trimethyl-3-(pyridin-3-yl)phenyl)borane, 1-methyl-2-(4-(naphthalen-2-yl)phenyl)-1H-imidazo[4,5f][1,10]phenanthroline, 2-(naphthalen-2-yl)-4,7-diphenyl-1,10-phenanthroline, phenyldipyrenylphosphine oxide, 3,3',5,5'-tetra[(m-pyridyl)-phen-3-yl]biphenyl, 1,3,5-tris[(3-pyridyl)-phen-3-yl]benzene, 4,4'-bis(4,6-diphenyl-1,3,5-triazin-2-yl)biphenyl, 1,3-bis[3,5-di(pyridin-3-yl)phenyl]benzene,bis(10-hydroxybenzo[h]quinolinato)beryllium, diphenylbis(4-(pyridin-3-yl)phenyI)silane and 3,5-di(pyren-1-yl)pyridine.

Examples of electron-injecting layer-forming materials include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, lithium acetylacetonate (Li(acac)), lithium acetate and lithium benzoate.

Examples of cathode materials include aluminum, magnesium-silver alloys, aluminum-lithium alloys, lithium, sodium, potassium and cesium.

Another example is described below of a method for producing the organic EL device of the invention in a case where the thin film obtained from the inventive composition is a hole-injecting layer.

An organic EL device having a charge-transporting thin film formed using the inventive composition can be produced by, in the above-described EL device production method, successively forming a hole-transporting layer and a light-emitting layer instead of carrying out vacuum evaporation operations for a hole-transporting layer, a light-emitting layer, an electron-transporting layer and an electron-injecting layer. Specifically, the inventive composition is applied onto an anode substrate, and a hole-injecting layer is formed by the above-described method. A hole-transporting layer and a light-emitting layer are then successively formed thereon, following which a cathode electrode is vapor-deposited on top, thereby giving an organic EL device.

The cathode and anode materials used here may be similar to those described above, and similar cleaning treatment and surface treatment may be carried out.

The method of forming the hole-transporting layer and the light-emitting layer is exemplified by a film-forming method that involves adding a solvent to a hole-transporting polymer material or a light-emitting polymer material, or to the material obtained by adding a dopant to either of these, thereby dissolving or uniformly dispersing the material, and then applying the solution or dispersion onto, respectively, the hole-injecting layer or the hole-transporting layer and subsequently baking the applied layer.

Examples of hole-transporting polymer materials include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)-benzidine] end-capped with polysilsesquioxane and poly[(9,9-dioctylfluorenyl-2,7-diyl)-co-(4,4'-(N-(p-butylphenyl))diphenylamine)].

Examples of light-emitting polymer materials include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

Examples of the solvent include toluene, xylene and chloroform. Examples of the method of dissolution or uniform dispersion include stirring, stirring under applied heat, and ultrasonic dispersion.

Examples of the method of application include, but are not particularly limited to, inkjet printing, spraying, dipping, spin coating, transfer printing, roll coating and brush coating. Application is preferably carried out in an inert gas atmosphere such as nitrogen or argon.

Examples of the baking method include methods that involve heating in an oven or on a hot plate, either within an inert gas atmosphere or in a vacuum.

An example is described below of a method for producing the organic EL device of the invention in a case where the thin film obtained from the inventive composition is a hole-injecting-and-transporting layer.

A hole-injecting-and-transporting layer is formed on an anode substrate, and a light-emitting layer, an electron-transporting layer, an electron-injecting layer and a cathode are provided in this order on the hole-injecting-and-transporting layer. Methods of forming the light-emitting layer, electron-transporting layer and electron-injecting layer, and specific examples of each, are exemplified in the same way as above.

The anode material, the light-emitting layer, the light-emitting dopant, the materials which form the electron-transporting layer and the electron-blocking layer, and the cathode material are exemplified in the same way as above.

A hole-blocking layer, an electron-blocking layer or the like may be optionally provided between the electrodes and any of the above layers. By way of illustration, an example of a material that forms an electron-blocking layer is tris(phenylpyrazole)iridium.

The materials which make up the anode, the cathode and the layers formed therebetween differ according to whether a device provided with a bottom emission structure or a top emission structure is to be fabricated, and so are suitably selected while taking this into account.

Typically, in a device having a bottom emission structure, a transparent anode is used on the substrate side and light is extracted from the substrate side, whereas in a device having a top emission structure, a reflective anode made of metal is used and light is extracted from a transparent electrode (cathode) in the opposite direction from the substrate. For example, with regard to the anode material, when fabricating a device having a bottom emission structure, a transparent anode of ITO or the like is used, and when fabricating a device having a top emission structure, a reflective anode of Al/Nd or the like is used.

To prevent deterioration of the device characteristics, the organic EL device of the invention may be sealed in the usual manner with, if necessary, a desiccant or the like.

### EXAMPLES

Working Examples are given below to more concretely illustrate the invention, although the invention is not limited by these Examples. The equipment used was as follows.
(1) ¹H-NMR: JNM-ECP-300FT NMR system, from JEOL Ltd.
(2) MALDI-TOF-MS:
   Autoflex III SmartBeam, from Bruker Daltonics
(3) Substrate Cleaning:
   Substrate cleaning machine (reduced-pressure plasma system),
   from Choshu Industry Co., Ltd.
(4) Composition (Varnish) Coating:
   MS-A100 Spin Coater, from Mikasa Co., Ltd.
(5) Film Thickness Measurement:
   Surfcorder ET-4000 microfigure measuring instrument,
   from Kosaka Laboratory, Ltd.
(6) EL Device Fabrication:
   C-E2L1G1-N Multifunction Vapor Deposition System,
   from Choshu Industry Co., Ltd.
(7) Measurement of EL Device Brightness:
   I-V-L Measurement System from Tech World, Inc.
(8) Measurement of EL Device Lifetime (Measurement of Brightness Half-Life):
   PEL-105S Organic EL Brightness Life Evaluation System,
   from EHC K.K.

### [1] Compound Synthesis

### [Synthesis Example 1] Synthesis of Aniline Derivative 1

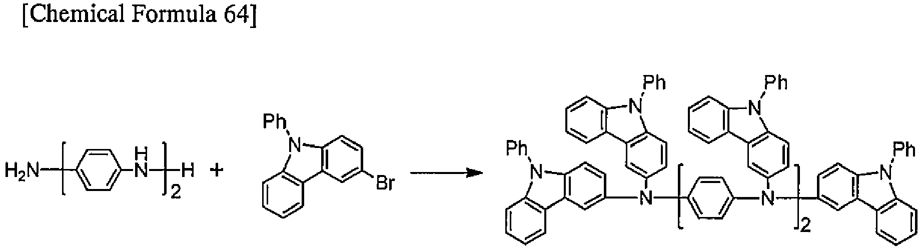

A flask was charged with 1.00 g of N1-(4-aminophenyl)benzene-1,4-diamine, 8.89 g of 3-bromo-9-phenyl-9H-carbazole, 112 mg of palladium acetate and 3.47 g of sodium tert-butoxide, following which the flask was flushed with nitrogen. To this was added 30 mL of toluene and 2.75 mL of a toluene solution of di-t-butyl(phenyl)phosphine (concentration, 81.0 g/L) that was prepared beforehand, and the system was stirred at 90°C for 6 hours.

After the completion of stirring, the reaction mixture was cooled to room temperature, and the cooled reaction mixture was mixed together with toluene and deionized water and separatory treatment carried out. The resulting organic layer was dried over sodium sulfate and concentrated. The concentrate was filtered with silica gel, 0.2 g of activated carbon was added to the resulting filtrate, and the system was stirred at room temperature for 30 minutes.

Next, the activated carbon was removed by filtration and the filtrate was concentrated. The concentrate was added dropwise to a mixed solvent of methanol and ethyl acetate (500 mL/500 mL), and the resulting slurry was stirred overnight at room temperature, following which the slurry was filtered and the filtered matter was collected. The filtered matter thus obtained was dried, giving 5.8 g of the target Aniline Derivative 1 (yield, 83 %).

¹H-NMR (300 MHz, THF-d8) δ [ppm]:
8.08 (d, J = 7.7 Hz, 2H), 7.99 (d, J = 7.7 Hz, 8H), 7.60-7.64 (m, 19H), 7.42-7.47 (m, 6H), 7.28-7.36 (m, 19H), 7.09-7.21 (m, 6H), 7.00 (m, 8H)

MALDI-TOF-MS, m/Z; found: 1404.68 ([M]⁺ calculated: 1404.56).

### [2] Preparation of Compositions

### [Working Example 1-1]

Aniline Derivative 1 (0.112 g) and 0.092 g of 2,4,6,7-tetracyano-1,4,5,8-tetraazanaphthalene (from Sanbo Chemical Ind. Ltd.; abbreviated below as "TCNA") were dissolved in 5.0 g of 1,3-dimethyl-2-imidazolidinone (DMI) in a nitrogen atmosphere. To this were added 3.0 g of 2,3-butanediol (2,3-BD) and 2.0 g of dipropylene glycol monomethyl ether (DPM) and stirring was carried out. The resulting solution was filtered using a PTFE filter having a pore size of 0.2 µm, thereby giving a charge-transporting thin film-forming composition.

### [Working Example 1-2]

Aniline Derivative 1 (0.171 g), 0.141 g of TCNA and 0.312 g of phosphotungstic acid (Japan New Metals Co., Ltd.; abbreviated below as "PTA") were dissolved in 7.5 g of DMI under a nitrogen atmosphere. To this were added 4.5 g of 2,3-BD and 3.0 g of DPM and stirring was carried out. The resulting solution was filtered using a PTFE filter having a pore size of 0.2 µm, thereby giving a charge-transporting thin film-forming composition.

### [Working Example 1-3]

Aniline Derivative 1 (0.171 g), 0.141 g of TCNA and 0.312 g of PTA were dissolved in 7.5 g of DMI under a nitrogen atmosphere. To this were added 4.5 g of 2,3-BD and 3.0 g of DPM and stirring was carried out, after which 0.010 g of 3,3,3-trifluoropropyltrimethoxysilane (Shin-Etsu Chemical, Co., Ltd.) and 0.021 g of phenyltrimethoxysilane (Shin-Etsu Chemical Co., Ltd.) were further added and stirring carried out. The resulting solution was filtered using a PTFE filter having a pore size of 0.2 µm, thereby giving a charge-transporting thin film-forming composition.

### [3] Fabrication of Organic EL Device and Evaluation of Device Characteristics

### [Working Example 2-1]

The charge-transporting thin film-forming composition obtained in Working Example 1-1 was coated onto an ITO substrate using a spin coater, then dried for 1 minute at 80°C and subsequently baked for 10 minutes at 150°C in an open-air atmosphere, thereby forming a uniform 30 nm thin film on the ITO substrate. A glass substrate with dimensions of 25 mm × 25 mm × 0.7 mm (t) and having indium-tin oxide (ITO) patterned on the surface to a film thickness of 150 nm was used as the ITO substrate. Prior to use, impurities on the surface were removed with an O₂ plasma cleaning system (150 W, 30 seconds).

Next, using a vapor deposition system (degree of vacuum, 1.0×10⁻⁵ Pa), 30 nm of α-NPD was deposited at a rate of 0.2 nm/s onto the ITO substrate where the thin film was formed, following which CBP and Ir(ppy)₃ were co-deposited. Co-deposition was carried out by controlling the rate of deposition such that the concentration of Ir(ppy)₃ becomes 6 %, to a thickness of 40 nm. Thin films of BAlq, lithium fluoride and aluminum were then successively deposited, thereby giving an organic EL device. At this time, vapor deposition was carried out at a rate of 0.2 nm/s for BAlq and aluminum, and at a rate of 0.02 nm/s for lithium fluoride. The film thicknesses were set to, respectively, 20 nm, 0.5 nm and 120 nm.

To prevent the device characteristics from deteriorating due to the influence of oxygen, moisture and the like in air, the organic EL device was sealed with sealing substrates, following which the characteristics were evaluated. Sealing was carried out by the following procedure. In a nitrogen atmosphere having an oxygen concentration of not more than 2 ppm and a dew point of not more than -85°C, the organic EL device was placed between sealing substrates and the sealing substrates were laminated together using an adhesive (MORESCO Moisture Cut WB90US(P), from Moresco Corporation). At this time, a desiccant (HD-071010W-40, from Dynic Corporation) was placed, together with the organic EL device, within the sealing substrates. The laminated sealing substrates were irradiated with UV light (wavelength, 365 nm; dosage, 6,000 mJ/cm²), and then annealed at 80°C for 1 hour to cure the adhesive.

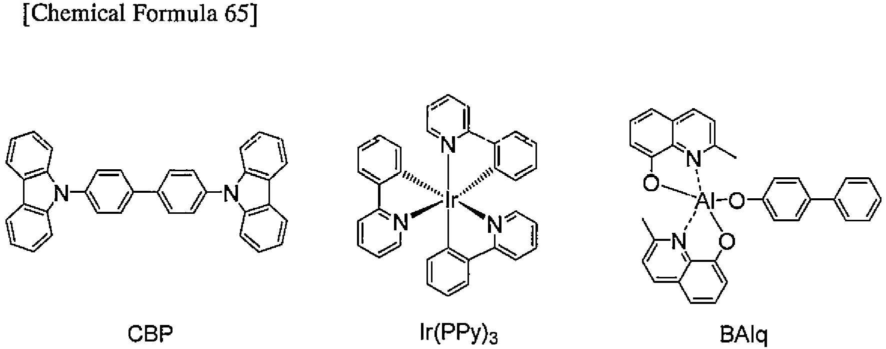

### [Working Examples 2-2 and 2-3]

Aside from using the charge-transporting thin film-forming compositions obtained in Working Examples 1-2 and 1-3 instead of the charge-transporting thin film-forming composition obtained in Working Example 1-1, devices were obtained by the same method as in Working Example 2-1.

The driving voltage, brightness, emission efficiency and brightness half-life (initial brightness, 5,000 cd/m²) when the devices fabricated above were made to luminesce at a driving current of 0.7 mA were measured. The results are shown in Table 19. The surface area of the light-emitting surface on each device was 2 mm × 2 mm.

**[Table 19]**

| | Driving voltage (V) | Brightness (cd/m²) | Emission efficiency (cd/A) | Brightness half-life (hours) |
|---|---|---|---|---|
| Working Example 2-1 | 9.38 | 1,978 | 26.4 | 225 |
| Working Example 2-2 | 8.83 | 2,120 | 28.3 | 287 |
| Working Example 2-3 | 8.75 | 2,231 | 29.7 | 326 |

It is apparent from the results in Table 19 that organic EL devices which include, as the hole-injecting layer, a charge-transporting thin film obtained from a charge transporting thin film-forming composition of the invention have excellent brightness characteristics.

It is also apparent that such organic EL devices have an excellent durability as well.

## Claims

1. A charge-transporting thin film-forming composition for an organic electroluminescent device, comprising a dopant substance consisting of a cyano group-substituted nitrogen-containing heteroaromatic compound of any of formulas (D1) to (D5) below, a charge-transporting substance and an organic solvent, wherein the dopant substance and the charge-transporting substance are dissolved in the organic solvent.

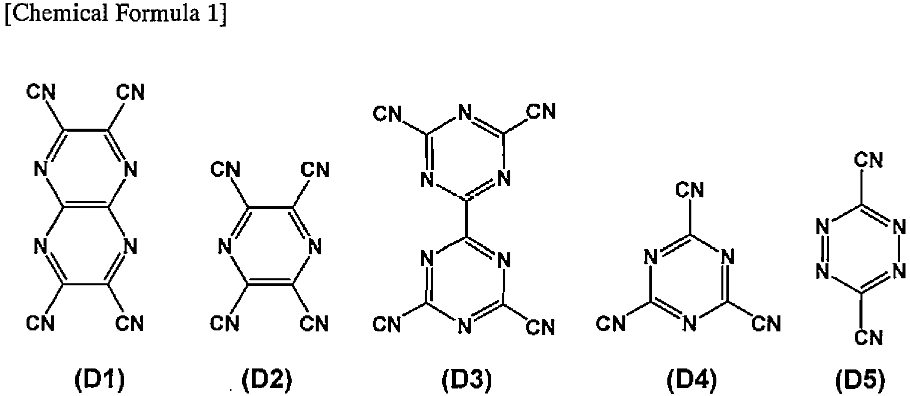

2. The charge-transporting thin film-forming composition for an organic electroluminescent device of claim 1, wherein the charge-transporting substance is a charge-transporting compound having a molecular weight of from 200 to 9,500.

3. The charge-transporting thin film-forming composition for an organic electroluminescent device of claim 2, wherein the charge-transporting compound is an aniline derivative or a thiophene derivative.

4. The charge-transporting thin film-forming composition for an organic electroluminescent device of claim 3, wherein the charge-transporting compound is an aniline derivative.

5. The charge-transporting thin film-forming composition for an organic electroluminescent device of any one of claims 1 to 4, further comprising an organosilane compound.

6. The charge-transporting thin film-forming composition for an organic electroluminescent device of any one of claims 1 to 5, further comprising a heteropolyacid.

7. The charge-transporting thin film-forming composition for an organic electroluminescent device of any one of claims 1 to 6 which is a composition for forming a hole-injecting layer, a hole-transporting layer or a hole-injecting-and-transporting layer of an organic electroluminescent device.

8. A charge-transporting thin film for an organic electroluminescence device that is produced using the charge-transporting thin film-forming composition for an organic electroluminescent device of any one of claims 1 to 7.

9. An organic electroluminescent device comprising the charge-transporting thin film for an organic electroluminescence device of claim 8.
